# EUROPEAN PATENT APPLICATION

(11) **EP 2 774 931 A1**
(43) Date of publication of application: **10.09.2014**
(21) Application number: 12844675.4
(22) Date of filing: 02.11.2012
(51) Int. Cl.: C07F 19/00, C07F 7/08, C07F 7/22, C07F 7/30, C08G 61/12, H01L 31/04

(54) **PROCESS FOR PRODUCING FUSED-RING AROMATIC COMPOUND, AND CONJUGATED POLYMER**

(30) Priority: 02.11.2011 JP 2011241498; 29.11.2011 JP 2011260973
(71) Applicant: Mitsubishi Chemical Corporation, Chiyoda-ku Tokyo 100-8251 (JP)
(72) Inventor: FUJITA, Rieko, Yokohama-shi Kanagawa 227-8502 (JP); KAWAI, Jyunya, Yokohama-shi Kanagawa 227-8502 (JP); SATO, Wataru, Yokohama-shi Kanagawa 227-8502 (JP); SATAKE, Kenichi, Yokohama-shi Kanagawa 227-8502 (JP); FURUYA, Mitsunori, Yokohama-shi Kanagawa 227-8502 (JP)
(74) Representative: HOFFMANN EITLE
(86) International application number: PCT/JP2012/078517
(87) International publication number: WO 2013/065836

(57) **Abstract**

The invention addresses a problem of purifying a monomer to be a precursor according to a simpler and milder method so as to obtain a polymer having a higher molecular weight. The invention relates to a method for producing a condensed polycyclic aromatic compound having n active groups (wherein n is an integer of 1 or more and 4 or less), which comprises bringing a composition containing the condensed polycyclic aromatic compound and a solvent into contact with zeolite.

## Description

### Technical Field

The present invention relates to a method for producing a condensed polycyclic aromatic compound and to a conjugated polymer.

### Background Art

As semiconductor materials for devices such as organic EL devices, organic thin film transistors, organic light-emitting sensors and the like, π-conjugated polymers are used, and above all, attention is focused on application thereof to polymer organic solar cells. In particular, in organic solar cells, there have been reported a lot of cases of using a copolymer of a donor-like monomer and an acceptor-like monomer (hereinafter this may be referred to as a copolymer) in a photoelectric conversion element.

Examples of the donor-like monomer skeleton include, for example, those described in NPL 1 and NPL 2. In these publications, there are disclosed copolymers produced through coupling polymerization of a condensed polycyclic structure-having monomer in which at least three 5-membered rings are condensed, such as dithieno[3,2-b:2',3'-d]silole, and any other monomer. It is reported that an organic solar cell using the copolymer exhibits a high photoelectric conversion efficiency of more than 5%.

### Citation List

### Non-Patent Literature

NPL 1: J. Am. Chem. Soc., 2008, 130, 16144-16415.
NPL 2: J. Am. Chem. Soc., 2011,133,4250-4253.
NPL 3: Chem. Commun., 2010,46,6335-6337.
NPL 4: Chem. Commun., 2004,1968-1969.

### Summary of Invention

### Technical Problem

For developing a higher-performance device, it is desired to obtain a polymer having a higher molecular weight. For obtaining a copolymer having a higher molecular weight, it is important to use monomers having a higher purity. However, the purification method through GPC (gel permeation chromatography) that has heretofore been employed in the art is unsuitable to industrial mass-production of monomers.

Investigations made by the present inventors have revealed that relatively unstable monomers often undergo substituent removal under ordinary purification conditions in a method of leading the monomer to pass through a silica gel column (NPL 3), a method of leading the monomer to pass through a silica gel/potassium fluoride column (NPL 4) or the like.

An object of the present invention is to purify and produce a monomer to be a precursor in a simpler and milder method so as to give a polymer having a higher molecular weight.

### Solution to Problem

For solving the above-mentioned problems, the present inventors have assiduously studied and, as a result, have found that purification of monomers by the use of zeolite provides a material capable of giving a polymer having a higher molecular weight.

Specifically, the gist of the invention is as follows.
1. A method for producing a condensed polycyclic aromatic compound having n active groups (wherein n is an integer of 1 or more and 4 or less), which comprises bringing a composition containing the condensed polycyclic aromatic compound and a solvent into contact with zeolite.
2. The method for producing a condensed polycyclic aromatic compound according to the item 1 above, wherein the condensed polycyclic aromatic compound satisfies the following requirement:
   Requirement: When 5 ml of a hexane solution containing 1.0 g of the condensed polycyclic aromatic compound (Ar(n)) having n active groups is charged in a column (having an inner diameter 15 mm, and charged with 50 mL of a hexane solution containing 20 g of silica gel (spherical, neutral (pH 7.0 ± 0.5), and having a particle size of from 63 to 210 µm) and 2 g of anhydrous potassium carbonate) and developed with a developing solvent of hexane (at a flow rate of 50 ml/min), the total proportion of the condensed polycyclic aromatic compound in which the number of the active groups is smaller than n in the solution having passed through the column in 3 minutes at room temperature is 5 mol% or more relative to the aromatic compound (Ar(n)) before charged in the column.
3. The method for producing a condensed polycyclic aromatic compound according to the item 1 or 2 above, wherein the condensed polycyclic aromatic compound is a condensed polycyclic aromatic compound represented by the following formula (I): 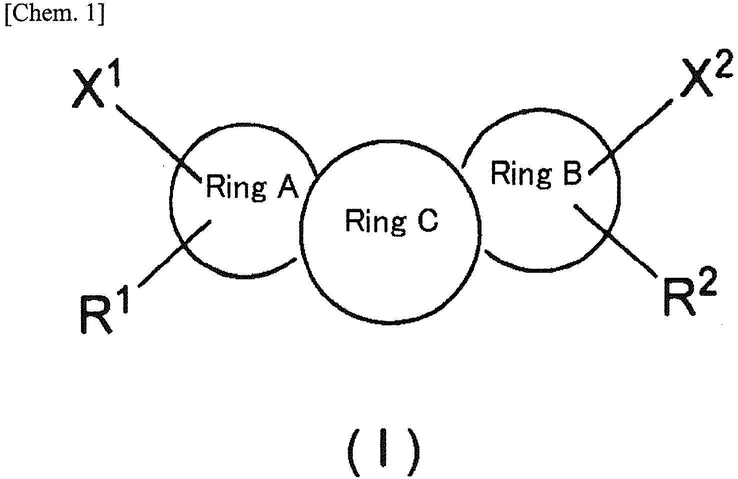
   (In the formula (I), the Ring A and the Ring B each independently represent a 5-membered aromatic hetero ring, and the Ring C represents a ring optionally having a substituent, X¹ and X² each independently represent an active group, R¹ and R² each independently represent a hydrogen atom, a halogen atom, or a hydrocarbon group optionally having a hetero atom.)
4. The method for producing a condensed polycyclic aromatic compound according to the item 3 above, wherein the compound represented by the formula (I) is a condensed polycyclic aromatic compound represented by the following formula (II) or formula (III): 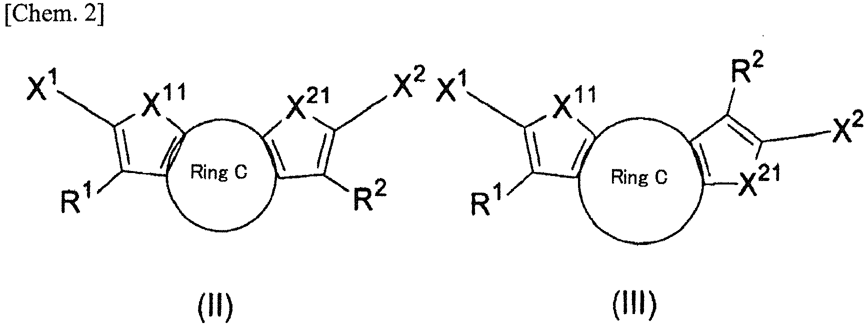 (In the formula (II) and the formula (III), X¹, X², R¹, R² and the Ring C have the same meanings as in the formula (I), and X¹¹ and X²¹ each independently represent an atom selected from Group 16 elements of the Periodic Table.)
5. The method for producing a condensed polycyclic aromatic compound according to the item 4 above, wherein the compound represented by the formula (II) or the formula (III) is a condensed polycyclic aromatic compound represented by the following formula (IV), formula (V), formula (VI) or formula (VII): 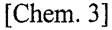 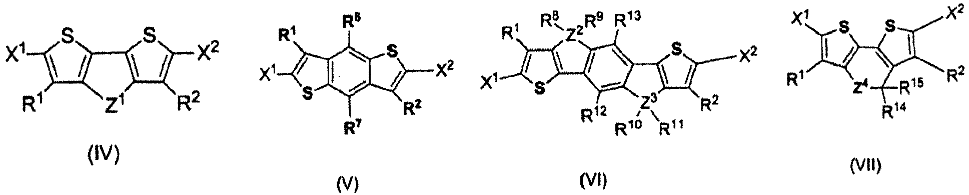 in the formula (IV), formula (V), formula (VI) or formula (VI), X¹, X², R¹ and R² have the same meanings as in the formula (I),
   in the formula (IV), Z¹ represents Z¹¹(R³)(R⁴), Z¹²(R⁵), or Z¹³, Z¹¹ represents an atom selected from Group 14 elements of the Periodic Table, R³ and R⁴ are the same as the above-mentioned R¹ and R², Z¹² represents an atom selected from Group 15 elements of the Periodic Table, R⁵ has the same meaning as R³ and R⁴. Z¹³ represents an atom selected from Group 16 elements of the Periodic Table,
   in the formula (V), R⁶ and R⁷ each represent a hydrogen atom, a halogen atom, an alkyl group optionally having a substituent, an alkenyl group optionally having a substituent, an alkynyl group optionally having a substituent, an aromatic group optionally having a substituent, an alkoxy group optionally having a substituent, or an aryloxy group optionally having a substituent,
   in the formula (VI), R⁸ to R¹¹ have the same meanings as R³ and R⁴; and R¹² and R¹³ have the same meanings as R¹ and R². Z² and Z³ each independently represent an atom selected from Group 14 elements of the Periodic Table,
   in the formula (VII), R¹⁴ and R¹⁵ have the same meanings as R³ and R⁴. Z⁴ represents an atom selected from Group 16 elements of the Periodic Table.
6. The method for producing a condensed polycyclic aromatic compound according to any one of the items 3 to 5 above, wherein at least one of X¹ and X² is a tin-containing group.
7. The method for producing a condensed polycyclic aromatic compound according to any one of the items 3 to 6 above, which, in the condensed compound represented by the formula (II), comprises producing the condensed polycyclic aromatic compound represented by the formula (I) through reaction of a condensed polycyclic aromatic compound represented by the following formula (VIII) with a non-nucleophilic base followed by reaction thereof with an electrophilic reagent: 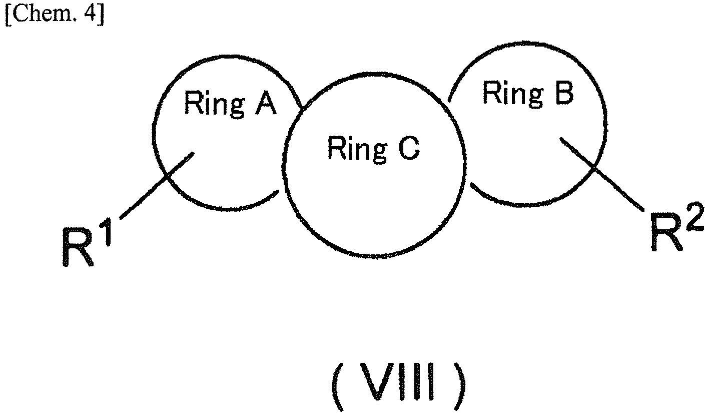 (In the formula (VIII), the Ring A, the Ring B, the Ring C, R¹ and R² have the same meanings as in the formula (I).)
8. The method for producing a condensed polycyclic aromatic compound according to the item 7 above, wherein pKa in tetrahydrofuran (THF) of the conjugated acid of the non-nucleophilic base is 20 or more and 40 or less.
9. The method for producing a condensed polycyclic aromatic compound according to the item 7 or 8 above, wherein the non-nucleophilic base is a metal amide.
10. The method for producing a condensed polycyclic aromatic compound according to any one of the items 7 to 9 above, wherein the operation of reacting with the non-nucleophilic base followed by reacting with the electrophilic reagent is repeated multiple times.
11. The method for producing a condensed polycyclic aromatic compound according to any one of the items 1 to 10 above, wherein the contact is performed by passing the composition through the zeolite-containing layer at a temperature not higher than the boiling point of the solvent.
12. The method for producing a condensed polycyclic aromatic compound according to any one of the items 1 to 11 above, wherein the zeolite is zeolite with 8-membered, 10-membered or 12-membered rings.
13. A conjugated polymer where the condensed polycyclic aromatic compound produced according to the method as described in any one of the items 1 to 12 above is used as the starting material.
14. A photoelectric conversion element that comprises the conjugated polymer produced according to the production method of the item 12 above.
15. A solar cell that contains the photoelectric conversion element produced according to the method of the item 13 above.
16. A solar cell module that contains the solar cell produced according to the item 14 above.

### Advantageous Effects of Invention

A monomer to be a precursor can be purified in a simpler and milder method so as to give a polymer having a higher molecular weight.

### Description of Embodiments

Embodiments of the invention are described in detail hereinunder. The following description is for some typical examples of embodiments of the invention, and the invention is not limited to the contents, so far as not to overstep the scope and the spirit thereof.

The production method of the invention includes a step of bringing a composition containing a condensed polycyclic aromatic compound having n active groups (wherein n is an integer of 1 or more and 4 or less) (hereinafter this may be referred to as the monomer in the invention) and a solvent into contact with zeolite. Through the step, for example, impurities can be removed from the composition containing a condensed polycyclic aromatic compound having n active groups, a solvent and impurities, thereby giving the condensed polycyclic aromatic compound having n active groups.

According to the method of the invention, it is possible to purify the condensed polycyclic aromatic compound having n active groups so that the purity of the compound could be on the level usable as a monomer in polymerization reaction. Here, the active group is meant to indicate a group capable of reacting with the group that any other monomer has in obtaining a polymer through polymerization reaction such as coupling reaction or the like, and the details thereof will be described below.

In the following, the composition that contains the condensed polycyclic aromatic compound having n active groups and a solvent may be referred to as the composition in the invention. Further, the step of bringing the composition in the invention into contact with zeolite may be referred to as a purification step in the invention.

### <Zeolite>

Zeolite for use in the invention (hereinafter simply referred to as zeolite) is described below. Zeolite that accords to the definition by the International Zeolite Association is more preferably used here. Specifically, preferred is a compound having a composition DEn (n is nearly equal to 2) to form an opened three-dimensional network, in which D has four bonds and E has two bonds and which has a skeleton density (total number of D atoms in 1 nm³) of 20.5 or less.

As zeolite, for example, employable here are those described in "Atlas of Simulated XRD Powder Patterns for Zeolites". As more concrete examples, there are mentioned A-type zeolite, ferrierite, SZM-5, ZSM-11, mordenite, beta-zeolite, X-type zeolite, Y-type zeolite, etc.

As the type of zeolite, preferred here are aluminosilicate-type zeolite such as aluminosilicates, metallosilicates, silicalites, etc.; phosphate-type zeolite such as aluminophosphates, gallophosphates, beryllophosphates, etc. Aluminosilicate contains aluminium and silicon, and when the proportion of silicon increases therein, it comes to adsorb organic molecules rather than water and inorganic salts. Consequently, the ratio of aluminium to silicon may be varied depending on the impurities that are desired to be removed.

The molar ratio of silicon to aluminium (silicon/aluminium) is generally 1 or more. Depending on the molar ratio of silicon to aluminium therein, aluminosilicate is grouped into low-silica zeolite (silicon/aluminium: 1 or more and 2 or less), middle-silica zeolite (silicon/aluminium: more than 2 and 5 or less), high-silica zeolite (silicon/aluminium: more than 5). These zeolites may be used either singly or as combined.

Zeolite can selectively adsorb molecules having dipoles, quadrupoles or π-electrons, or molecules having strong polarity. When the ratio of silicon/aluminium therein increases, the cation-caused adsorption by zeolite decreases, and zeolite comes to selectively adsorb organic molecules rather than water and comes to be hydrophobic. The adsorption by hydrophobic zeolite is physical adsorption through filling into intracrystalline pores. Contrary to zeolite in which the silicon/aluminium ratio is low, adsorption selectivity of hydrophobic zeolite is higher in the order of paraffin, aromatic compounds and water.

Consequently, low-silica zeolite is preferred in the point that it selectively adsorbs water and inorganic salts; middle-silica zeolite is preferred in the point that it adsorbs water, inorganic salts and organic molecules in a well-balanced manner; and high-silica zeolite is preferred in the point that it selectively adsorbs organic molecules. It is also desirable to mix two or more different types of zeolites in any desired ratio to increase the adsorption capability of the mixed zeolite.

As zeolite, especially preferred are tectoaluminosilicates. Tectoaluminosilicate is an oxide generally containing a silicon atom and an aluminium atom, and is generally represented by a formula FₘGₙO₂ₙ·sH₂O. Here, F represents an alkali metal or alkaline metal cation, and F may be one cation or multiple cations.

Examples of the alkali metal include sodium and potassium. Examples of the alkaline earth metal include calcium, barium and strontium. m is any positive number, and may be defined depending on the ratio of silicon to aluminium. G is silicon and aluminium, and in general, the number of silicon atoms is larger than the number of aluminium atoms. O represents oxygen. n is any positive number. H₂O is water, and s is any number of 0 or more.

Zeolite in the invention may contain any other element, not detracting from the advantageous effects of the invention. The weight of the other elements to the weight of the components represented by the above-mentioned general formula FₘGₙO₂ₙ·sH₂O, which the zeolite in the invention contains, is preferably 50% or less, more preferably 20% or less, even more preferably 10% or less, still more preferably 5% or less, further more preferably 2% or less.

Usable here is all-pore zeolite (8-membered ring), middle-pore zeolite (10-membered ring), large-pore zeolite (12-membered ring), or ultra-large-pore zeolite (14-membered ring or more), which may be selected in accordance with the impurities to be adsorbed to the pores. Above all, ore preferred is 8-membered ring, 10-membered ring, or 12-membered ring zeolite from the viewpoint of obtaining the preferred pore size to be mentioned below.

The alkali metal or alkaline earth metal cation, which zeolite contains, is preferably potassium, sodium, cesium or calcium.

The mean pore size of the zeolite for use in the invention is generally 2 nm or less, preferably 1 nm or less, more preferably 0.5 nm (5 angstroms) or less. On the other hand, in general, the size is 0.1 nm (1 angstrom) or more, preferably 0.2 nm (2 angstroms) or more, even more preferably 0.3 nm (3 angstroms) or more. When the mean pore size thereof falls within the range, the zeolite can remove impurities with a higher efficiency while preventing monomers from being adsorbed. The mean pore size may be measured through gas adsorption [JIS Z 8831-2 (2010) and JIS Z 8831-3 (2010)].

The specific surface area (BET) which the zeolite in the invention has is generally 10 m²/g or more, preferably 100 m²/g, more preferably 200 m²/g or more. On the other hand, in general, the specific surface area is 5000 m²/g or less, preferably 2000 m²/g or less, more preferably 1000 m²/g, even more preferably 800 m²/g. When the specific surface area thereof falls within the range, the zeolite can remove impurities with a higher efficiency while preventing monomers from being adsorbed. The specific surface area may be measured through gas adsorption [JIS Z 8831-2 (2010) and JIS Z 8831-3 (2010)].

The shape of the zeolite in the invention is not specifically defined. Examples of the shape of the zeolite in the invention include blocks, spheres, granules, pellets, powders, etc. From the viewpoint of promoting the contact between the composition and the zeolite in the invention, the zeolite in the invention is more preferably powdery.

The mean particle size of the zeolite in the invention is generally 1 nm or more, preferably 100 nm or more, more preferably 10 µm or more. On the other hand, in general, the mean particle size is 10 mm or less, preferably 1 mm or less, more preferably 250 µm or less, even more preferably 100 µm or less. The mean particle size maybe measured and calculated through microscopy [JIS Z 8901 (2006)].

The zeolite in the invention is preferably insoluble in the solvent to be mentioned below for facilitating the removal thereof from the composition in the invention.

Commercial products of zeolite usable here include Zeolite A-3, Zeolite A-4, Zeolite A-5, Zeolite F-9, Zeolite HS-320, Zeolite HS-341, Zeolite HS-500, Zeolite HS-642, Zeolite HS-690, Zeolite HS-720 and the like (for example, by Wako Pure Chemicals). In general, these zeolites are commercially sold as powders, granules or pellets. These zeolites may be used here directly as they are, or may be used after ground in a mortar or the like. For increasing the adsorption efficiency thereof, preferably used is powdery zeolite.

As the zeolite, also usable here are molecular sieves, and for example, commercial products of Molecular Sieves 3A, Molecular Sieves 4A, Molecular Sieves 5A, Molecular Sieves 13X and the like are usable. Molecular sieves are generally sold as powders, granules or pellets. These zeolites may be used here directly as they are, or may be used after ground in a mortar or the like. For increasing the adsorption efficiency thereof, preferred is use of powdery molecular sieves.

Zeolite generally has (SiO₄)⁴⁻ unit and (AlO₄)⁵⁻ unit. The neighboring four tetrahedrons share the oxygen atoms existing on the four apices, therefore three-dimensionally connecting to each other to form a crystal. The crystal is a porous structure, and therefore adsorbs low-molecular organic compounds, inorganic substances such as metals and the like, insoluble impurities, unfilterable impurities, etc.

According to the invention using zeolite that is a porous substance having a small pore size of generally 2 nm or less, the monomer in the invention can be prevented from being decomposed. This is considered to be because the monomer in the invention could be prevented from penetrating into the depth of the pores and therefore could be prevented from being decomposed inside the pores. It is considered that, of porous substances, zeolite having a relatively small pore size would be favorable for the invention.

### <Composition>

Next described is the composition containing the monomer in the invention and a solvent. The composition could be a reaction solution that is obtained after the reaction for obtaining the monomer in the invention. The composition could also be a crude product solution extracted from the reaction solution. Further, the composition could also be one prepared by dissolving the crude product, which is obtained by removing the solvent from the crude product solution, in a solvent. In general, the composition contains impurities in addition to the monomer in the invention and the solvent.

The solvent may be any one capable of dissolving the monomer in the invention, but is generally an organic solvent. Examples of the solvent include saturated hydrocarbons such as pentane, hexane, heptane, octane, cyclohexane, etc.; aromatic hydrocarbons such as benzene, toluene, ethylbenzene, xylene, etc.; halogenoaromatic hydrocarbons such as chlorobenzene, dichlorobenzene, trichlorobenzene, fluorobenzene, etc.; alcohols such as methanol, ethanol, propanol, isopropanol, butanol, t-butyl alcohol, etc.; water; ethers such as dimethyl ether, diethyl ether, methyl t-butyl ether, tetrahydrofuran, tetrahydropyran, dioxane, etc.; amine solvents such as butylamine, triethylamine, diisopropylethylamine, diisopropylamine, diethylamine, pyrrolidine, piperidine, pyridine, etc.; aprotic polar organic solvents such as N,N-dimethylformamide, dimethyl sulfoxide, N-methylpyrrolidone, etc. For improving the solubility of the monomer in the invention and the polymer to be obtained by the use of the monomer in the invention, one solvent may be used alone, or two or more types of solvents may be used as mixed. From the viewpoint of increasing the adsorption efficiency of impurities to zeolite, use of polar solvents is preferred, and use of hydrocarbon solvents is more preferred. As the solvent, preferably selected is one in which the solubility of zeolite in the invention is sufficiently low, for facilitating zeolite removal.

### <Purification Step>

The purification step in the invention includes a step of bringing the composition in the invention into contact with zeolite. The method for bringing the composition in the invention into contact with zeolite includes the following:
(1) A layer containing zeolite is prepared, and the composition in the invention is led to pass through the layer.

According to the method, contact of the composition in the invention with zeolite and removal of zeolite from the composition can be carried out simultaneously. One concrete example is a method of putting zeolite into a column and leading the composition in the invention to pass through the column. In this case, the composition in the invention is put on the column, then a developing solvent is led to run through the column, and the solution having passed through the column is collected. As the developing solvent, the same as those mentioned hereinabove for the composition may be used. In general, the developing solvent is the same solvent as in the composition, however, as the developing solvent, any one differing from the solvent in the composition may also be used.

Preferably, the solution having passed through the column is fractionated, and the solvent is removed from the solution that contains the monomer in the invention, thereby isolating the monomer in the invention. In this case, whether or not the solution contains the monomer in the invention can be confirmed according to a known method. In general, TLC (thin-layer chromatography) may be used. However, the monomer in the invention would be decomposed by silica gel or alumina, it is desirable that whether or not the monomer has been decomposed is confirmed through reversed-phase HPLC, proton or carbon NMR, or the like.

In this case, the weight of zeolite charged in the column is preferably at least 10 times the weight of the monomer in the composition in the invention, more preferably at least 30 times, even more preferably at least 50 times, and is, on the other hand, preferably at most 1000 times, more preferably at most 500 times, even more preferably at most 300 times.

Preferably, the length of zeolite charged in the column is 3 cm or more. However, in order that the length is not unrealistic, that amount of zeolite is laminated on filter paper, and the solution of the monomer in the composition in the invention may be filtered through the filter paper. Using zeolite in that amount enables removal of a larger amount of impurities while shortening the time to be taken for the treatment. It is desirable that the development time is shorter. Preferably, the time is within 1 hour, more preferably within 30 minutes, even more preferably within 15 minutes. The column charged with zeolite may contain any other carrier, not detracting from the advantageous effects of the invention.

(2) Zeolite is put into the composition, and thereafter zeolite is removed.

In this case, zeolite is put into the composition and then stirred, and thereafter zeolite may be removed through filtration. For removing a larger amount of impurities, the stirring time is preferably 5 minutes or more, but is preferably 30 minutes or less. As the filtration method, employable is suction filtration in addition to ordinary filtration. Further, another method is also employable in which zeolite is laid on a funnel, and a mixed solution of zeolite and monomer is put thereinto and filtered through the funnel.

In the step of bringing the composition in the invention into contact with zeolite, the monomer in the invention is not adsorbed by zeolite but may pass through it along with the solvent (especially the above-mentioned non-polar solvent), and after the monomer in the invention has been adsorbed by zeolite, the monomer may be released by the use of a polar solvent such as ethyl acetate, chloroform or the like (this may be referred to as a release agent) and recovered. Above all, the former method is preferred since the operation is simple. In the latter case, low-molecular impurities or metal salts that have been adsorbed by zeolite may also be released along with the monomer in the invention during the treatment with the release agent; however, the former method is free from the trouble as in the latter case.

In this case, the weight of zeolite to be used is generally at least 1 time the weight of the monomer in the composition, but preferably at least 3 times, more preferably at least 5 times, even more preferably at least 10 times, still more preferably at least 30 times, further more preferably at least 50 times.

On the other hand, the weight is preferably at most 1000 times, more preferably at most 500 times, even more preferably at most 300 times. Using zeolite in that amount enables removal of a larger amount of impurities while facilitating the filtration. The used zeolite may be regenerated according to known technology and may be reused.

The monomer in the invention obtained in the above-mentioned step is preferred in that its storage stability at -20°C is good. This may be considered because the impurities such as low-molecular compounds, metal salts and others contained in the composition in the invention could be removed. Here, good storage stability at -20°C concretely indicates that, when the monomer in the invention is statically stored at -20°C, no impurities are visually detected generally in 1 day or more, preferably in 4 day or more, more preferably in 30 day or more.

### (Temperature)

The temperature at which the composition in the invention is brought into contact with zeolite is preferably not higher than the boiling point of the solvent in the composition (however, when the developing solvent in the zeolite column differs from solvent in the composition, this is the developing solvent), more preferably 40°C or lower, even more preferably 30°C or lower. A lower temperature can prevent the monomer in the invention from being decomposed; however, when the temperature is too low, then the system may absorb moisture in air. In case where the monomer in the invention is more unstable, it is desirable to use a refrigerant column so as not to absorb moisture.

### (Light)

In carrying out the series of operation, the operation may be carried out under an ordinary fluorescent lamp. However, from the viewpoint of preventing the monomer in the invention from being decomposed, it is more desirable that the operation is carried out in the absence of a fluorescent lamp, or under a yellow lamp or a red lamp.

### (Atmosphere)

The atmosphere during the operation is not specifically defined. The operation may be carried out in air, or in an inert gas such as nitrogen, argon, etc.

### (Pressure)

The pressure during the operation is not specifically defined. The operation may be carried out under normal pressure or under increased pressure.

In case where the monomer in the invention contains impurities, especially when the monomer contains impurities undetectable through proton NMR or HPLC, such as inorganic salts or the like, accurate weighing would be difficult. For example, in case where the monomer in the invention is polymerized with any other monomer to produce a polymer, it would be difficult to obtain a polymer having a high molecular weight if the monomers are not weighted to be in a predetermined molar ratio. On the other hand, when the monomer in the invention is used to produce a polymer, the impurities therein would interfere with the polymerization reaction in a catalyst cycle. In particular, when a polymer is produced by the use of a catalyst such as a transition metal catalyst, low-molecular impurities, metal salts and the like would act as a catalyst poison in the catalytic reaction.

Consequently, in case where a polymer is produced by the use of the monomer in the invention, it is desirable that the monomer in the invention is used for the reaction after purified. On the other hand, it is difficult to purify the monomer in the invention according to an existing method. In purification through a silica gel column, the monomer in the invention would be decomposed. In particular, the active groups that the monomer in the invention has would be released. The compound resulting from the release of the active groups does not contribute toward production of a polymer or interferes with the growth of a polymer; and therefore, the compound of the type is a bar to production of a polymer having a high molecular weight.

Purification through GPC (gel permeation chromatography) takes a lot of time, and is therefore unsuitable to industrial-scale monomer purification. Further, owing to hydrochloric acid to be contained slightly in chloroform that is much used as a developing solvent in GPC, the monomer may be decomposed.

On the other hand, according to the purification step in the invention, the monomer in the invention can be purified in a simple operation of bringing the composition in the invention into contact with zeolite followed by removal of solvent and zeolite. The purification step in the invention is applicable to mass-scale purification, and is especially useful for removing low-molecular impurities, metal salts, etc.

### <Condensed Polycyclic Aromatic Compound>

A condensed polycyclic aromatic compound, especially the condensed polycyclic aromatic compound having n active groups (wherein n is an integer of 1 or more and 4 or less) (the monomer in the invention) is described below.

The active group is meant to indicate a group capable of reacting with the group that any other monomer has, in producing a polymer through polymerization reaction such as coupling reaction or the like.

The active group concretely includes an alkylsulfonyloxy group, an arylsulfonyloxy group or a group having Li, Mg, Zn, B or an atom selected from Group 14 elements of the Periodic Table.

Above all, preferred is a group having B or an atom selected from Group 14 elements of the Periodic Table, more preferred is a group having an atom selected from Group 14 elements, even more preferred is a silicon-containing group or a tin-containing group, and still more preferred is a tin-containing group. In this description, the Periodic Table indicates that in Recommendations of IUPAC 2005.

Of the alkylsulfonyloxy group, preferred is a methylsulfonyloxy group; and of the arylsulfonyloxy group, preferred is a phenylsulfonyloxy group. The alkylsulfonyloxy group and the arylsulfonyloxy group may have a substituent, for example, a halogen atom such as a fluorine atom or the like, or an alkyl group such as a methyl group or the like. Above all, from the viewpoint of improving the coupling reactivity, a methylsulfonyloxy group and a trifluoromethylsulfonyloxy group are preferred as the substituent-having alkylsulfonyloxy group; and a p-toluenesulfonyloxy group is preferred as the substituent-having arylsulfonyloxy group.

The group having Mg includes, for example, a magnesium halide group.

The group having Zn includes, for example, a zinc halide group.

The group having B includes, for example, a boric acid group, a borate salt group, or a borate ester group.

The boric acid group includes -B(OH)₂, etc. The borate salt group includes -BF₃K, etc. Examples of the borate salt group and the borate ester groups are mentioned below.

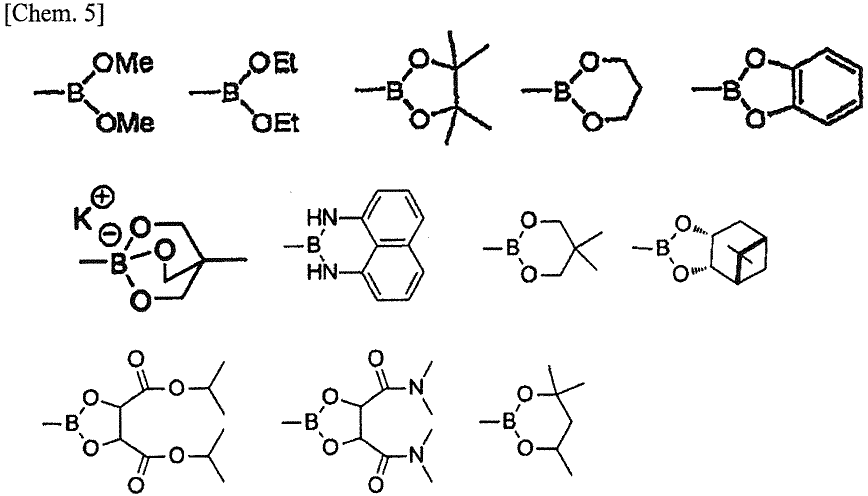

The group with an atom selected from elements of Group 14 of the Periodic Table includes a silicon-containing group, a tin-containing group, a germanium-containing group, a lead-containing group, etc. Of those, a silicon-containing group or a tin-containing group is preferred from the point of reactivity thereof, and a tin-containing group is more preferred. To that effect, it is more desirable that at least one of one or more monomers is an aromatic compound having a tin-containing group, especially a condensed polycyclic aromatic heterocyclic compound having the group. Of the tin-containing group, an alkylstannyl group or an arylstannyl group is more preferred form the point of reactivity, and an alkylstannyl group is more preferred. Examples of the alkylstannyl group are mentioned below.

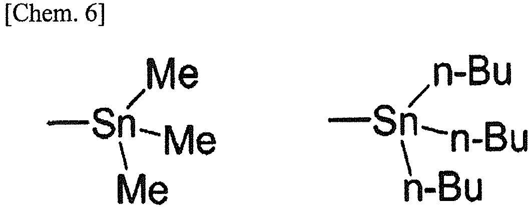

The silicon-containing group includes a silyl group optionally having a substituent, and, for example, usable here are those reported in publications (Pharmaceutical Process Chemistry (2011), 101-126; Accounts of Chemical Research (2008), 41, 1486-1499).

As specific examples, there are mentioned -SiMe₂F, -SiEtF₂, -SiEtCl₂, -SiF₃, -SiMe(OEt)₂, -Si(OMe)₃, -SiMe₂OH, -SiMe₂OK, -SiMe₂ONa, -SiMe₃, -SiMe₂Ph, -SiMe₂(allyl), -SiMe₂Bn, -Si(i-Pr)₂Bn, -SiCy₃, etc. (In these, Me means a methyl group, Et means an ethyl group, Pr means a propyl group, Ph means a phenyl group, allyl means an allyl group, Bn means a benzyl group, Cy means a cyclohexyl group.) Other examples are mentioned below.

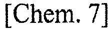

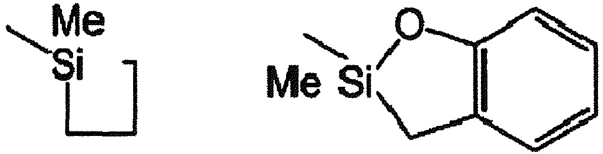

The condensed polycyclic aromatic compound includes a condensed polycyclic aromatic hydrocarbon compound and a condensed polycyclic aromatic heterocyclic compound. Above all, preferred is the condensed polycyclic aromatic heterocyclic compound from the point of enhancement of coupling reactivity. The condensed polycyclic aromatic hydrocarbon compound and the condensed polycyclic aromatic heterocyclic compound include a monocyclic aromatic compound such as benzene, thiophene, etc.; and a compound condensed with an alicyclic compound such as cyclopentadiene, etc.

The condensed polycyclic aromatic hydrocarbon compound is preferably a condensed polycyclic aromatic hydrocarbon compound in which the number of the members constituting the ring is 5 or more and 7 or less and in which the number of the condensed rings is 2 or more and 6 or less. Concretely, there are mentioned naphthalene, anthracene, fluorene, etc.

The condensed polycyclic aromatic heterocyclic compound is preferably a condensed polycyclic aromatic heterocyclic compound in which the number of the members constituting the ring is 5 or more and 7 or less and in which the number of the condensed rings is 2 or more and 6 or less. Concretely, there are mentioned benzothiophene, benzodithiophene, benzofuran, indole, benzoxazole, benzothiazole, benzimidazole, benzopyrazole, benzisoxazole, benzisothiazole, benzothiadiazole, benzoxadiazole, benzotriazole, benzoselenophene, benzotellurophene, benzophosphole, arsindole, silaindene, benzogermole, benzoborole, indacenodithiophene, thienothiophene, imidothiophene, quinoxaline, difuranofluorene, difuranosilol, difuranogermole, difuranostannole, difuranopyranebole, difuranopyrrole, difuraophosphole, difuranoarsole, difuranofuran, difuranothiophene, difuranoselenole, difuranotellurole, difuranoborole, dipyrrolofluorene, dipyrrolosilol, dipyrrologermole, dipyrrolostannole, dipyrrolopyranebole, dipyrrolopyrrole, dipyrrolophosphole, dipyrroloarsole, dipyrrolofuran, dipyrrolothiophene, dipyrroloselenole, dipyrrolotellurole, dipyrroloborole, dithienofluorene, dithienosilol, dithienogermole, dithienostannole, dithienopyranebole, dithienopyrrole, dithienophosphole, dithienoarsole, dithienofuran, dithienothiophene, dithienoselenole, dithienotellurole, dithienoborole, diselenosilol, diselenogermole, diselenostannole, diselenopyranebole, diselenopyrrole, diselenophosphole, diselenoarsole, diselenofuran, diselenothiophene, diselenoselenole, diselenotellurole, diselenoborole, ditellurosilol, ditellurogermole, ditellurostannole, ditelluropyranebole, ditelluropyrrole, ditellurophosphole, ditelluroarsole, ditellurofuran, ditellurothiophene, ditelluroselenole, ditellurotellurole, ditelluroborole, etc.

Above all, preferred is a condensed polycyclic aromatic heterocyclic compound having an atom selected from Group 16 elements as the hetero atom therein, more preferred is a condensed polycyclic heterocyclic compound having an oxygen atom or a sulfur atom as the hetero atom, and even more preferred is a condensed polycyclic aromatic heterocyclic compound having a sulfur atom as the hetero atom. From the point of reactivity, the aromatic hetero ring having an oxygen atom or a sulfur atom as the hetero atom is a 5-membered ring.

From the point of enhancing the semiconductor characteristics of the conjugated polymer to be obtained through coupling reaction, it is desirable that the condensed polycyclic aromatic heterocyclic compound has an atom selected from Group 14 elements of the Periodic Table, especially a carbon atom, a silicon atom or a germanium atom. More preferred is a condensed polycyclic aromatic heterocyclic compound having a silicon atom or a germanium atom.

Of the condensed polycyclic aromatic compounds having n active groups, it is possible to efficiently remove impurities such as low-molecular substances and the like from those where the active groups are easy to thermally and/or chemically release, according to the production method of the invention, without releasing the active groups. In particular, the production method of the invention is effective for the condensed polycyclic aromatic compound having thermally and/or chemically unstable active groups.

The condensed polycyclic aromatic compound having thermally and/or chemically unstable active groups is a condensed polycyclic aromatic compound having at least n active groups (where n indicates an integer of 1 or more and 4 or less) (hereinafter this may be referred to as Ar(n)), and satisfying the following requirement:
Requirement: When 5 ml of a hexane solution containing 1.0 g of the condensed polycyclic aromatic compound (Ar(n)) is charged in a column (having an inner diameter 15 mm and a length 5 cm, and charged with 50 mL of a hexane solution containing 20 g of silica gel (spherical, neutral (pH 7.0 ± 0.5), and having a particle size of from 63 to 210 µm) and 2 g of anhydrous potassium carbonate and developed with a developing solvent of hexane (at a flow rate of 50 ml/min), the total proportion of the condensed polycyclic aromatic compound in which the number of the active groups is smaller than n in the solution having passed through the column in 3 minutes at room temperature is 5 mol% or more relative to the aromatic compound (Ar(n)) before charged in the column. In particular, in the above requirement, the proportion of the aromatic compound in which the number of the active groups is smaller than n in the solution having passed through the column is preferably 20 mol% or more, more preferably 40 mol% or more, even more preferably 60 mol% or more, further preferably 75% or more, further more preferably 90 mol% or more relative to the aromatic compound (Ar(n)) before charged in the column. When the production method of the invention is employed in the preferred case, a conjugated polymer having a high molecular weight can be produced more effectively.

The silica gel to be used under the above condition is spherical and neutral (having pH of 7.0 ±0.5) and has a particle size of from 63 to 210 µm. Concretely, for example, a commercial product, Silica Gel 60N (spherical neutral, for column chromatography, produced by Kanto Chemical) is usable.

n indicates the number of the active groups that the condensed polycyclic aromatic compound has, and is an integer of 1 or more, preferably an integer of 2 or more. On the other hand, the number is an integer of 4 or less, preferably an integer of 3 or less.

The condensed polycyclic aromatic compound (Ar(n)) is preferably a condensed polycyclic aromatic heterocyclic compound, and is more preferably a condensed polycyclic aromatic heterocyclic compound in which the active group bonds to the aromatic hetero ring, from the point of enhanced reactivity in coupling reaction. Even more preferred is a condensed polycyclic aromatic heterocyclic compound in which the group having Li, Mg, B or an atom selected from Group 14 elements of the Periodic Table bonds to the aromatic hetero ring.

Examples of the monomer in the invention are described in more detail hereinunder.

Of the monomer in the invention, there are mentioned compounds represented by the following formula (I) as examples of the compound having two active groups.

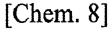

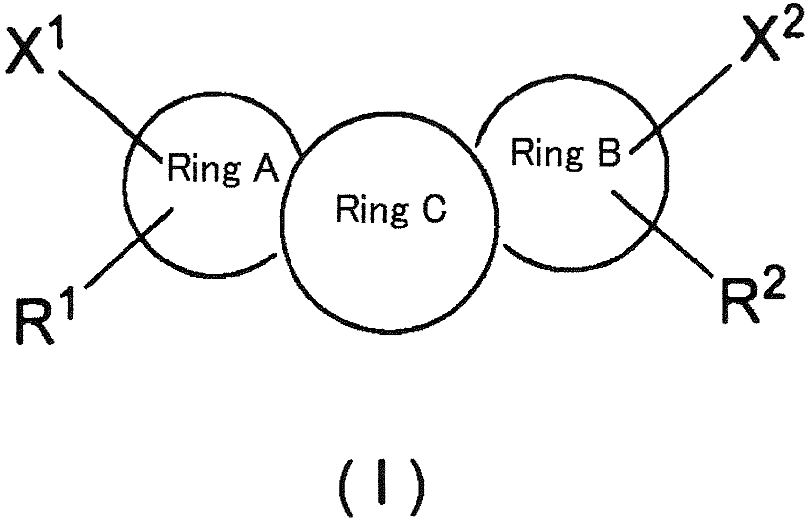

In the formula (I), the ring A and the ring B each independently represent a 5-membered aromatic hetero ring, and the ring C represents any ring optionally having a substituent. X¹ and X² each independently represent an active group. R¹ and R² each independently represent a hydrogen atom, a halogen atom, or a hydrocarbon group optionally having a hetero atom. In the formula (I), X¹ and X² each independently represent an active group, and have the same meanings as those described in the section of the condensed polycyclic aromatic compound.

In the formula (I), the ring A and the ring B each independently represents a 5-membered aromatic hetero ring bonding to the ring C to be mentioned below. Examples of the 5-membered aromatic hetero ring include a thiophene ring, a furan ring, a pyrrole ring, an imidazole ring, a pyrazole ring, an oxazole ring, an isoxazole ring, a thiazole ring and an isothiazole ring. In the case of the 5-membered aromatic hetero ring containing a nitrogen atom, such as a pyrrole ring, an imidazole ring, a pyrazole ring or the like, the nitrogen atom may have an alkyl group such as a methyl group, etc. The bonding mode between the ring A and the ring B, and the ring C is not specifically defined.

In case where the monomer in the invention is used for the coupling reaction to be mentioned below, it is desirable that the monomer is a condensed polycyclic aromatic heterocyclic compound and an active group bonds to the carbon atom of the aromatic hetero ring that the compound has, for enhancing the reactivity in the reaction.

R¹ and R² each independently represent a hydrogen atom, a halogen atom, or a hydrocarbon group optionally having a hetero atom.

The halogen atom includes a fluorine atom, a chlorine atom, a bromine atom or an iodine atom. From the point of safety, preferred is a fluorine atom or a chlorine atom, and more preferred is a fluorine atom.

Examples of the hydrocarbon group optionally having a hetero atom include a hydrocarbon group optionally having a substituent, a heterocyclic group optionally having a substituent, a carbonyl group having a substituent, or a hydrocarbon group or a heterocyclic group which optionally has a substituent and bonds via a hetero atom. The hydrocarbon group or the heterocyclic group bonding via a hetero atom means a hydrocarbon group or a heterocyclic group bonding to the basic skeleton, for example, the ring A or the ring B via a hetero atom. The hydrocarbon group or the heterocyclic group and the hetero atom are collectively referred to as a hydrocarbon group or a heterocyclic group bonding via a hetero atom.

Not specifically defined, the hetero atom includes, for example, an oxygen atom, a nitrogen atom, a sulfur atom, etc.

The hydrocarbon group includes an aliphatic hydrocarbon group and an aromatic hydrocarbon group. The aliphatic hydrocarbon group includes a saturated aliphatic hydrocarbon group such as an alkyl group (including a cycloalkyl group) etc.; and an unsaturated aliphatic hydrocarbon group such as an alkenyl group (including a cycloalkenyl group), an alkynyl group, etc. Especially preferred is a saturated aliphatic hydrocarbon group such as an alkyl group, etc.

The number of the carbon atoms constituting the alkyl group is generally 1 or more, preferably 3 or more, more preferably 4 or more, and is generally 20 or less, preferably 16 or less, more preferably 12 or less, even more preferably 10 or less.

The alkyl group of the type includes, for example, a linear alkyl group such as a methyl group, an ethyl group, an n-propyl group, an n-butyl group, an n-pentyl group, an n-hexyl group, an n-octyl group, an n-nonyl group, an n-decyl group, an n-lauryl group, etc.; a branched alkyl group such as an iso-propyl group, an iso-butyl group, a tert-butyl group, a 3-methylbutyl group, a 2-ethylhexyl group, a 3,7-dimethyloctyl group, etc.; a cyclic alkyl group such as a cyclopropyl group, a cyclobutyl group, a cyclopentyl group, a cyclohexyl group, a cycloheptyl group, a cyclooctyl group, a cyclononyl group, a cyclolauryl group, a cyclodecyl group, etc. Of those, as the linear alkyl group, preferred is an n-propyl group, an n-butyl group, an n-pentyl group, an n-hexyl group, an n-heptyl group, an n-octyl group, an n-nonyl group, an n-decyl group, or an n-lauryl group; as the branched alkyl group, preferred is an iso-propyl group, an iso-butyl group, a tert-butyl group, a 3-methylbutyl group, a 2-ethylhexyl group, or a 3,7-dimethyloctyl group; and as the cyclic alkyl group, preferred is a cyclopropyl group, a cyclobutyl group, a cyclopentyl group, a cyclohexyl group, a cycloheptyl group, or a cyclolauryl group. More preferred are an n-butyl group, an iso-propyl group, an iso-butyl group, a tert-butyl group, an n-pentyl group, a 3-methylbutyl group, a cyclopentyl group, an n-hexyl group, a cyclohexyl group, a 2-ethylhexyl group, a cyclooctyl group, an n-nonyl group, a 3,7-dimethyloctyl group, a cyclononyl group, an n-decyl group, and a cyclodecyl group.

The number of the carbon atoms constituting the alkenyl group is generally 1 or more, preferably 3 or more, more preferably 4 or more, and is, on the other hand, generally 20 or less, preferably 16 or less, more preferably 12 or less, even more preferably 10 or less. The alkenyl group of the type includes, for example, a vinyl group, a propenyl group, a butenyl group, a pentenyl group, a hexenyl group, a heptenyl group, an octenyl group, a nonenyl group, a decenyl group, an undecenyl group, a dodecenyl group, a tridecenyl group, a tetradecenyl group, a pentadecenyl group, a hexadecenyl group, a heptadecenyl group, an octadecenyl group, a nonadecenyl group, an eicosenyl group, a geranyl group, etc. Preferred are a propenyl group, a butenyl group, a pentenyl group, a hexenyl group, a heptenyl group, an octenyl group, a nonenyl group, a decenyl group, an undecenyl group and a dodecenyl group; more preferred are a butenyl group, a pentenyl group, a hexenyl group, a heptenyl group, an octenyl group, a nonenyl group and a decenyl group. As the alkenyl group, preferred is one having from 2 to 20 carbon atoms, for example, a vinyl group, a styryl group, etc.

The alkynyl group is preferably one having from 2 to 20 carbon atoms, for example, a methylethynyl group, a trimethylsilylethynyl group, etc.

The aromatic hydrocarbon group is preferably one having from 6 to 30 carbon atoms, for example, a phenyl group, a naphthyl group, a phenanthryl group, a biphenylenyl group, a triphenylenyl group, an anthryl group, a pyrenyl group, a fluorenyl group, an azulenyl group, an acenaphthenyl group, a fluoranthenyl group, a naphthacenyl group, a perylenyl group, a pentacenyl group, a quarter-phenyl group, etc. Above all, preferred are a phenyl group, a naphthyl group, a phenanthryl group, a triphenylenyl group, an anthryl group, a pyrenyl group, a fluorenyl group, an acenaphthenyl group, a fluoranthenyl group, and a perylenyl group.

The heterocyclic group includes an aliphatic heterocyclic group and an aromatic heterocyclic group. The aliphatic heterocyclic group is preferably one having from 2 to 30 carbon atoms, including, for example, a pyrrolidinyl group, a piperidinyl group, a piperazinyl group, a tetrahydrofuranyl group, a dioxanyl group, a morpholinyl group, a thiomorpholinyl group, etc. Above all, preferred are a pyrrolidinyl group, a piperidinyl group and a piperazinyl group. The aromatic heterocyclic group is preferably one having from 2 to 30 carbon atoms, including, for example, a pyridyl group, a thienyl group, a furyl group, a pyrrolyl group, an oxazolyl group, a thiazolyl group, an oxadiazolyl group, a thiadiazolyl group, a pyrazinyl group, a pyrimidinyl group, a pyrazolyl group, an imidazolyl group, a benzothienyl group, a dibenzofuryl group, a dibenzothienyl group, a carbazolyl group, a phenylcarbazolyl group, a phenoxathiinyl group, a xanthenyl group, a benzofuranyl group, a thianthrenyl group, an indolidinyl group, a phenoxazinyl group, a phenothiazinyl group, an acridinyl group, a phenanthrydinyl group, a phenanthrolinyl group, a quinolyl group, an isoquinolyl group, an indolyl group, a quinoxalinyl group, etc. Above all, preferred are a pyridyl group, a pyrazinyl group, a pyrimidinyl group, a pyrazolyl group, a quinolyl group, an isoquinolyl group, an imidazolyl group, an acridinyl group, a phenanthrydinyl group, a phenanthrolinyl group, a quinoxalinyl group, a dibenzofuryl group, a dibenzothienyl group, a xanthenyl group and a phenoxazinyl group.

The aromatic hydrocarbon group and the aromatic heterocyclic group may be a condensed polycyclic aromatic group. The ring to form the condensed polycyclic aromatic group is preferably a cyclic alkyl structure optionally having a substituent, an aromatic hydrocarbon ring optionally having a substituent, or an aromatic hetero ring optionally having a substituent. The cyclic alkyl structure is, for example, a cyclopentane structure or a cyclohexane structure. The aromatic hydrocarbon ring is, for example, a benzene ring or a naphthalene ring. The aromatic hetero ring includes, for example, a pyridine ring, a thiophene ring, a furan ring, a pyrrole ring, an oxazole ring, a thiazole ring, an oxadiazole ring, a thiadiazole ring, a pyrazine ring, a pyrimidine ring, a pyrazole ring, an imidazole ring, etc. Of those, preferred are a pyridine ring and a thiophene ring.

Concretely, the condensed polycyclic aromatic group is preferably a condensed polycyclic aromatic hydrocarbon group or a condensed polycyclic aromatic heterocyclic group. The condensed polycyclic aromatic hydrocarbon group includes, for example, a phenanthryl group, an anthryl group, a pyrenyl group, a fluoranthenyl group, a naphthacenyl group, a perylenyl group, a pentacenyl group, a triphenylenyl group, etc. The condensed polycyclic aromatic heterocyclic group includes, for example, a phenoxazinyl group, a phenothiazinyl group, an acridinyl group, a phenanthrydinyl group, a phenanthrolinyl group, etc.

The carbonyl group having a substituent includes, for example, an alkylcarbonyl group, an arylcarbonyl group, an alkyloxycarbonyl group, an aryloxycarbonyl group, an alkylcarbamoyl group, an arylcarbamoyl group, an alkylimide group, an arylimide group, etc. Aryl means an aromatic group.

The carbon number of the substituent that the carbonyl group has is not specifically defined, but is generally 1 or more and 40 or less. The alkyl group that the alkylcarbonyl group, the alkyloxycarbonyl group, the alkylcarbamoyl group or the alkylimide group has is not specifically defined, but is generally one having from 1 to 40 carbon atoms. The aryl group that the arylcarbonyl group, the aryloxycarbonyl group, the arylcarbamoyl group and the arylimide group has is not specifically defined, but is generally one having from 2 to 40 carbon atoms.

The alkylcarbonyl group includes, for example, an acetyl group, an ethylcarbonyl group, a propylcarbonyl group, a pentylcarbonyl group, a cyclohexylcarbonyl group, an octylcarbonyl group, a 2-ethylhexylcarbonyl group, a dodecylcarbonyl group, etc. Above all, preferred are an octylcarbonyl group, a 2-ethylhexylcarbonyl group and a dodecylcarbonyl group.

The arylcarbonyl group includes, for example, a benzoyl group, a naphthylcarbonyl group, a pyridylcarbonyl group, etc. Above all, preferred is a benzoyl group.

The alkyloxycarbonyl group includes, for example, a methoxycarbonyl group, an ethoxycarbonyl group, an n-butoxycarbonyl group, etc.

The aryloxycarbonyl group includes, for example, a phenoxycarbonyl group, a naphthoxycarbonyl group, etc.

The alkylcarbamoyl group is preferably one having from 3 to 40 carbon atoms, including, for example, a methylaminocarbonyl group, a dimethylaminocarbonyl group, a propylaminocarbonyl group, a pentylaminocarbonyl group, a cyclohexylaminocarbonyl group, an octylaminocarbonyl group, a methylhexylaminocarbonyl group, an octylaminocarbonyl group, a 2-ethylhexylaminocarbonyl group, a dodecylaminocarbonyl group, etc. Above all, preferred are an octylaminocarbonyl group and a 2-ethylhexylaminocarbonyl group.

The arylcarbamoyl group is preferably one having from 3 to 40 carbon atoms, including, for example, a phenylaminocarbonyl group, a naphthylaminocarbonyl group, a 2-pyridylaminocarbonyl group, etc. Above all, preferred is a phenylaminocarbonyl group.

The alkylimide group is one preferably having from 2 to 20 carbon atoms, including, for example, a methylcarbonylaminocarbonyl group, an ethylcarbonylaminocarbonyl group, an n-butylcarbonylaminocarbonyl group, etc.

The arylimide group is one preferably having rom 2 to 20 carbon atoms, including, for example, a phenylcarbonylaminocarbonyl group, a naphthylcarbonylaminocarbonyl group, etc.

The number of the carbon atoms that the hydrocarbon group bonding via a hetero atom has is not specifically defined, but is generally 1 or more and 40 or less. The alkyl group of the hydrocarbon group bonding via a hetero atom is not specifically defined in point of the number of the carbon atoms constituting the group, but in general, the carbon number is 1 or more and 40 or less. The aryl group of the hydrocarbon group bonding via a hetero atom is not specifically defined in point of the number of the carbon atoms constituting the group, but in general, the carbon number is 2 or more and 40 or less.

Concretely, the hydrocarbon group or the heterocyclic group bonding via a hetero atom includes an alkoxy group, an aryloxy group, an alkylthio group, an arylthio group, an alkylamino group, an arylamino group, an N-aryl-N-alkylamino group, an alkylsulfonyl group, an arylsulfonyl group, etc. From the viewpoint of improving the electron-transporting characteristics of the electron extraction layer, preferred is an alkoxy group or an aryloxy group.

The alkoxy group is preferably one having from 1 to 20 carbon atoms, including, for example, a linear or branched alkoxy group such as a methoxy group, an ethoxy group, an n-propoxy group, an i-propoxy group, an n-butoxy group, an i-butoxy group, a t-butoxy group, a benzyloxy group, an ethylhexyloxy group, etc.

The aryloxy group is preferably one having from 2 to 20 carbon atoms, including, for example, a phenoxy group, a naphthyloxy group, a pyridyloxy group, a thiazolyloxy group, an oxazolyloxy group, an imdiazolyloxy group, etc. Above all, preferred are a phenoxy group and a pyridyloxy group.

The alkylthio group is preferably one having from 1 to 20 carbon atoms, including, for example, a methylthio group, an ethylthio group, a propylthio group, a pentylthio group, a hexylthio group, an octylthio group, a dodecylthio group, a cyclopentylthio group, a cyclohexylthio group, etc. Above all, preferred are a methylthio group and an octylthio group.

The arylthio group is preferably one having from 2 to 20 carbon atoms, including, for example, a phenylthio group, a naphthylthio group, a pyridylthio group, a thiazolylthio group, an oxazolylthio group, an imidazolylthio group, a furylthio group, a pyrrolylthio group, etc. Above all, preferred are a phenylthio group and a pyridylthio group.

The alkylamino group is preferably one having from 1 to 20 carbon atoms, including, for example, a methylamino group, an ethylamino group, a dimethylamino group, a diethylamino group, a butylamino group, an octylamino group, a cyclopentylamino group, a 2-ethylhexylamino group, a dodecylamino group, etc. Above all, preferred are a dimethylamino group, an octylamino group and a 2-ethylhexylamino group.

The arylamino group is preferably one having from 2 to 20 carbon atoms, including, for example, an anilino group, a diphenylamino group, a naphthylamino group, a 2-pyridylamino group, a naphthylphenylamino group, etc. Above all, preferred is a diphenylamino group.

The N-aryl-N-alkylamino group is preferably one having from 3 to 40 carbon atoms, including, for example, an N-phenyl-N-methylamino group, an N-naphthyl-N-methylamino group, etc.

The alkylsulfonyl group includes, for example, a methylsulfonyl group, an ethylsulfonyl group, a butylsulfonyl group, an octylsulfonyl group, a cyclohexylsulfonyl group, a 2-ethylhexylsulfonyl group, a dodecylsulfonyl group, etc. Above all, preferred are an octylsulfonyl group and 2-ethylhexylsulfonyl group.

The arylsulfonyl group includes, for example, a phenylsulfonyl group, a naphthyl sulfonyl group, a 2-pyridylsulfonyl group, etc. Above all, preferred is a phenylsulfonyl group.

The hydrocarbon group optionally having a hetero atom may further have a substituent. Not specifically defined, examples of the substituent that the group may additionally have include a halogen atom, a hydroxyl group, a cyano group, an amino group, an ester group, an alkylcarbonyl group, an acetyl group, a sulfonyl group, a silyl group, a boryl group, a nitrile group, an alkyl group, an alkenyl group, an alkynyl group, an alkoxy group, an aromatic hydrocarbon group, and an aromatic heterocyclic group. Of these, the neighboring substituents may bond to each other to form a ring. The halogen atom includes a fluorine atom, a chlorine atom, a bromine atom and an iodine atom. Of those, preferred is a fluorine atom. In case where the hydrocarbon group optionally having a substituent is an aryl group, preferred examples of the substituent that the group may additionally have include an alkoxy group having from 1 to 12 carbon atoms, and an alkyl group having from 1 to 12 carbon atoms.

More preferably, R¹ and R² each are a hydrogen atom or an alkyl group optionally having a substituent. A hydrogen atom is preferred from the point of promoting the polymerization reaction with the monomer in the invention. An alkyl group is preferred from the point of increasing the solubility of the polymer to be produced from the monomer in the invention. From the viewpoint of the reactivity, the alkyl group is preferably one having at most 12 carbon atoms, more preferably at most 6 carbon atoms.

As the ring A and the ring B, preferred are rings represented by the following formulae (Ia) and (Ib):

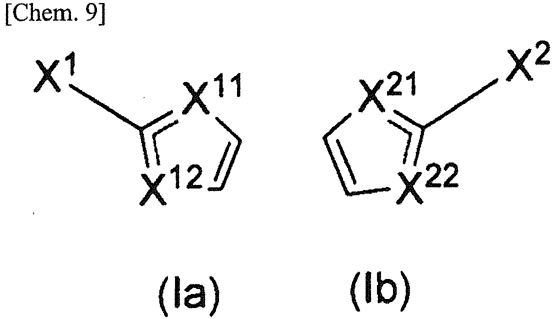

In the formulae (Ia) and (Ib), X¹ and X² are the same as in the formula (I). In the formula (Ia), one of X¹¹ and X¹² is an atom selected from Group 16 elements of the Periodic Table, and the other is a carbon atom. In the formula (Ib), one of X²¹ and X²² is an atom selected from Group 16 elements of the Periodic Table, and the other is a carbon atom.

In the formula (Ia), one of X¹¹ and X¹² is an atom selected from Group 16 elements of the Periodic Table, and the other is a carbon atom. The bond between the atom selected from Group 16 elements of the Periodic Table and C¹ is a single bond, and the bond between the carbon atom and C¹ is a double bond. The carbon atom that is the other of X¹¹ and X¹² bonds to R¹ in the formula (I).

Similarly, in the formula (Ib), one of X²¹ and X²² is an atom selected from Group 16 elements of the Periodic Table, and the other is a carbon atom. The bond between the atom selected from Group 16 elements of the Periodic Table and C² is a single bond, and the bond between the carbon atom and C² is a double bond. The carbon atom that is the other of X²¹ and X²² bonds to R² in the formula (I).

One of X¹¹ and X¹² that is an atom selected from Group 16 elements of the Periodic Table is more preferably an oxygen atom or a sulfur atom, even more preferably a sulfur atom. One of X¹¹ and X¹² that is an oxygen atom or a sulfur atom, especially a sulfur atom is preferred as facilitating hydrogen atom drawing from the neighboring carbon atom C¹.

Similarly, one of X²¹ and X²² that is an atom selected from Group 16 elements of the Periodic Table is more preferably an oxygen atom or a sulfur atom, even more preferably a sulfur atom. One of X²¹ and X²² that is an oxygen atom or a sulfur atom, especially a sulfur atom is preferred as facilitating hydrogen atom drawing from the neighboring carbon atom C².

In the formula (I), the ring C represents any ring optionally having a substituent. Above all, the ring is preferably a 5-membered or 6-membered single ring, or condensed ring formed through condensation of from 2 to 6 such rings.

The 5-membered single ring includes a 5-membered aromatic ring or a 5-membered aliphatic ring. The 5-membered aromatic ring includes a 5-membered aromatic hetero ring such as a thiophene ring, a furan ring, a pyrrole ring, a thiazole ring, an oxazole ring, an imidazole ring, a pyrazole ring, an isoxazole ring, an isothiazole ring, a thiadiazole ring, an oxadiazole ring, a triazole ring, a selenol ring, a tellurole ring, etc.

Above all, preferred is a 5-membered aromatic hetero ring; more preferred is a 5-membered aromatic hetero ring containing a sulfur ring, such as a thiophene ring, a thiazole ring, an isothiazole ring, a thiadiazole ring, etc.; and even more preferred is a thiophene ring.

The 5-membered aliphatic ring includes a 5-membered aliphatic hydrocarbon ring such as a cyclopentane ring, a cyclopentadiene ring, etc.; a 5-membered aliphatic hetero ring such as a tetrahydrofuran ring, a pyrrolidine ring, a borole ring, a silole ring, a germole ring, a stannole ring, a pyranebole ring, a phosphole ring, an arsole ring, etc.

The 6-membered single ring includes, for example, a 6-membered aromatic ring and a 6-membered aliphatic ring. The 6-membered aromatic ring includes, for example, a 6-membered aromatic hydrocarbon ring such as a benzene ring, etc.; a 6-membered aromatic hetero ring such as a pyridine ring, a pyrazine ring, a pyrimidine ring, a pyridazine ring, etc.

The 6-membered aliphatic ring includes, for example, a 6-membered aliphatic hydrocarbon ring such as a cyclohexane ring, etc.; a 6-membered aliphatic hetero ring such as an oxane ring, a dioxane ring, a piperidine ring, a piperazine ring, etc.

The ring formed through condensation of from 2 to 6 these rings includes, for example, a polycyclic condensed aromatic hydrocarbon ring, and a polycyclic condensed aromatic hetero ring.

The polycyclic condensed aromatic hydrocarbon ring has from 2 to 6 condensed rings, concretely including a naphthalene ring, an anthracene ring, a fluorene ring, an indacene ring, etc.

The polycyclic condensed aromatic hetero ring has from 2 to 6 condensed rings, concretely including a quinolyl group, an acridinyl group, an indolyl group, an isoquinolyl group, a quinoxalinyl group, a carbazolyl group, etc.

The substituent that the ring C may have is not specifically defined, and concrete examples thereof include a halogen atom, a hydrocarbon group, an aromatic heterocyclic group, an alkylcarbonyl group, an arylcarbonyl group, an alkyloxycarbonyl group, an aryloxycarbonyl group, an alkylaminocarbonyl group, an arylaminocarbonyl group, an alkoxy group, an aryloxy group, etc. The hydrocarbon group, the aromatic heterocyclic group, the alkylcarbonyl group, the arylcarbonyl group, the alkyloxycarbonyl group, the aryloxycarbonyl group, the alkylaminocarbonyl group, the arylaminocarbonyl group, the alkoxy group and the aryloxy group may further have a substituent.

Of the compounds represented by the formula (I), more preferred are condensed polycyclic aromatic compounds represented by the following formula (II) or formula (III):

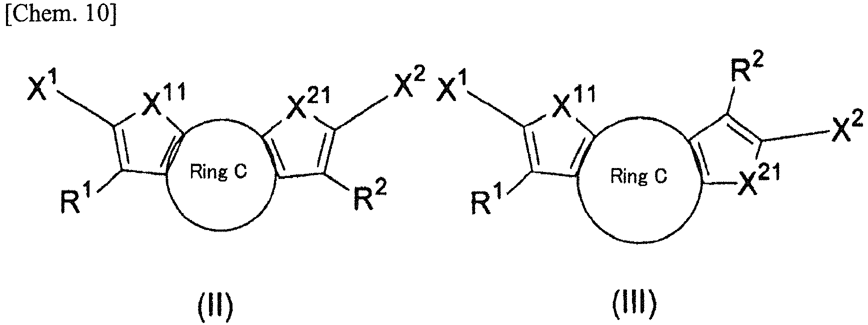

In the formula (II) and the formula (III), X¹, X², R¹, R² and the ring C are the same as in the formula (I). X¹¹ and X²¹ each independently represent an atom selected from Group 16 elements of the Periodic Table.

In the formula (II) and the formula (III), X¹¹, X²¹ are the same as in the formula (Ia) and (Ib). X¹ and X² are the same as in the formula (I), each independently representing an active group. R¹ and R² are the same as in the formula (I), each independently representing a hydrogen atom, a halogen atom, or a hydrocarbon group optionally having a hetero atom.

Of the condensed polycyclic aromatic compounds represented by the formula (II) or the formula (III), preferred are the compounds represented by the following formula (IV), formula (V), formula (VI) or formula (VII):

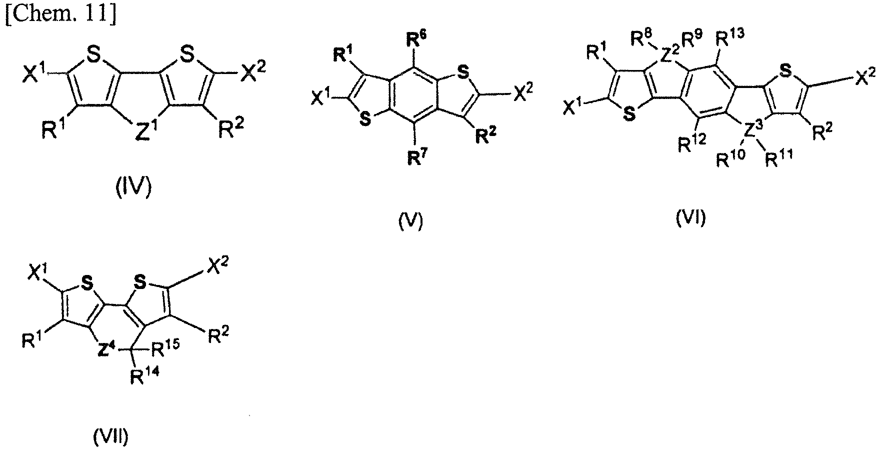

The compounds represented by the formulae (IV) to (VII) are described below.

In the formula (IV), X¹ and X² are the same as in the formula (II). In the formula (IV), R¹ and R² are the same as in the formula (II).

In the formula (IV), Z¹ represents Z¹¹(R³)(R⁴), Z¹²(R⁵) or Z¹³. Above all, preferred is Z¹¹(R³)(R⁴) or Z¹³, and more preferred is Z¹¹(R³)(R⁴), from the point of improving the semiconductor characteristics of the polymer.

Z¹¹ represents an atom selected from Group 14 elements of the Periodic Table. Preferably, Z¹¹ is a carbon atom, a silicon atom or a germanium atom, and from the viewpoint that the semiconductor characteristics of the conjugated polymer to be produced by the use of the compound represented by the formula (IV), Z¹¹ is more preferably a silicon atom or a germanium atom.

R³ and R⁴ are the same as the above-mentioned R¹ and R². R³ and R⁴ may bond to each other to form a ring, or may bond to R¹ or R² to form a ring.

Preferred substituents are mentioned. At least one of R³ and R⁴ is preferably an alkyl group or an aromatic group optionally having a substituent, but more preferably, both of R³ and R⁴ are alkyl groups or aromatic groups optionally having a substituent.

At least one of R³ and R⁴ that is an alkyl group optionally having a substituent is preferred from the viewpoint that the conjugated polymer to be produced from the monomer compound represented by the formula (IV) can absorb light having a longer wavelength.

At least one of R³ and R⁴ that is a linear alkyl group optionally having a substituent is preferred from the viewpoint that the crystallinity of the conjugated polymer to be produced from the monomer compound represented by the formula (IV) can increase and therefore the mobility thereof can be greater.

At least one of R³ and R⁴ that is a branched alkyl group optionally having a substituent is preferred from the viewpoint that the solubility of the conjugated polymer to be produced from the monomer compound represented by the formula (IV) can increase therefore facilitating the film formation with the polymer according to a coating process. From these viewpoints, at least one of R³ and R⁴ is preferably an alkyl group having from 1 to 20 carbon atoms, more preferably an alkyl group having from 6 to 20 carbon atoms.

At least one of R³ and R⁴ that is an aromatic group optionally having a substituent is preferred from the viewpoint that the intermolecular interaction increases owing to the interaction between the π-electrons, and therefore the mobility of the material that contains the conjugated polymer to be produced from the monomer compound represented by the formula (IV) can increase, and in addition, the stability of the cyclic skeleton containing the atom Z¹¹ tends to better.

In the embodiment where R³ is a branched alkyl group optionally having a substituent, R⁴ is a linear alkyl group optionally having a substituent or an aromatic group optionally having a substituent, the steric hindrance around the atom Z¹¹ can be prevented and therefore the intermolecular interaction of the conjugated polymer to be produced from the monomer compound represented by the formula (IV) can suitably better. This is preferred from the viewpoint that the absorption wavelength of the conjugated polymer to be produced from the monomer compound represented by the formula (IV) can be prolonged and the mobility of the material containing the conjugated polymer to be produced from the monomer compound represented by the formula (IV) tends to increase and, in addition, the stability of the cyclic skeleton containing the atom Z¹¹ tends to better.

The invention of the embodiment is preferred in that both the effect of the branched alkyl group (R³) to increase the solubility of the conjugated polymer and the effect of the linear alkyl group or the aromatic group (R⁴) to increase the crystallinity of the conjugated polymer and to better the intermolecular interaction of the conjugated polymer can be secured not detracting from any of these effects.

From the viewpoint of increasing the steric hindrance around the atom Z¹¹ to thereby enhance the durability of the conjugated polymer, it is desirable that R³ and R⁴ each are an alkyl group optionally having a substituent, an alkenyl group optionally having a substituent, or an aromatic group optionally having a substituent.

Z¹² represents an atom selected from Group 15 elements of the Periodic Table. Z¹² is preferably a nitrogen atom, a phosphorus atom or an arsenic atom, and from the viewpoint of improving the semiconductor characteristics of the conjugated polymer to be produced by the use of the compound represented by the formula (IV), Z is more preferably a nitrogen atom or a phosphorus atom, even more preferably a nitrogen atom.

As R⁵, there are mentioned the same substituents as those mentioned hereinabove for R³ and R⁴. Preferred is an alkyl group optionally having a substituent or an aromatic group optionally having a substituent. R⁵ may bond to R¹ or R² to form a ring.

Z¹³ represents an atom selected from Group 16 elements of the Periodic Table. Z¹³ is preferably an oxygen atom, a sulfur atom or a selenium atom, and from the viewpoint of improving the semiconductor characteristics of the conjugated polymer to be produced by the use of the compound represented by the formula (IV), Z¹³ is more preferably an oxygen atom or a sulfur atom, even more preferably a sulfur atom.

In the formula (V), X¹ and X² are the same as in the formula (II). R¹ and R² are the same as in the formula (II).

In the formula (V), R⁶ and R⁷ each represent a hydrogen atom, a halogen atom, an alkyl group optionally having a substituent, an alkenyl group optionally having a substituent, an alkynyl group optionally having a substituent, an aromatic group optionally having a substituent, an alkoxy group optionally having a substituent, or an aryloxy group optionally having a substituent. Above all, from the viewpoint of improving the solubility of the compound, preferred is an alkyl group optionally having a substituent; and from the viewpoint of easiness in substituent introduction into the compound, also preferred is an alkoxy group optionally having a substituent.

The halogen atom, the alkyl group, the alkenyl group, the alkynyl group and the aromatic group are the same as those described hereinabove for R¹ and R².

The alkoxy group is preferably one having from 1 to 20 carbon atoms, for example, a linear or branched alkoxy group such as a methoxy group, an ethoxy group, an n-propoxy group, an i-propoxy group, an n-butoxy group, an i-butoxy group, a t-butoxy group, a benzyloxy group, an ethylhexyloxy group, etc.

The aryloxy group is preferably one having from 2 to 20 carbon atoms, for example, including a phenoxy group, a naphthyloxy group, a pyridyloxy group, a thiazolyloxy group, an oxazolyloxy group, an imdiazolyloxy group, etc. Above all, preferred are a phenoxy group and a pyridyloxy group.

Examples of the substituent which the alkyl group, the alkenyl group, the alkynyl group, the aromatic group, the alkoxy group and the aryloxy group may have, may be the same as those of the substituent which the alkyl group, the alkenyl group, the alkynyl group and the aromatic group of R¹ and R² may have. In the formula (VI), X¹ and X² are the same as in the formula (II).

In the formula (VI), R¹ and R² are the same as in the formula (II), including the same groups as those mentioned hereinabove for R⁸ to R¹¹ and R³ and R⁴. Above all, at least one of R³ and R⁴ is preferably an alkyl group or an aromatic group optionally having a substituent. R¹ and R⁸, R² and R¹¹, R⁸ and R⁹, and R¹⁰ and R¹¹ may bond to each other to form a ring.

In the formula (VI), as R¹² and R¹³, there are mentioned the same groups as those mentioned hereinabove for R¹ and R². Above all, from the viewpoint of easiness in production of the compound, preferred is a hydrogen atom. R⁹ and R¹³, and R¹⁰ and R¹² may bond to each other to form a ring.

In the formula (VI), Z² and Z³ each independently represent an atom selected from Group 14 elements of the Periodic Table. Z² and Z³ may be the same or different, but is the same from the viewpoint of the compound stability.

Z² and Z³ each are preferably a carbon atom, a silicon atom or a germanium atom, and more preferably a silicon atom or a germanium atom from the viewpoint of improving the semiconductor characteristics of the conjugated polymer to be produced by the use of the compound represented by the formula (VI).

In the formula (VII), X¹ and X² are the same as in the formula (II); and R¹ and R² are the same as in the formula (II). In the formula (VII), as R¹⁴ and R¹⁵, there are mentioned the same groups as those mentioned hereinabove for R³ and R⁴ in the formula (VI). Above all, preferred is an alkyl group optionally having a substituent.

In the formula (VII), Z⁴ represents an atom selected from Group 16 elements of the Periodic Table. Z⁴ is preferably an oxygen atom, a sulfur atom or a selenium atom. From the viewpoint of improving the semiconductor characteristics of the conjugated polymer to be produced by the use of the compound represented by the formula (VII), Z⁴ is more preferably an oxygen atom or a sulfur atom, even more preferably an oxygen atom.

Of the compounds represented by the formulae (IV) to (VII) to be used as the monomer in the invention, preferred are those represented by the formula (IV) or the formula (V) from the viewpoint of readily enhancing the conversion efficiency in use of the polymer to be mentioned below in a photoelectric conversion element, and more preferred are those represented by the formula (IV).

Not limited thereto, compounds having any of the following structures are concretely mentioned for the monomer in the invention. These compounds may further have a substituent. In the following formulae, Me is a methyl group(-CH₃), Et is an ethyl group (-CH₂CH₃), i-Pr is an i-propyl group (-CH(CH₃)₂), n-Bu is an n-butyl group (-CH₂CH₂CH₂CH₃), and tBu is a t-butyl group (-C(CH₃)₃).

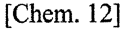

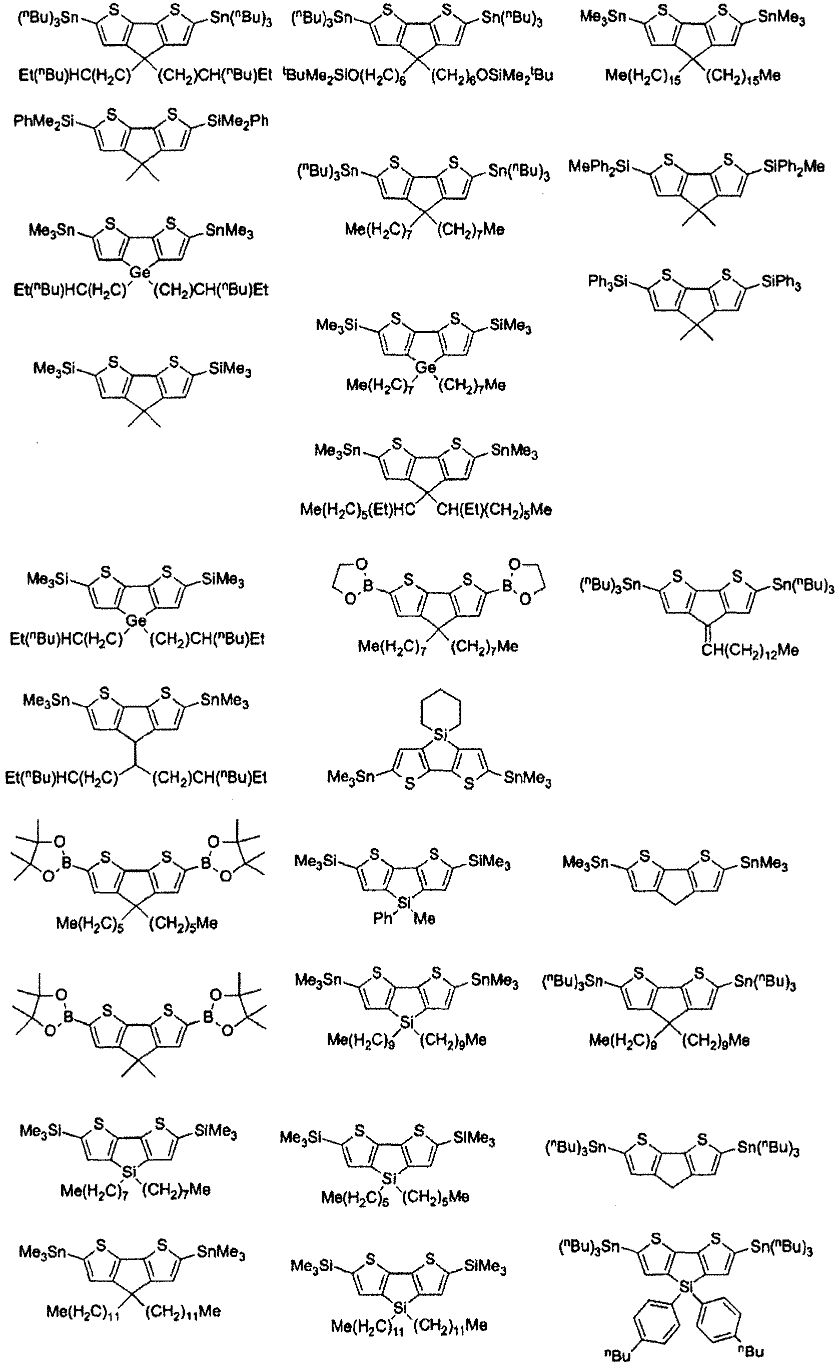

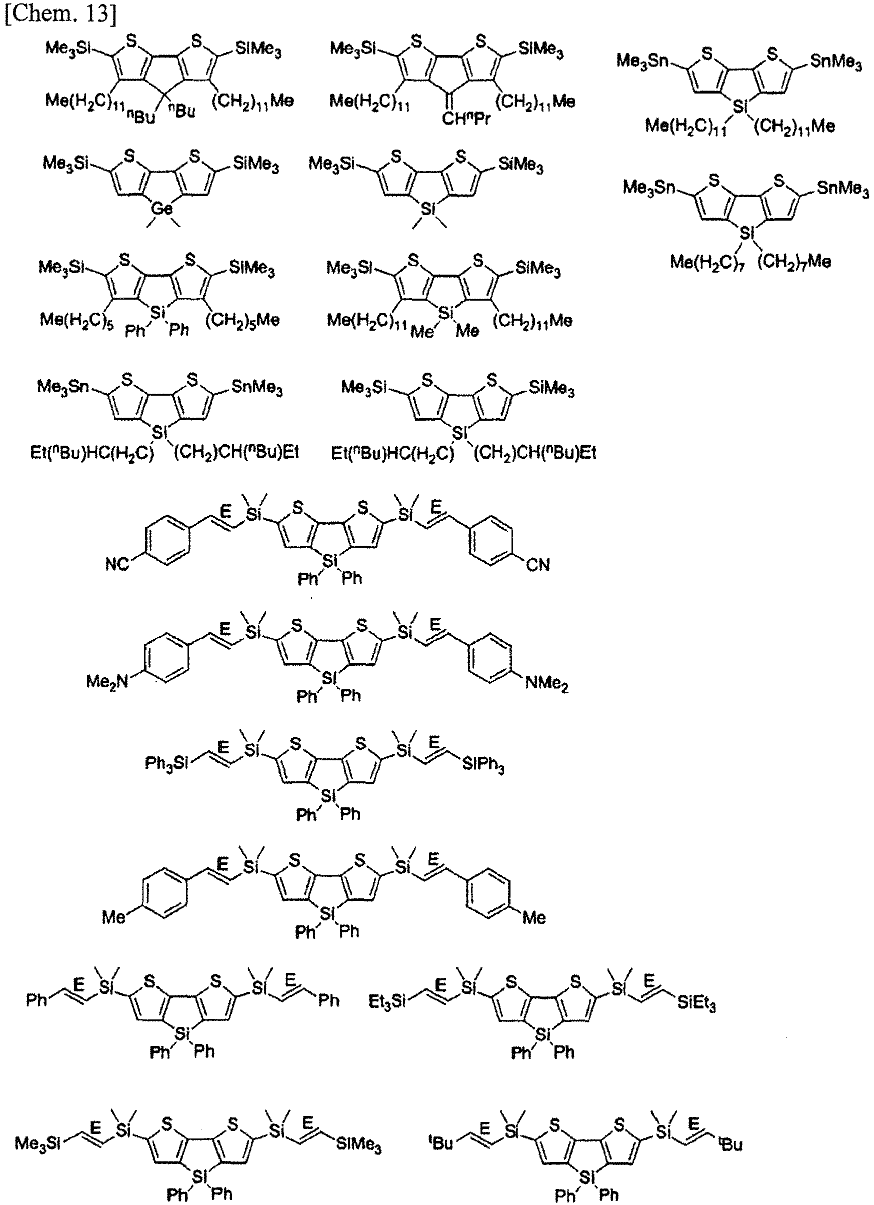

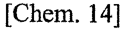

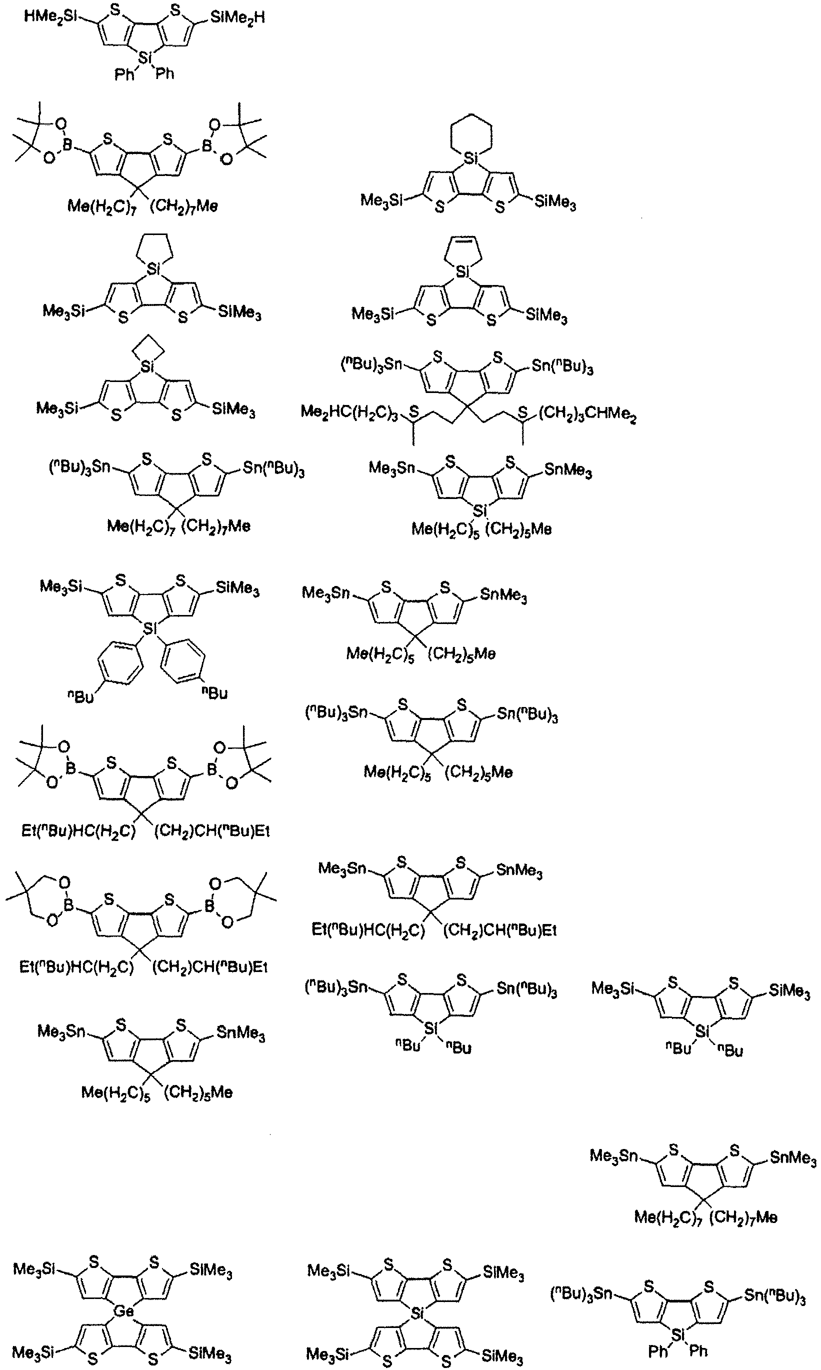

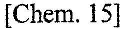

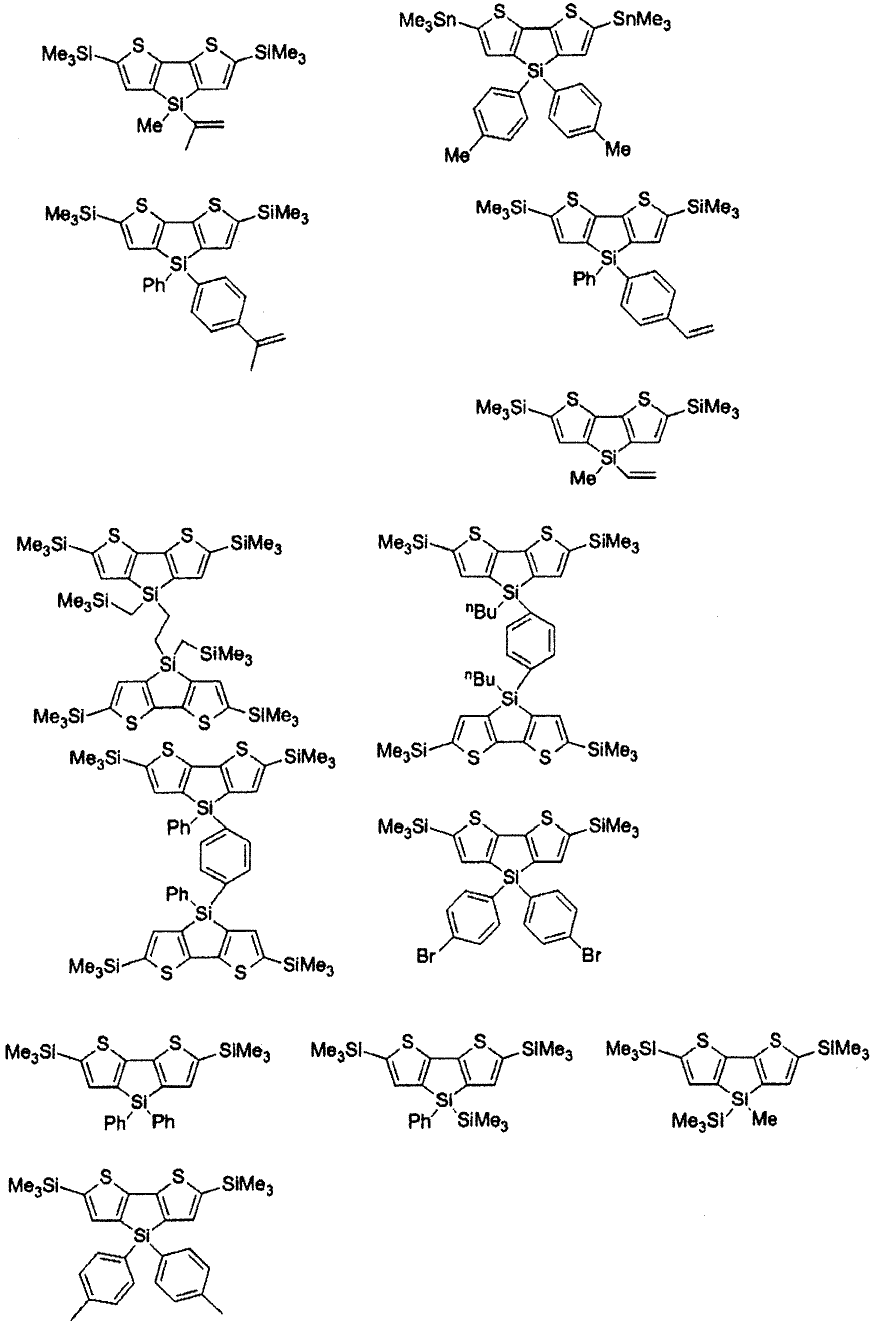

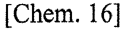

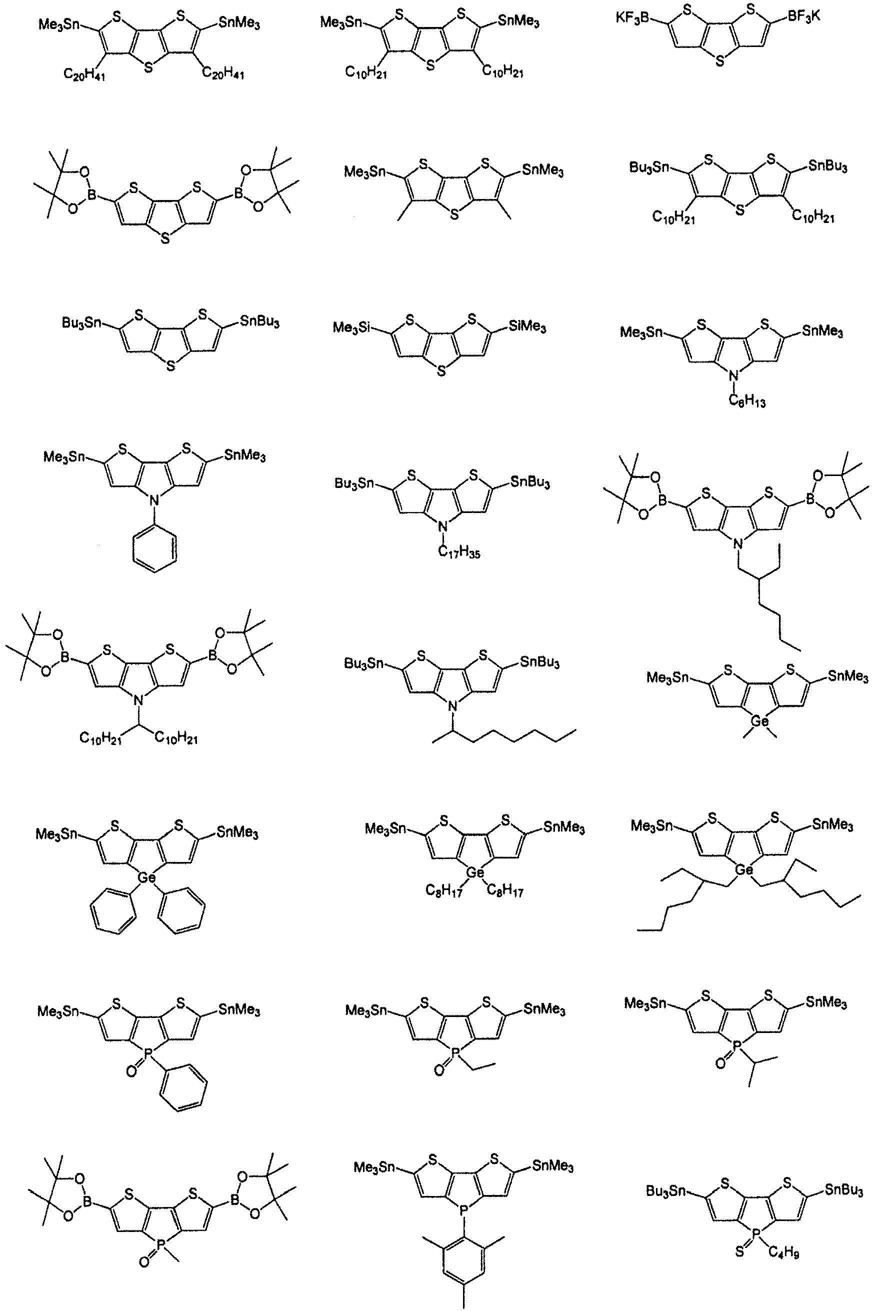

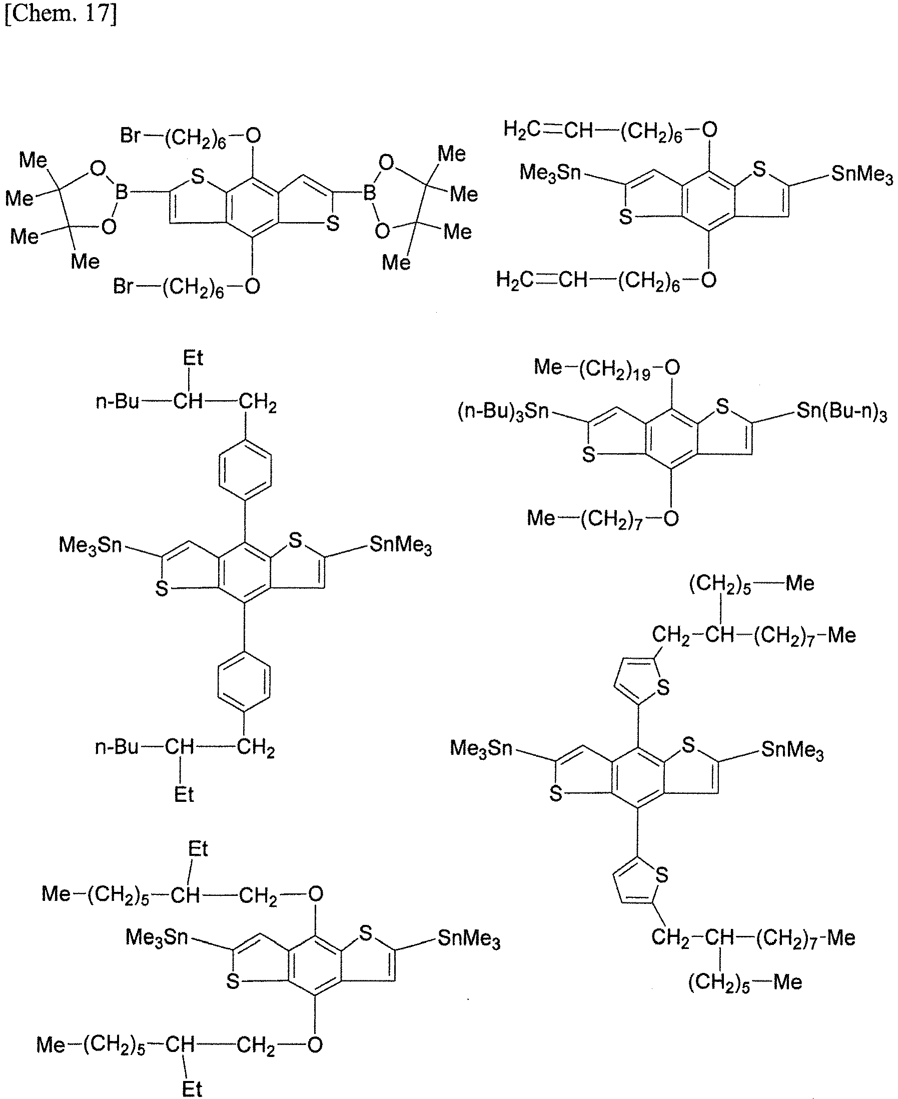

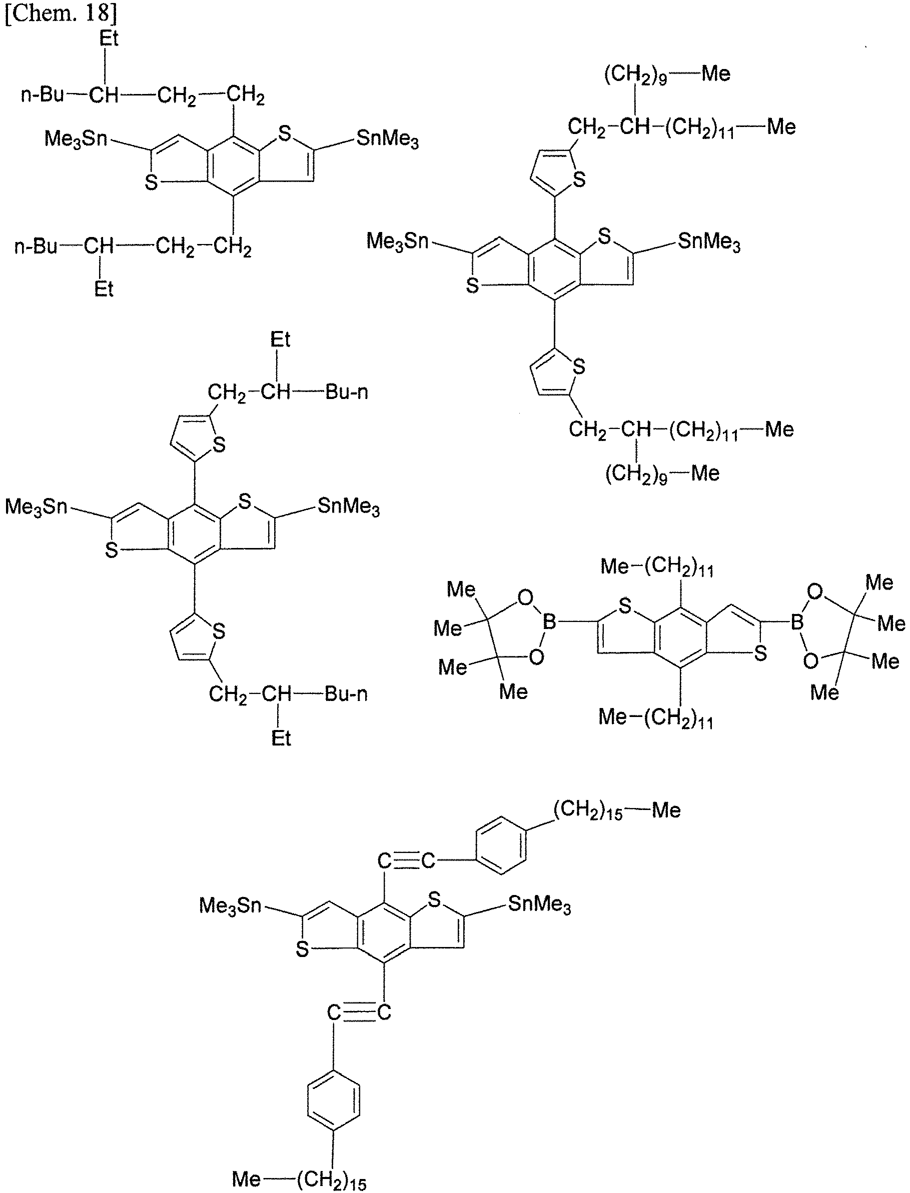

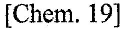

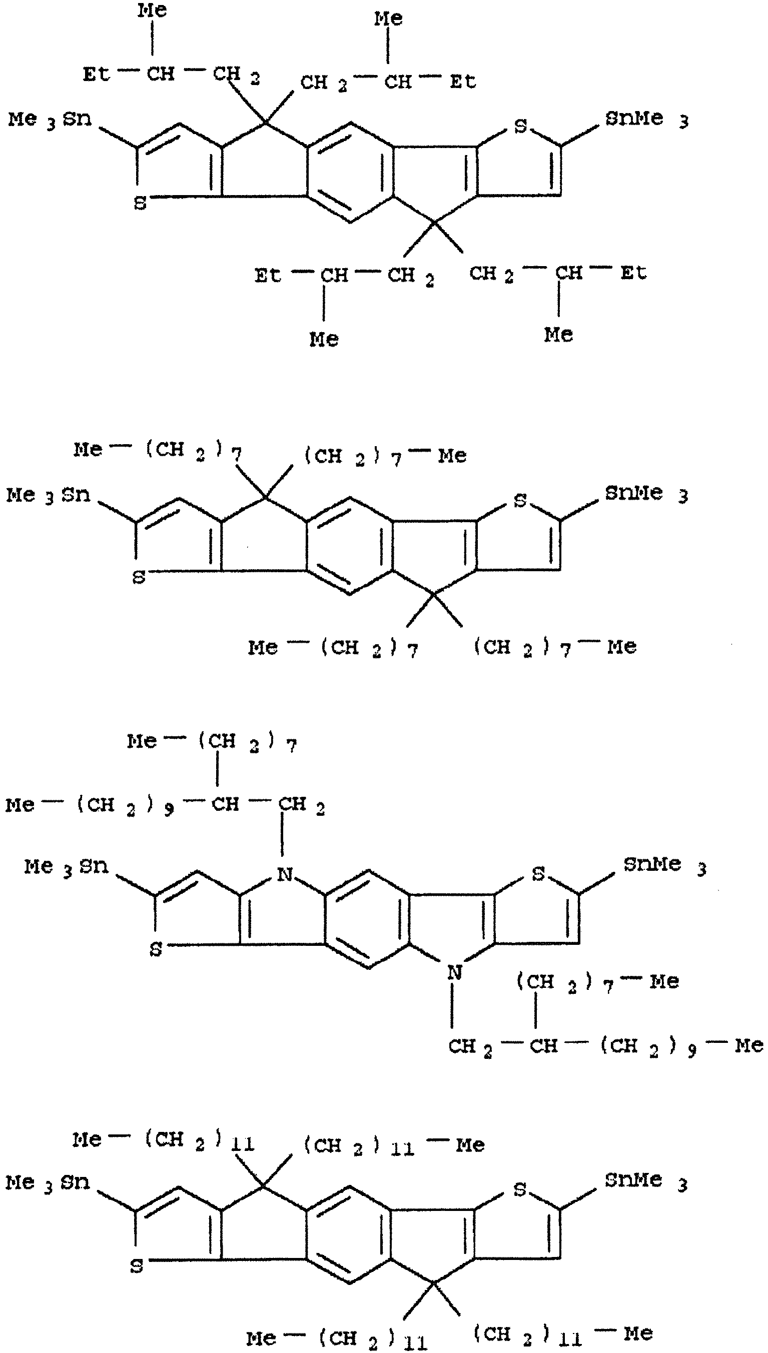

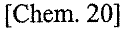

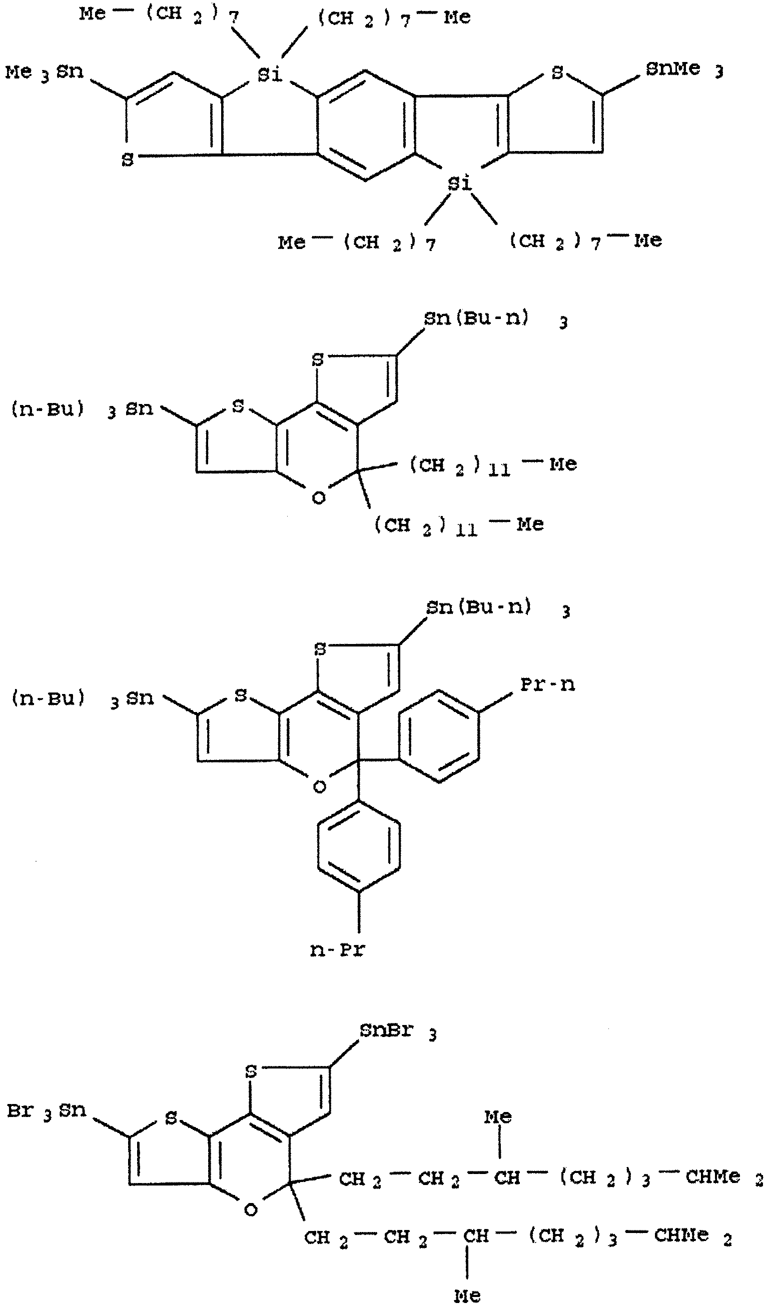

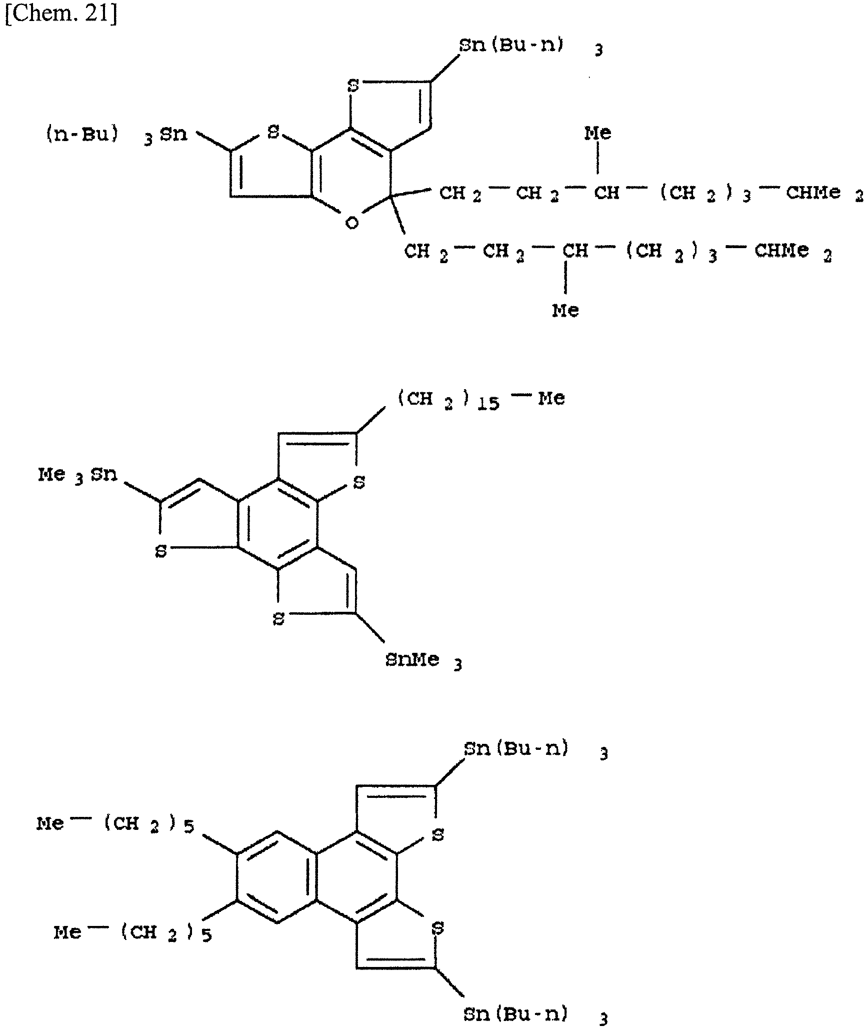

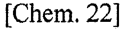

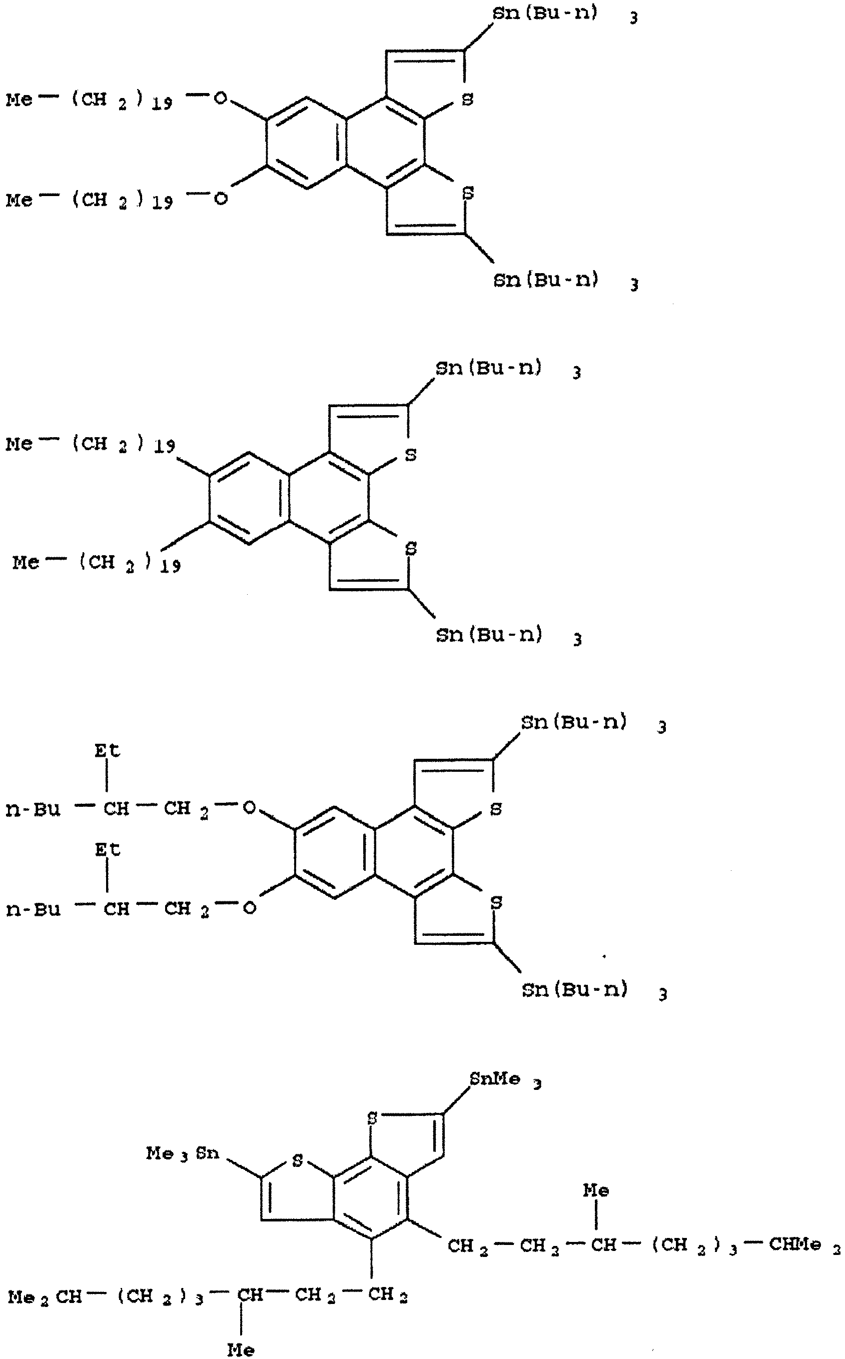

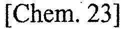

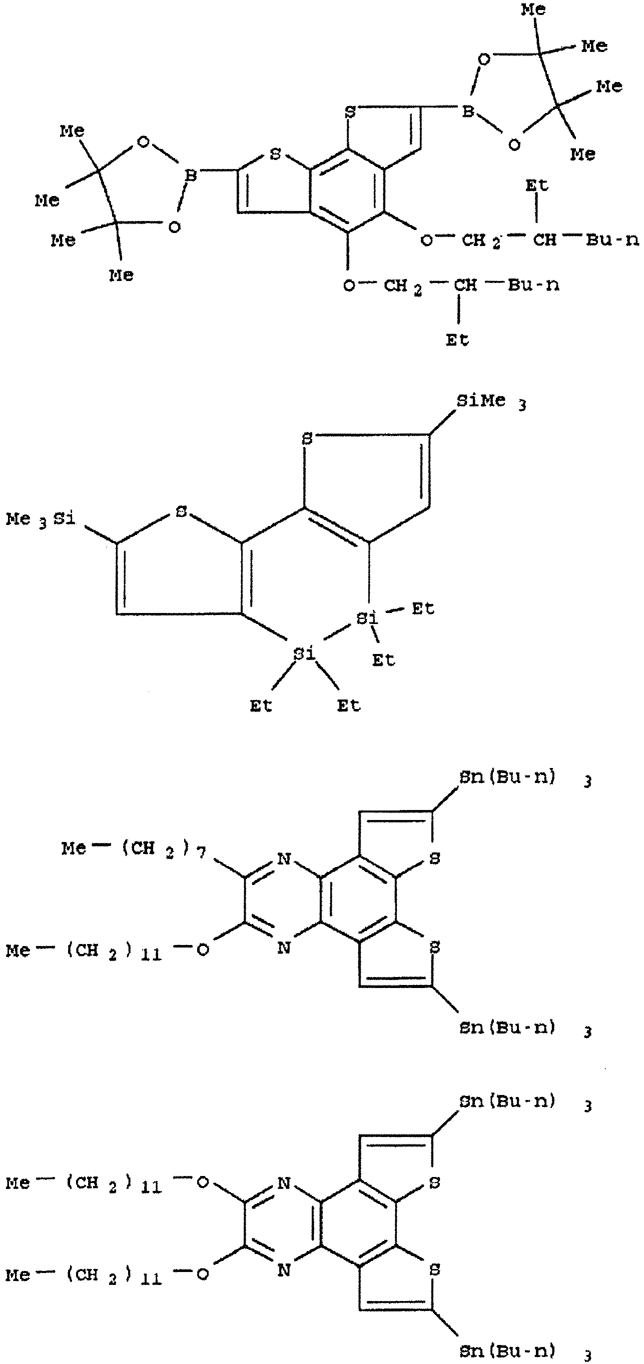

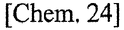

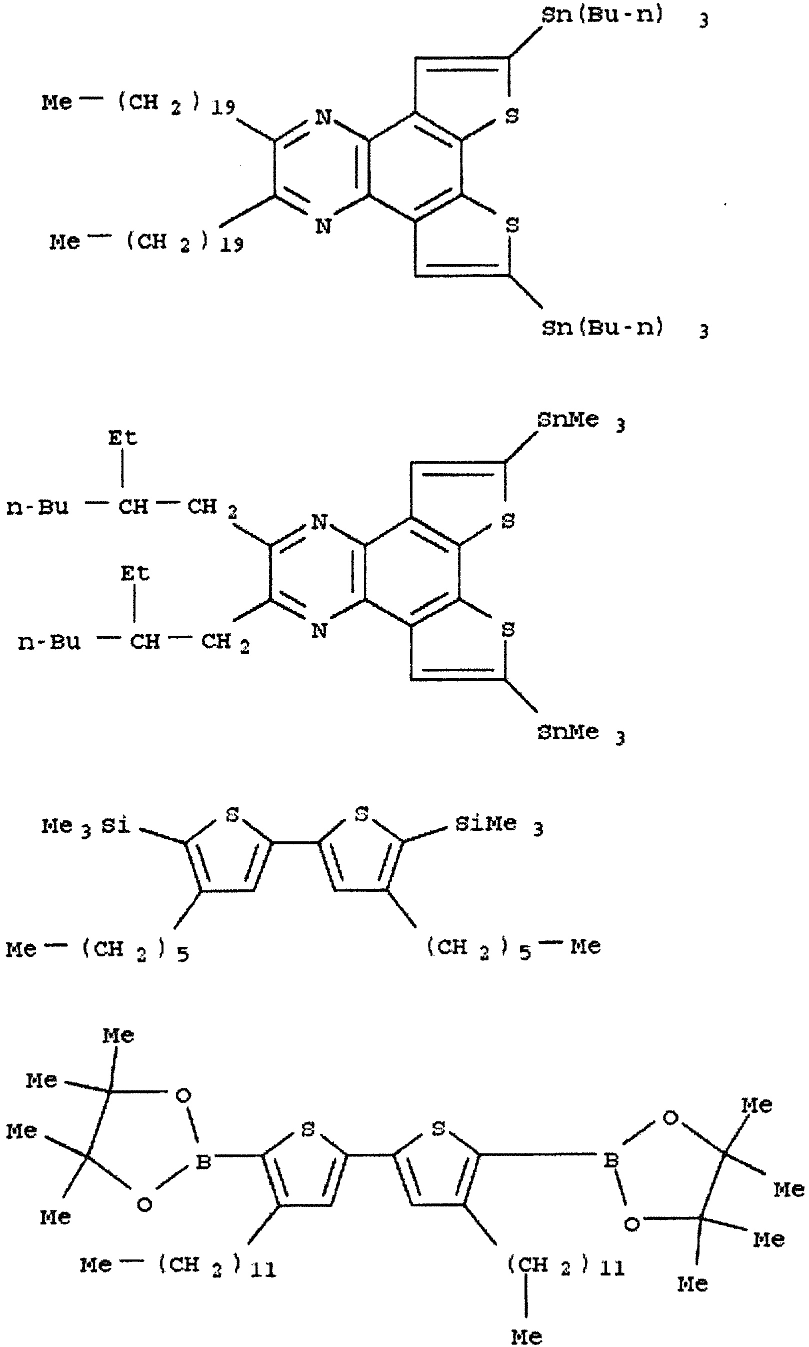

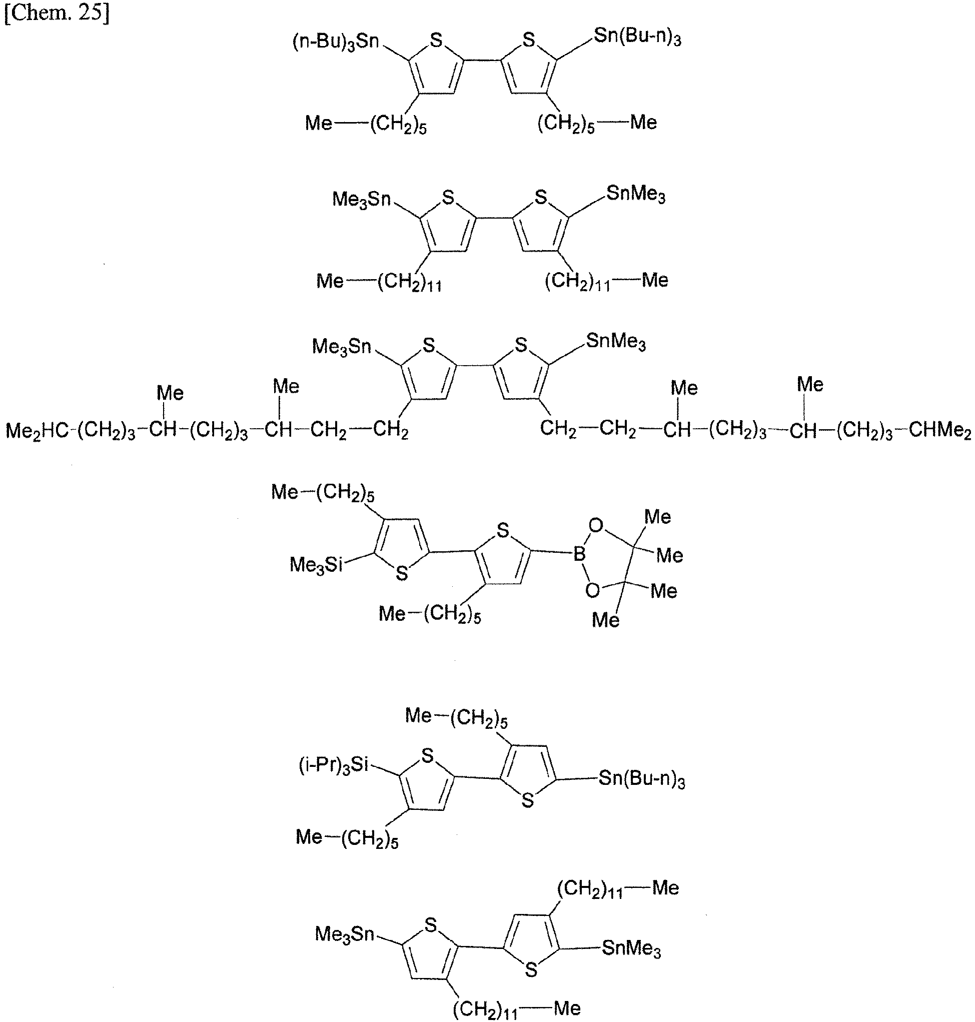

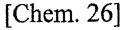

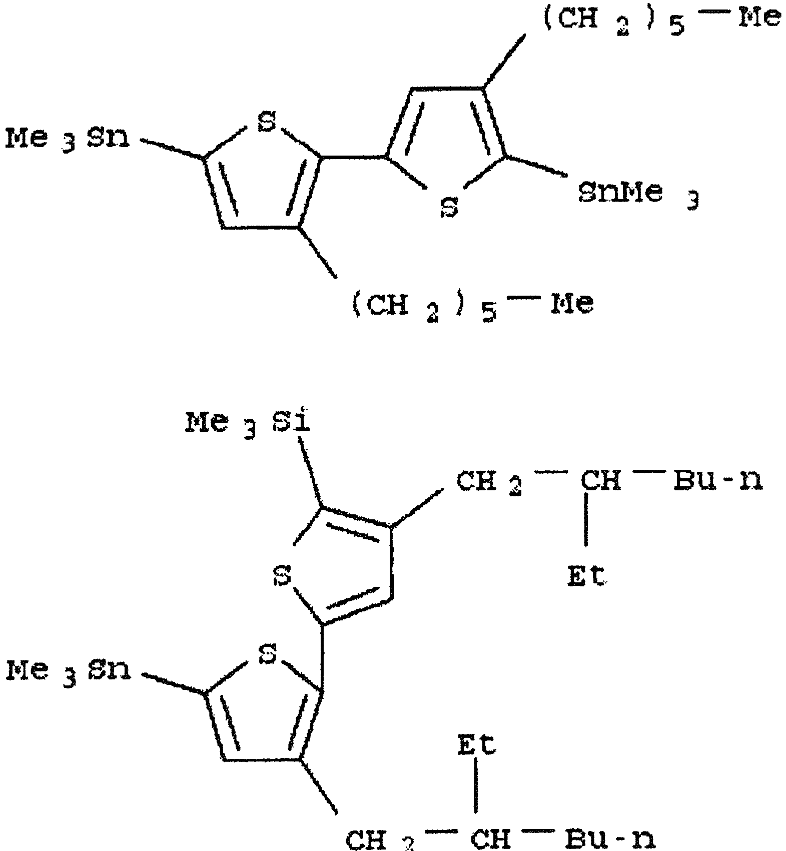

### <Production Method for Monomer in the Invention>

Not specifically defined, the monomer in the invention may be synthesized, for example, with reference to the description in publications (Journal of the American Chemical Society (2009), 131 (22), 7792-7799; Chemical Communications (Cambridge, United Kingdom) (2010), 46 (35), 6503-6505; WO2011/052709).

Above all, it is desirable to produce the compound represented by the formula (I) by generating an anionic species corresponding to the compound represented by the formula (I) by the use of a base such as an organic metal reagent followed by reacting it with an electrophilic reagent corresponding to X¹ or X² in the formula (I), from the viewpoint that the compound represented by the formula (I) can be produced to have a high purity not via any specific purification step for the compound.

### (Base)

The base may be any one capable of generating an anionic species not decomposing the compound, for which, for example, there may be used metal hydrides, metal alkoxides having a bulky substituent, amines, phosphazene bases, metal magnesium reagents having a bulky substituent (Grignard reagents), metal amides, etc. From the viewpoint of preventing nucleophilic attack to the atom Q or to the substituent Z¹ or Z² of the reaction product and of preventing production of any side product, preferred is use of a non-nucleophilic base.

The metal hydrides includes lithium hydride, sodium hydride, potassium hydride, etc.

The metal alkoxide having a bulky substituent includes lithium t-butoxide, sodium t-butoxide, potassium t-butoxide, etc.

The amine includes tertiary amines such as 1,8-diazabicyclo[5.4.0]undec-7-ene (DBU), 1,5-diazabicyclo[4.3.0]non-5-ene (DBN), 1,4-diazabicyclo[2.2.0]octane, etc.

The phosphazene base includes 2-t-butylimino-2-diethylamino-1,3-dimethylperhydro-1,3,2-diazaphospholine, t-butylimino-tris(dimethylamino)phosphorane, 1-t-(dimethylamino)-2λ⁵,4λ⁵-catenadi(phosphazene), 1-t-butyl-4,4,4-tris(dimethylamino)-2,2-bis-[tris(dimethylamino)phosphoranylideneami no]-2λ⁵,4λ⁵-catenadi(phosphazene), etc.

The metal magnesium reagent having a bulky substituent (Grignard reagent) includes 1,1-dimethylpropylmagnesium chloride, sec-butylmagnesium chloride, t-butylmagnesium chloride, isopropylmagnesium chloride, isopropylmagnesium bromide, etc.

The metal halide includes metal amides having a bulky substituent, e.g., dialkylamides such as lithium diisospropylamide (LDA), lithium dicyclohexylamide, magnesium bis(diisopropyl)amide, lithium 2,2,6,6-tetramethylpiperidinyl (LiTMP), 2,2,6,6-tetramethylpiperidinylmagnesium chloride, 2,2,6,6-tetramethylpiperidinylmagnesium magnesium bromide, etc.; silazides such as lithium bis(trimethylsilyl)amide (alias: lithium hexadimethyldisilazide), sodium bis(trimethylsilyl)amide (alias: sodium hexamethyldisilazide), potassium bis(trimethylsilyl)amide (alias: potassium hexamethyldisilazide), magnesium bis(hexamethyldisilazide), etc. For lowering the nucleophilicity of the base, it is desirable to use a metal amide having a bulky substituent; however, in general, a metal amide is poorly nucleophilic, and therefore a non-bulky metal amide such as sodium amide or the like may also be used here.

As the metal alkoxide having a bulky substituent, the metal magnesium reagent having a bulky substituent, and the metal amide having a bulky substituent, for example, there are mentioned a metal alkoxide where the carbon atom to which the oxygen atom bonds is a secondary or tertiary carbon, a metal magnesium reagent where the carbon atom to which magnesium bonds is a secondary or tertiary carbon, and a metal amide to be obtained from a secondary amine, respectively.

Preferably, the value pKa in tetrahydrofuran (THF) of the conjugated acid of the base is 20 or more and 40 or less. The value 20 or more enables rapid deprotonation of the hydrogen atom on the ring A and the ring B. The value 40 or less enables position-selective deprotonation of the hydrogen atom on the ring A and the ring B.

From the viewpoint of low basicity and low nucleophilicity, a metal amide is preferred as the base, and a metal amide having a bulky substituent is more preferred. For example, pKa of lithium diisopropylamide (LPD), a type of metal amide, in THF is 35.7 (see J. Am. Chem. Soc., 1983, 105, 7790-7791).

### (Electrophilic Reagent)

In case where X¹ and X² in the general formula (I) is a stannyl group optionally having a substituent, the electrophilic reagent is not specifically defined, but is, for example, a trialkyltin halide compound. The trialkyltin halide compound includes trimethyltin chloride, trimethyltin bromide, trimethyl tin iodide, triethyltin chloride, triethyltin bromide, triethyltin iodide, tributyltin chloride, tributyltin bromide, tributyltin iodide, tricyclohexyltin chloride, etc.

From the viewpoint of reactivity, preferred is a case where X¹ and X² each are a trimethylstannyl group or a tributylstannyl group. As the electrophilic reagent for introducing a trimethylstannyl group, for example, preferred is use of trimethyltin chloride, trimethyltin bromide or trimethyltin iodide. As the electrophilic reagent for introducing a tributylstannyl group, for example, preferred is use of tributyltin chloride, tributyltin bromide or tributyltin iodide. As the electrophilic reagent, especially preferred is trimethyltin chloride.

In case where X¹ and X² in the general formula (I) is a boryl group optionally having a substituent, the electrophilic reagent is not specifically defined, but, for example, preferred is a boric acid triester. The boric acid triester includes, for example, trimethyl borate, triethyl borate, triisopropyl borate, tributyl borate, tris(hexafluoroisopropyl) borate, tris(trimethylsilyl) borate, 2-methoxy-4,4,6-trimethyl-1,3,2-dioxaborinane, 2-ethoxy-4,4,6-trimethyl-1,3,2-dioxaborinane, 2-isopropoxy-4,4,6-trimethyl-1,3,2-dioxaborinane, 2-methoxy-4,4,5,5-tetramethyl-1,3,2-dioxaborolane, 2-isapropoxy-4,4,5,5-tetramethyl-1,3,2-dioxaborolane, etc. Also usable here is a B-halogenoboric acid ester such as B-chlorocatecholborane and B-bromocatecholborane.

As the electrophilic reagent, preferred is use of trimethyl borate, triisopropyl borate, 2-isopropoxy-4,4,6-trimethyl-1,3,2-dioxaborinane, 2-methoxy-4,4,5,5-tetramethyl-1,3,2-dioxaborolane, or 2-isopropoxy-4,4,5,5-tetramethyl-1,3,2-dioxaborolane; and more preferred is use of 2-isopropoxy-4,4,6-trimethyl-1,3,2-dioxaborinane, 2-methoxy-4,4,5,5-tetramethyl-1,3,2-dioxaborolane, or 2-isopropoxy-4,4,5,5-tetramethyl-1,3,2-dioxaborolane.

The compound having a borate residue that is obtained through reaction with a boric acid triester may be isolated directly as it is, or after the borate residue therein may be hydrolyzed to be a boric acid residue, and the resulting compound may be isolated. In case where the borate residue is converted into a boric acid residue, even though the compound having the boric acid residue is desired to be isolated, the resulting substance tends to be a mixture of the compound having a boric acid residue and a boroxine derivative. When the mixture of the type is used, it is often difficult to control the equivalent ratio in polymerization reaction, and therefore it is more desirable to isolate the compound having a borate residue.

In case where X¹ and X² in the general formula (I) is a silyl group optionally having a substituent, the electrophilic reagent is not specifically defined, but preferably used is 1-chloro-1-methylsilacyclobutane, 1-bromo-1-methylsilacyclobutane, 1,3-dihydro-1,1-dimethyl-2,1-benzoxasilole, 1,3-dihydro-1,1,3,3-tetramethyl-2,1-benzoxasilole, etc.

In case where the condensed polycyclic aromatic compound represented by the formula (I) is produced according to the above-mentioned method, the reaction crude product contains impurities such as the base, the electrophilic reagent as well as metal salts, low-molecular compounds and others to be formed from these in the absence of any purification operation. The production method of the invention is suitable for removing these impurities, and is therefore favorably combined with the production method for the condensed polycyclic aromatic compound represented by the formula (I) mentioned above.

More preferably, the condensed polycyclic aromatic compound represented by the formula (I) may be produced by the use of a condensed polycyclic aromatic compound represented by the following formula (VIII):

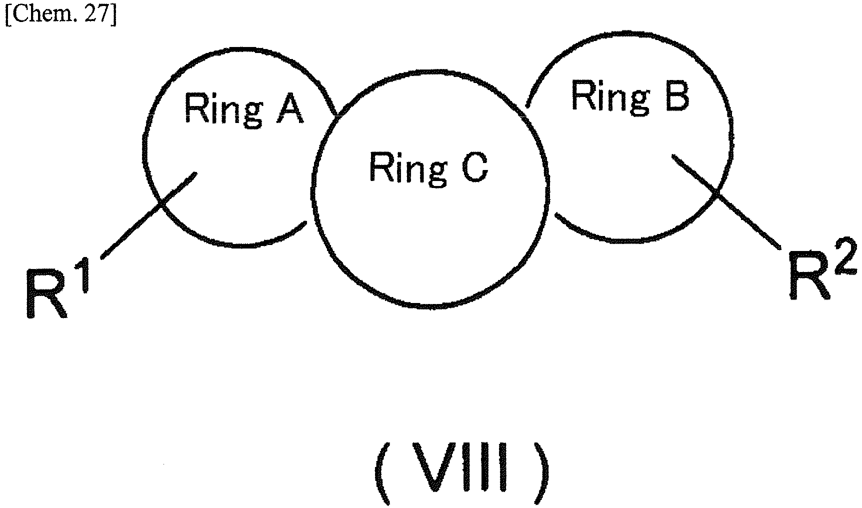

In the formula (VIII), the ring A, the ring B, the ring C, R¹ and R² have the same meanings as in the formula (I).

Concretely, the condensed polycyclic aromatic compound represented by the formula (VIII) is reacted with the above-mentioned base for deprotonation, and the resulting anion species is reacted with the above-mentioned electrophilic agent to give the condensed polycyclic aromatic compound represented by the formula (I).

The reaction of the condensed polycyclic aromatic compound represented by the formula (VIII) with the base and further with the electrophilic reagent is generally carried out in an organic solvent. Not specifically defined, the organic solvent may be any one capable of dissolving a part or all of the condensed polycyclic aromatic compound represented by the formula (II) but not reacting with the base and the electrophilic reagent. Preferred are ether solvents such as tetrahydrofuran (THF), 1,4-dioxane, diethyl ether, etc.; aliphatic hydrocarbon solvents such as hexane, heptane, etc.; aromatic hydrocarbon solvents such as toluene, xylene, etc. Two or more solvents may be used as combined.

The reaction temperature is not specifically defined, but is generally -100°C or higher, preferably -80°C or higher, and is, on the other hand, generally 80°C or lower, preferably 20°C or lower.

The pressure during the reaction is not specifically defined, but is generally atmospheric pressure.

The base, the anion generated through deprotonation of the condensed polycyclic aromatic compound represented by the formula (VIII) by the base, and the electrophilic reagent are often unstable to moisture, and therefore it is desirable that the reaction is carried out in an inert gas atmosphere such as nitrogen, argon, etc.

Regarding the order of putting the base and the electrophilic reagent into the system, any of the two may be put thereinto first so far as the base and the electrophilic reagent do not react with each other. From the viewpoint of evading as much as possible the risk of producing side products, it is desirable to put the base first into the system.

The base and the electrophilic reagent may be added to the reaction liquid all at a time, but may be added thereto a few times as divided in portions. In particular, preferred is a method of adding the base and the electrophilic reagent successively from the viewpoint that a di-active group substitution can be obtained efficiently. Sequential addition means that a series of operations of adding a part of the base followed by adding a part of the electrophilic reagent is repeated multiple times. Such sequential addition is preferred, as enabling difunctionalization with generation of no unstable dianion species and reducing the risk of forming side products. Further, even in a case where a mono-active group substitution is produced as a side product, it may be further reacted with the base for deprotonation and subsequently with the electrophilic reagent, whereby the mono-active group substitution can be converted into a di-active group substitution.

As another method, there may be taken into consideration a method of adding the electrophilic reagent all at a time followed by adding the base sequentially. Without workup operation, the base and the electrophilic agent may be added continuously, or the base and the electrophilic reagent may be added to the crude product obtained after once workup operation. The advantage of the method of once carrying out workup operation and then further adding the base and the electrophilic reagent is that, even after the production of a mono-active group substitution as a side product has been recognized after workup operation, the mono-active group substitution produced as a side product could be converted into a di-active group substitution.

The total amount of the base to be added to the condensed polycyclic aromatic compound represented by the formula (VIII) is not specifically defined, and in general, the amount is 2 equivalents or more relative to the condensed polycyclic aromatic compound represented by the formula (VIII). In this description, "a" equivalent means 100 x a mol%. On the other hand, for reducing the amount of the reagent to be used, the amount of the base is generally 20 equivalents or less, preferably 10 equivalents or less, more preferably 5 equivalents or less.

The total amount of the electrophilic reagent to be added to the condensed polycyclic aromatic compound represented by the formula (VIII) is not specifically defined, and in general, the amount is 2 equivalents or more relative to the condensed polycyclic aromatic compound represented by the formula (II). On the other hand, for reducing the amount of the reagent to be used, the amount of the electrophilic reagent is generally 20 equivalents or less, preferably 10 equivalents or less, more preferably 5 equivalents or less.

<Polymerization Reaction Using the Monomer Obtained according to the Purification Method in the Invention>

The monomer in the invention is useful as the starting material for a polymer, especially for a conjugated polymer. For example, coupling of the condensed polycyclic aromatic compound represented by the formula (I) with a dihalogenated conjugated compound gives a conjugated polymer (hereinafter this may be referred to as the conjugated polymer in the invention). As the dihalogenated conjugated compound, for example, preferably used is a dihalogenated aromatic compound, more preferably a dihalogenated aromatic heterocyclic compound, from the viewpoint of improving the semiconductor characteristics of the conjugated polymer to be obtained. As the halogen group that the dihalogenated conjugated compound has, preferably used is a bromine group, from the viewpoint of improving the reactivity of the compound. As the dihalogenated conjugated compound, there may be mentioned those described in publications (Weinheim, Germany) (2008), 20 (13), 2556-2560; Macromolecules (Washington, DC, United States) (2009), 42 (17), 6564-6571; J. Am. Chem. Soc., 132, 7595-7597 (2010); Advanced Materials (Weinheim, Germany((2003), 15 (12), 988-991;; Macromolecules (2005), 38 (2), 244-253; Macromolecules (Washington, DC, United States) (2008), 41(16), 6012-6018; Advanced Functional Materials (2007), 17 (18), 3836-3842; Chemistry of Materials (2004), 16 (19), 3667-3676; Macromolecules (Washington, DC, United States) (2008), 41 (18),6664-6671; Chemistry--A European Journal (2010), 16 (6), 1911-1928; WO2009/115413; WO2010/136401; Journal of the American Chemical Society (2008), 130 (30), 9679-9694; Journal of the American Chemical Society (2011), 133 (5), 1405-1418).

The coupling reaction may be carried out according to a known method. For example, in case where Z¹ and Z² each are a stannyl group optionally having a substituent, the coupling reaction may be carried out under the condition of known Stille coupling reaction. In case where Z¹ and Z² each are a boryl group optionally having a substituent, the coupling reaction may be carried out under the condition of known Suzuki-Miyaura coupling reaction. Further in case where X¹ and X² each are a silyl group optionally having a substituent, the coupling reaction may be carried out under the condition of known Hiyama coupling reaction. As the coupling reaction, for example, there may be used a combination of a transition metal such as palladium or the like and a ligand (for example, phosphine ligand such as triphenyl phosphine or the like).

The production method for the conjugated polymer in the invention includes a step of polymerizing one or more monomers through coupling reaction, wherein the monomer coupling reaction is preferably carried out by the use of one or more types of homogeneous transition metal complex catalysts and one or more types of heterogeneous transition metal complex catalysts in combination.

In case where a homogeneous transition metal complex catalyst and a heterogeneous transition metal complex catalyst are used in combination, each transition metal catalyst active species may be formed through reaction of a transition metal salt and a ligand, and then put into the coupling reaction system, or the transition metal catalyst active species may be formed through reaction of a transition metal salt and a ligand in the reaction system.

The coupling reaction of monomers using homogeneous and heterogeneous transition metal catalysts in combination provides a conjugated polymer having a higher molecular weight. Using a conjugated polymer having a higher molecular weight provides a photoelectric conversion element excellent in photoelectric conversion efficiency, therefore favorable for use in solar cells and other modules.

As described above, in case where a polymer is synthesized especially using a catalyst such as a transition metal catalyst, low-molecular impurities, metal salts and others may act as catalyst poisons for catalytic reaction. According to the purification method in the invention, the amount of the impurities contained in the monomer in the invention may be reduced. Accordingly, by purifying the monomer in the invention according to the purification method in the invention, it is considered that the above-mentioned polymerization reaction speed may be increased and a polymer having a higher molecular weight may be obtained. To that effect, the purification method in the invention is favorably used in combination with the above-mentioned polymerization reaction.

### <Use>

The conjugated polymer in the invention may be used in organic electronic devices. The type of the organic electronic device is not specifically defined so far as the conjugated polymer in the invention is applicable thereto. Examples of the device include light-emitting elements, switching elements, photoelectric conversion elements, light sensors using photoelectric conductivity, etc.

Regarding the configuration of the organic electronic devices and the production method for them, employable here is any known technique, and concretely, those described in publications such as Solar Energy Materials & Solar Cells, 96 (2012), 155-159, WO2011/016430, JP-A 2012-191194 and others can be employed here.

### Examples

Embodiments of the invention are described with reference to Examples given below. However, not overstepping the scope and the spirit thereof, the invention is not limited to these Examples. The items described in the Examples were determined according to the methods mentioned below.

### [Measurement of Weight-Average Molecular Weight (Mw), and Molecular Weight Distribution (PDI)]

The weight-average molecular weight (Mw) and the molecular weight distribution (PDI) of copolymer were determined through gel permeation chromatography (GPC). Concretely, columns of Shim-pac GPC-803 and GPC-804 (by Shimadzu, inner diameter 8.0 mm, length 30 cm) of each one are connected in series, and a pump of LC-10AT, an oven of CTO-10A, and detectors of a differential refractometer (Shimadzu's RID-10A) and a UV-vis detector (Shimadzu's SPD-10A) were used. For the measurement, the conjugated polymer to be analyzed was dissolved in chloroform, and 5 µL of the resulting solution was injected into the columns. Chloroform was used as the mobile phase, and the sample was analyzed at a flow rate of 1.0 mL/min. For the analysis, used was LC-Solution (by Shimadzu).

### [Proton NMR Measurement]

An NMR apparatus (name of apparatus: Bruker's 400 MHz) was used for proton NMR. Concretely, heavy chloroform was used as the deuterated solvent, and tetramethylsilane was used as the internal standard to provide the chemical shift. The chemical shift of the aromatic moiety unsubstituted, or mono-substituted or di-substituted with an active group (trimethylstannyl group) was identified through proton NMR, and the ratio of the above compounds was identified from the integral values of the peaks.

### <Synthesis Example 1>

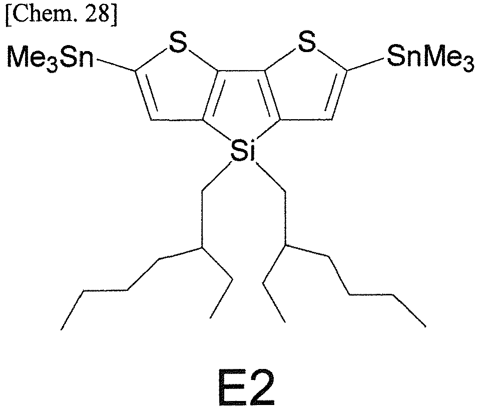

The compound E2 was synthesized with reference to the method described in a publication (Journal of the American Chemical Society, Vol. 130, pp. 16144-16145 (2008)). Concretely, the compound was synthesized as follows:

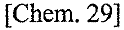

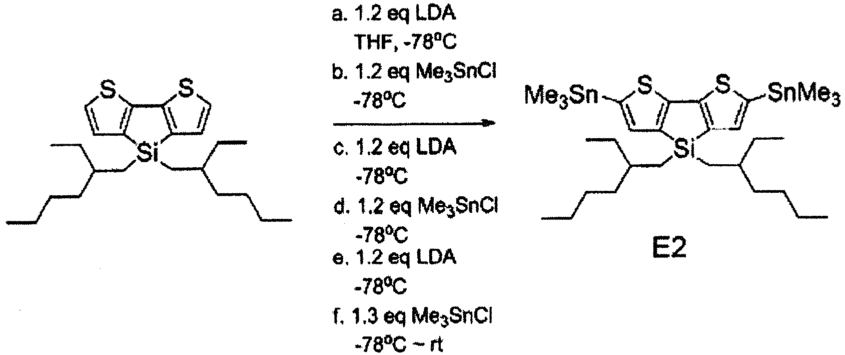

In a 100-mL two-neck flask in a nitrogen atmosphere, 4,4-bis(2-ethylhexyl)-dithieno[3,2-b:2',3'-d]silole (1 g, 2.39 mmol) was dissolved in tetrahydrofuran (THF, 25 mL), and cooled to -78°C. Further, a tetrahydrofuran/hexane solution of lithium diisopropylamide (LDA) (by Kanto Chemical, concentration 1.11 M, 2.6 mL, 1.2 eq) was dropwise added thereto and stirred for 40 minutes.

Further, a tetrahydrofuran solution of trimethyltin chloride (by Aldrich, 1.0 M, 2.9 mL, 1.2 eq) was dropwise added thereto, and stirred for 40 minutes. Further, a tetrahydrofuran/hexane solution of lithium diisopropylamide (LDA) (by Kanto Chemical, concentration 1.11 M, 2.6 mL, 1.2 eq) was dropwise added thereto, and stirred for 40 minutes. Further, a tetrahydrofuran solution of trimethyltin chloride (by Aldrich, 1.0 M, 2.9 mL, 1.2 eq) was dropwise added thereto, and stirred for 40 minutes.

Further, a tetrahydrofuran/hexane solution of lithium diisopropylamide (LDA) (by Kanto Chemical, concentration 1.11 M, 2.6 mL, 1.2 eq) was dropwise added thereto and stirred for 40 minutes. Further, a tetrahydrofuran solution of trimethyltin chloride (by Aldrich, 1.0 M, 3.1 mL, 1.3 eq) was dropwise added, and then gradually heated up to room temperature.

Water was added to the reaction liquid, the product was extracted with hexane, and the organic layer was washed with water. The organic layer was dried on sodium sulfate, filtered, concentrated under reduced pressure and dried in vacuum to give 4,4-bis(2-ethylhexyl)-2,6-bis(trimethylstannyl)-dithieno[3,2-b:2',3'-d]silole (compound E2) as a yellow-green oil. The presence of a mono-substituted form derived from the compound E2 by removing one trimethylstannyl group therefrom (compound S1: Ar(1)) and an unsubstituted form derived from the compound E2 by removing two trimethylstannyl groups therefrom (compound S2: Ar(0)) was not confirmed.
Compound E2: ¹H-NMR (400 MHz, solvent: heavy chloroform): δ 7.07 (s, 2H), 1.45-1.37 (m, 2H), 1.32-1.08 (m, 16H), 0.99-0.80 (m, 10H), 0.77 (t, 6H, J = 7.3 Hz), 0.36 (s, 18H).

### <Synthesis Example 2>

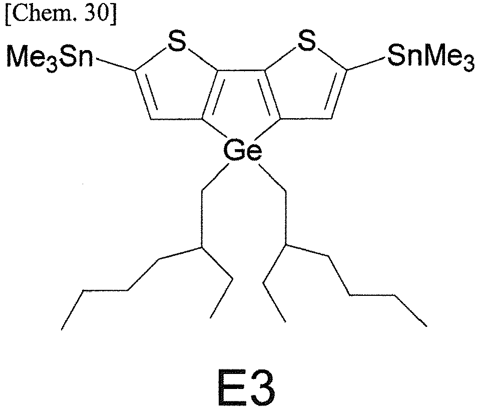

The compound E3 was synthesized with reference to the method described in a publication (Macromolecules, Vol. 44, pp. 7188-7193 (2011)). Concretely, the compound was synthesized as follows:

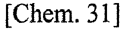

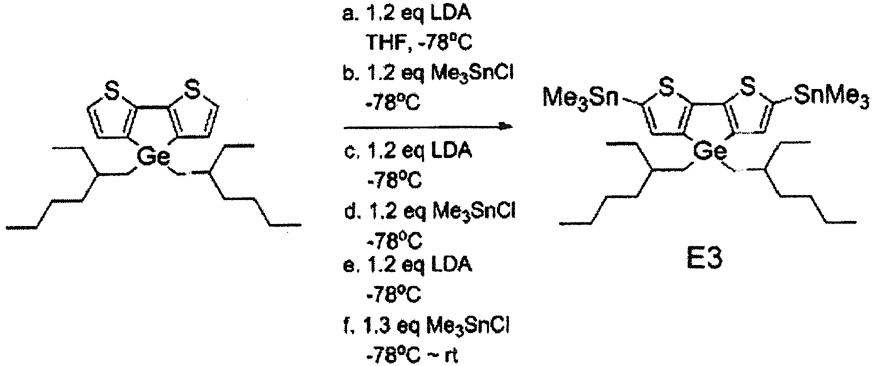

The compound E3 was obtained in the same manner as in Synthesis Example 1 except that 4,4-bis(2-ethylhexyl)-dithieno[3,2-b:2',3'-d]germole was used in place of 4,4-bis(2-ethylhexyl)-dithieno[3,2-b:2',3'-d]silole as the starting material. The presence of a mono-substituted form derived from the compound E3 by removing one trimethylstannyl group therefrom (Ar(1)) and an unsubstituted form derived from the compound E3 by removing two trimethylstannyl groups therefrom (Ar(0)) was not confirmed.

### <Synthesis Example 3>

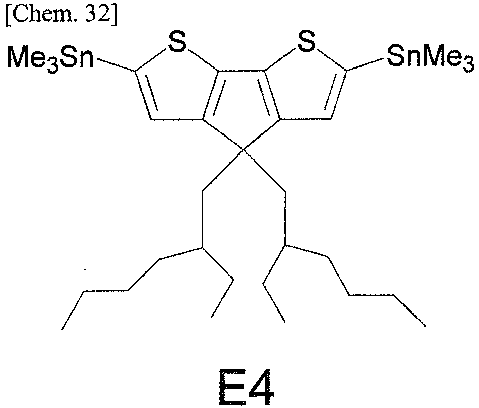

The compound E4 was synthesized with reference to the method described in a publication (Journal of Materials Chemistry, Vol. 21, pp. 3895-3902 (2011)). Concretely, the compound was synthesized as follows:

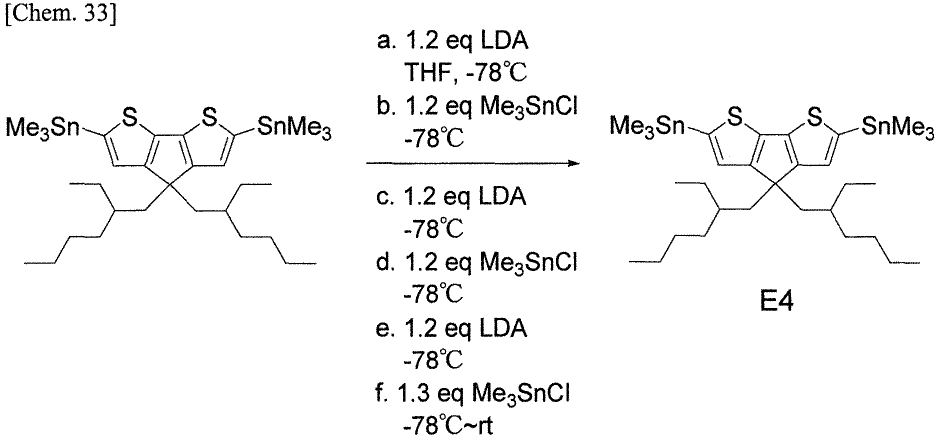

The compound E4 was obtained in the same manner as in Synthesis Example 1 except that 4,4-bis(2-ethylhexyl)-cyclopenta[2,1-b:3,4-b']dithiophene was used in place of 4,4-bis(2-ethylhexyl)-dithieno[3,2-b:2',3'-d]silole as the starting material.

The presence of a mono-substituted form derived from the compound E4 by removing one trimethylstannyl group therefrom (Ar(1)) and an unsubstituted form derived from the compound E4 by removing two trimethylstannyl groups therefrom (Ar(0)) was not confirmed.

### <Synthesis Example 4>

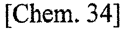

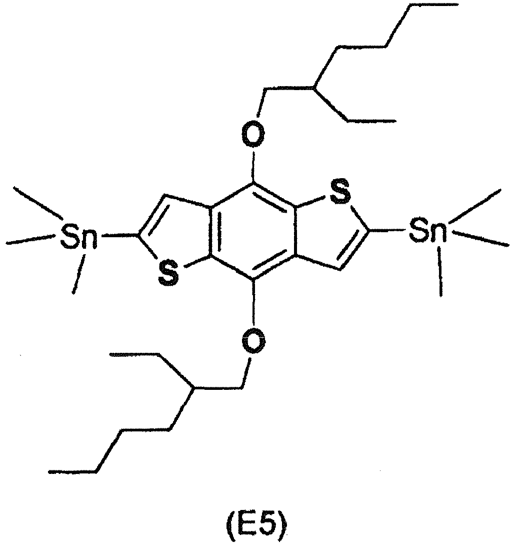

1,1'-(4,8-Bis((2-ethylhexyl)oxy)benzo(1,2-b:4,5-b')dithiophene-2,6-diyl)bis(1,1 ,1-trimethylstannyl) (compound E5) was synthesized in the same manner as in Synthesis Example 2, except that 4,8-bis((2-ethylhexyl)oxy)benzo(1,2-b:4,5-b')dithiophene that had been synthesized with reference to the method described in a publication (Macromolecules, Vol. 45, pp. 3732-3739 (2012)) was used in place of 4,4-bis(2-ethylhexyl)-dithieno[3,2-b:2',3'-d]silole as the starting material in Synthesis Example 2.

### <Synthesis Example 5>

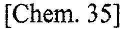

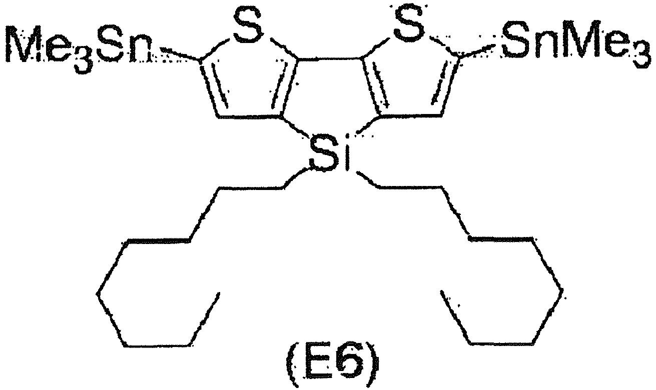

4,4-Di-n-octyl-2,6-bis(trimethylstannyl)-dithieno[3,2-b:2',3'-d]silole (compound E6) was obtained in the same manner as in Synthesis Example 2 except that 4,4-bis(n-octyl)-dithieno[3,2-b:2',3'-d]silole was used in place of 4,4-bis(2-ethylhexyl)-dithieno[3,2-b:2',3'-d]silole as the starting material in Synthesis Example 2. The compound E6 was obtained quantitatively.

### <Synthesis Example 6>

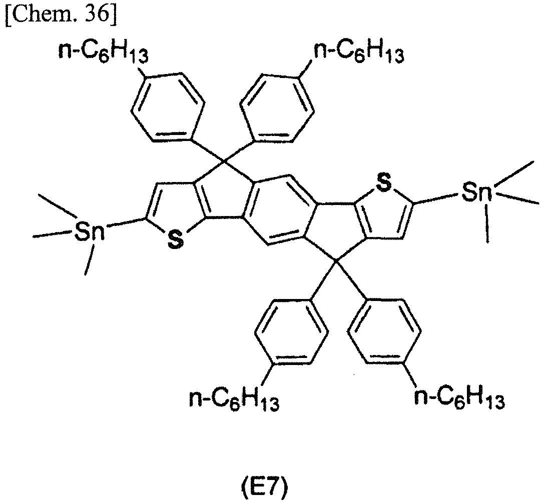

1,1'-[4,4,9,9-Tetrakis(4-hexylphenyl)-4,9-dihydro-s-indaceno[1,2-b:5,6-b']dithi ophene-2,7-diyl]bis[1,1,1-trimehtylstannyl] (compound E7) was obtained in the same manner as in Synthesis Example 2 except that 4,4,9,9-tetrakis(4-hexylphenyl)-4,9-dihydro-s-indaceno[1,2-b:5,6-b']dithiophene that had been synthesized with reference to the method described in a publication (Chemistry of Materials(2011) 2289-2291) was used in place of 4,4-bis(2-ethylhexyl)-dithieno[3,2-b:2',3'-d]silole as the starting material in Synthesis Example 2.

### <Synthesis Example 7>

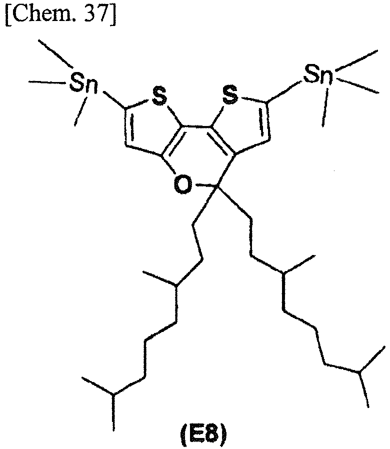

1,1'-[5,5-Bis(3,7-dimethyloctyl)-5H-dithieno[3,2-b:2',3'-d]pyran-2,7-diyl]bis[1, 1,1-trimethylstannyl] (compound E8) was obtained in the same manner as in Synthesis Example 2 except that 5,5-bis(3,7-dimethyloctyl)-5H-dithieno[3,2-b:2',3'-d]pyran that had been synthesized with reference to the method described in a publication (WO2012/050070) was used in place of 4,4-bis(2-ethylhexyl)-dithieno[3,2-b:2',3'-d]silole as the starting material in Synthesis Example 2.

### <Synthesis Example 8>

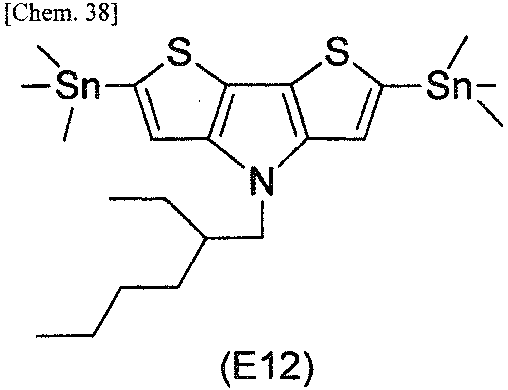

4-(2-Ethylhexyl)-2,6-bis(trimethylstannyl)-4H-dithieno[3,2-b:2',3'-d]pyrrole (compound E12) was obtained in the same manner as in Synthesis Example 2 except that 4-(2-ethylhexyl)-4H-dithieno[3,2-b:2',3'-d]pyrrole that had been synthesized with reference to the method described in a publication (Journal of Polymer Science, Part A: Polymer Chemistry (2011), 49, 1453-1461) was used in place of 4,4-bis(2-ethylhexyl)-dithieno[3,2-b:2',3'-d]silole as the starting material in Synthesis Example 2.

### <Synthesis Example 9>

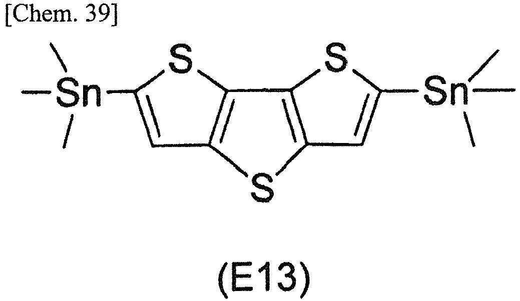

A Tokyo Chemical's product 1,1'-dithieno[3,2-b:2',3-d]thiophene was used and stannylated as in Synthesis Example 1, and 1,1'-dithieno[3,2-b:2',3'-d]thiophene-2,6-diiyl]bis[1,1,1-trimethylstannyl] (compound E13) was obtained in the same manner as in Synthesis Example 2 except that 1,1'-dithieno[3,2-b:2',3'-d]thiophene (by Tokyo Chemical) was used in place of 4,4-bis(2-ethylhexyl)-dithieno[3,2-b:2',3'-d]silole as the starting material in Synthesis Example 2.

### <Synthesis Example 10>

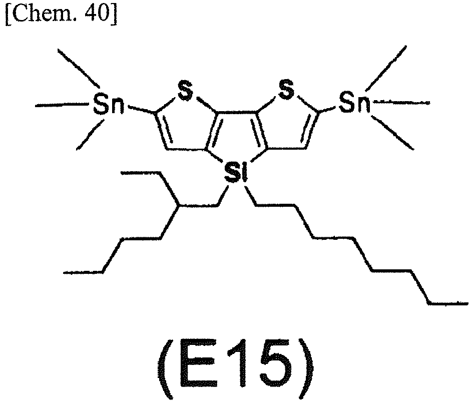

4,4-n-octyl-2-ethylhexyl-2,6-bis(trimethylstannyl)-dithieno[3,2-b:2',3'-d]silol (compound E15) was obtained in the same manner as in Synthesis Example 2 except that 4,4-n-octyl-2-ethylhexyl-dithieno[3,2-b:2',3'-d]silol was used in place of 4,4-bis(2-ethylhexyl)-dithieno[3,2-b:2',3'-d]silole as the starting material in Synthesis Example 2. The compound E15 was obtained quantitatively.

### <Comparative Example A1>

Silica gel (Kanto Chemical's product name, Silica Gel 60N, spherical neutral, for column chromatography (particle size 63 to 210 µm, pH 7.0 ± 0.5), 20 g) and anhydrous potassium carbonate (Aldrich's Catalog No. 347825, powder, 2.0 g) were suspended in hexane (50 mL), and charged in a column (inner diameter 15 mm, length 5 cm). (Hereinafter the column material is referred to as silica gel/potassium carbonate.) The compound E2 (1.0 g) obtained in Synthesis Example 1 was dissolved in hexane (5.0 mL), and charged in the column. Using hexane as a developing solvent, the solution having passed through the column was collected. The solvent was evaporated away from the solution under reduced pressure to give an oily compound (0.96 g, yield 96%).

The obtained compound was analyzed through the above-mentioned proton NMR, in which neither the di-substituted form (compound E2: Ar(2)) nor the mono-substituted form (compound S1: Ar(1)) derived from the compound E2 by removing one trimethylstannyl group therefrom was present but only the unsubstituted form (compound S2: Ar(0)) derived from the compound E2 by removing two trimethylstannyl groups therefrom was present.

The proportion (by mol) of the mono-substituted form (Ar(1)) and the unsubstituted form (Ar(0)) in the compound after charging in the column was 100%, and the recovery efficiency of the di-substituted form was 0%. The recovery efficiency (%) of the di-substituted form means di-substituted form (g) in the compound after charging in the column/di-substituted form (g) before charging in the column × 100.

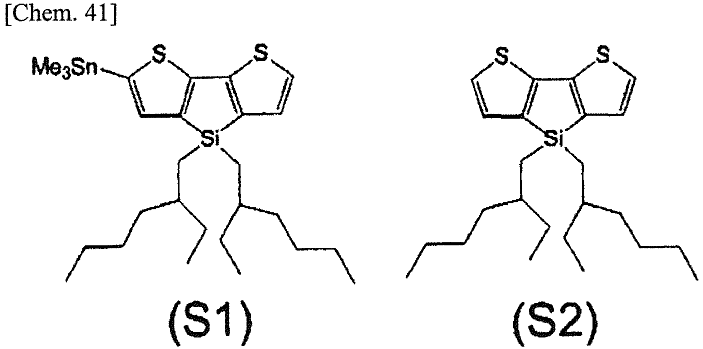

### <Comparative Example A2>

This is the same as in Comparative Example 1, except that in the process of Comparative Example A1, silica gel (Kanto Chemical's product name, Silica Gel 60N, spherical neutral, for column chromatography (particle size 63 to 210 µm, pH 7.0 ± 0.5), 20 g) was used as the column material in place of silica gel/potassium carbonate, and that hexane containing 10% by weight of triethylamine was used as the developing solvent. As a result of the treatment here, an oily compound (0.94 g, yield 94%) was obtained. The obtained compound was analyzed through proton NMR, which was confirmed as a mixture of the compound E2 (di-substituted form (Ar(2)) and the compound S1 (mono-substituted form (Ar(1)) derived from the compound E2 by removing one trimethylstannyl group therefrom. The ratio of the compound E2 to the compound S 1 was 1/3 as the integration ratio of the chemical shift.

In the compound after charging in the column, the ratio (by mol) of the mono-substituted form (Ar(1)) to the unsubstituted form (Ar(0)) was 75%, and the recovery efficiency of the di-substituted form was 24%.

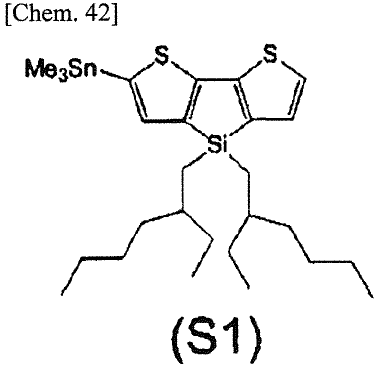

### <Comparative Example A3>

This is the same as in Comparative Example 1, except that in the process of Comparative Example A1, amine silica gel (Kanto Chemical's product name, Silica Gel 60 (spherical) NH₂, 40 to 50 µm, 30 g) was used as the column material in place of silica gel/potassium carbonate. As a result of the treatment here, an oily compound (0.95 g, yield 95%) was obtained. The obtained compound was analyzed through proton NMR, which was confirmed as a mixture of the compound E2 (di-substituted form (Ar(2)), the compound S1 (mono-substituted form (Ar(1)) and the compound S2 (unsubstituted form (Ar(0)). The proportion of E2, the compound S1 and the compound S2 was 1/3/7 as the integration ratio of the chemical shift.

In the compound after charging in the column, the ratio (by mol) of the mono-substituted form (Ar(1)) to the unsubstituted form (Ar(0)) was 90%, and the recovery efficiency of the di-substituted form was 9%.

### <Comparative Example A4>

This is the same as in Comparative Example 1, except that in the process of Comparative Example A1, neutral alumina (Merck's product name, Aluminium Oxide, Neutral, Activity 1, 1078-3, 30 g) was used as the column material in place of silica gel/potassium carbonate. As a result of the treatment here, an oily compound (0.97 g, yield 97%) was obtained. The obtained compound was analyzed through proton NMR, which was confirmed as the compound S2 alone obtained through destannylation. Neither the compound E2 (di-substituted form Ar(2)) nor the compound S1 (mono-substituted form Ar(1)) was present.

The proportion (by mol) of the mono-substituted form (Ar(1)) and the unsubstituted form (Ar(0)) in the compound after charging in the column was 100%, and the recovery efficiency of the di-substituted form was 0%.

### <Comparative Example A5>

This is the same as in Comparative Example 1, except that in the process of Comparative Example A1, basic alumina (Merck's product name, Aluminium Oxide, Basic, Activity 1, 1077-2, 30 g) was used as the column material in place of silica gel/potassium carbonate. As a result of the treatment here, an oily compound (0.64 g, yield 64%) was obtained. The recovery yield indicates that the compound E2 (di-substituted form (Ar(2)) was adsorbed by the basic alumina. The obtained compound was analyzed through proton NMR, which was confirmed as the compound S2 alone obtained through destannylation. Neither the compound E2 (di-substituted form Ar(2)) nor the compound S1 (mono-substituted form Ar(1)) was present.

The proportion (by mol) of the mono-substituted form (Ar(1)) and the unsubstituted form (Ar(0)) in the compound after charging in the column was 100%, and the recovery efficiency of the di-substituted form was 0%.

### <Comparative Example A6>

This is the same as in Comparative Example 1, except that in the process of Comparative Example A1, activated charcoal (acidic) (Wako Pure Chemicals' product name, Charcoal, Activated, Powder, Acid Washed, 031-18083, 30 g) was used as the column material in place of silica gel/potassium carbonate. As a result of the treatment here, an oily compound (0.94 g, yield 94%) was obtained. The obtained compound was analyzed through proton NMR, which was confirmed as a 1/4 mixture of the compound S1 (mono-substituted form (Ar(1)) and the compound E2 (di-substituted form (Ar(2)).

The proportion (by mol) of the mono-substituted form (Ar(1)) and the unsubstituted form (Ar(0)) in the compound after charging in the column was 20%, and the recovery efficiency of the di-substituted form was 75%.

### <Comparative Example A7>

This is the same as in Comparative Example 1, except that in the process of Comparative Example A1, activated charcoal (basic) (Wako Pure Chemicals' product name, Charcoal, Activated, Powder, Basic, 031-18093, 30 g) was used as the column material in place of silica gel/potassium carbonate.

As a result of the treatment here, an oily compound (0.94 g, yield 94%) was obtained. The obtained compound was analyzed through proton NMR, which was confirmed as a 1/5 mixture of the compound S1 and the compound E2 (di-substituted form (Ar(2)).

The proportion (by mol) of the mono-substituted form (Ar(1)) and the unsubstituted form (Ar(0)) in the compound after charging in the column was 17%, and the recovery efficiency of the di-substituted form was 78%.

### <Comparative Example A8>

This is the same as in Comparative Example 1, except that in the process of Comparative Example A1, celite (Wako Pure Chemicals' product name, No. 545, 20 g) was used as the column material in place of silica gel/potassium carbonate. As a result of the treatment here, an oily compound (2.9 g, yield 99%) was obtained. The obtained compound was analyzed through proton NMR, which was confirmed as the compound E2 (di-substituted form) and in which neither the mono-substituted form (Ar(1)) nor the unsubstituted form (Ar(0)) was detected. The obtained compound was stored at -20°C, and after 4 days, a visible precipitate was formed. This indicates that, even though the composition of the invention is brought into contact with celite, the impurities could not be removed.

The proportion (by mol) of the mono-substituted form (Ar(1)) and the unsubstituted form (Ar(0)) in the compound after charging in the column was 0%, and the recovery efficiency of the di-substituted form was 98%.

### <Comparative Example A9>

This is the same as in Comparative Example 1, except that in the process of Comparative Example A1, the compound E5 obtained in Synthesis Example 4 was used in place of the compound E2 obtained in Synthesis Example 1. As a result of the treatment here, an oily compound (yield 98%) was obtained.

The obtained compound was analyzed through proton NMR, which was a mixture (2/3) of the mono-substituted form (Ar(1)) and the unsubstituted form (Ar(0)) but in which the di-substituted form (Ar(2) was not present.

Before charging in the column, the proportion (by mol) of the mono-trimethylstannyl substitution and the unsubstituted form relative to the compound E5 (di-trimethylstannyl substitution (Ar(2)) was 98%.

After charging in the column, the proportion (by mol) of the mono-substituted form (Ar(1)) and the unsubstituted form (Ar(0)) in the compound was 100%, and the recovery efficiency of the di-substituted form was 0%.

### <Comparative Example A10>

This is the same as in Comparative Example 1, except that in the process of Comparative Example A1, the compound E7 obtained in Synthesis Example 6 was used in place of the compound E2 obtained in Synthesis Example 1. As a result of the treatment here, an oily compound (yield 98%) was obtained.

The obtained compound was analyzed through proton NMR, which was a mixture (1/4) of the mono-substituted form (Ar(1)) and the unsubstituted form (Ar(0)) but in which the di-substituted form (Ar(2) was not present. Before charging in the column, the proportion (by mol) of the mono-trimethylstannyl substitution and the unsubstituted form relative to the compound E7 (di-trimethylstannyl substitution) was 98%.

After charging in the column, the proportion (by mol) of the mono-substituted form (Ar(1)) and the unsubstituted form (Ar(0)) in the compound was 100%, and the recovery efficiency of the di-substituted form was 0%.

### <Comparative Example A11>

This is the same as in Comparative Example 1, except that in the process of Comparative Example A1, the compound E8 obtained in Synthesis Example 7 was used in place of the compound E2 obtained in Synthesis Example 1. As a result of the treatment here, an oily compound (yield 98%) was obtained.

The obtained compound was analyzed through proton NMR, which was a mixture (2/1) of the mono-substituted form (Ar(1) and the unsubstituted form (Ar(0)) but in which the di-substituted form (Ar(2) was not present. Before charging in the column, the proportion (by mol) of the mono-trimethylstannyl substitution and the unsubstituted form relative to the compound E8 (di-trimethylstannyl substitution) was 98%.

After charging in the column, the proportion (by mol) of the mono-substituted form (Ar(1)) and the unsubstituted form (Ar(0)) in the compound was 100%, and the recovery efficiency of the di-substituted form was 0%.

### <Comparative Example A12>

This is the same as in Comparative Example 1, except that in the process of Comparative Example A1, the compound E12 obtained in Synthesis Example 8 was used in place of the compound E2 obtained in Synthesis Example 1. As a result of the treatment here, an oily compound (yield 98%) was obtained. The obtained compound was analyzed through proton NMR, which was a mixture (1/5) of the mono-substituted form (Ar(1)) and the unsubstituted form (Ar(0)) but in which the di-substituted form (Ar(2) was not present.

Before charging in the column, the proportion (by mol) of the mono-trimethylstannyl substitution and the unsubstituted form relative to the compound E12 (di-trimethylstannyl substitution) was 98%.

After charging in the column, the proportion (by mol) of the mono-substituted form (Ar(1)) and the unsubstituted form (Ar(0)) in the compound was 100%, and the recovery efficiency of the di-substituted form was 0%.

### <Example A1>

This is the same as in Comparative Example 1, except that in the process of Comparative Example A1, Zeolite A-3 (Wako Pure Chemicals' product name, Zeolite, Synthetic, A-3, Powder, through 75 µm, 30 g) was used as the column material in place of silica gel/potassium carbonate. As a result of the treatment here, an oily compound (0.97 g, yield 97%) was obtained.

The obtained compound was analyzed through proton NMR, which was confirmed as the compound E2 and in which neither the compound S1 nor S2 was confirmed. After kept in contact with the compound E2 obtained in Synthesis Example 1, the zeolite changed from colorless to pale yellow. From this, it is known that the impurities were adsorbed by the zeolite. Also from the recovery rate, it is known that the impurities were adsorbed by the zeolite. The above compound obtained here was stored at -20°C, and after 4 days, no visible precipitate was formed. This indicates that, when the composition of the invention is brought into contact with zeolite, the impurities contained in the composition were removed by the zeolite.

Zeolite A-3 is synthetic zeolite, having a chemical composition of (0.4 K + 0.6 Na)₂O·Al₂O₃·2SiO₂ and having a mean pore size of 3 angstroms (Wako Analytical Circle No. 22, p. 14 (9. 2001)).

The proportion (by mol) of the mono-substituted form (Ar(1)) and the unsubstituted form (Ar(0)) in the compound after charging in the column was 0%, and the recovery efficiency of the di-substituted form was 97%.

### <Example A2>

This is the same as in Comparative Example 1, except that in the process of Comparative Example A1, Zeolite A-4 (Wako Pure Chemicals' product name, Zeolite, Synthetic, A-4, Powder, through 75 µm, 30 g) was used as the column material in place of silica gel/potassium carbonate. As a result of the treatment here, an oily compound (0.96 g, yield 96%) was obtained.

The obtained compound was analyzed through proton NMR, which was confirmed as the compound E2 and in which neither the compound S1 nor S2 was confirmed. After kept in contact with the compound E2 obtained in Synthesis Example 1, the zeolite changed from colorless to pale yellow. From this, it is known that the impurities were adsorbed by the zeolite. Also from the recovery rate, it is known that the impurities were adsorbed by the zeolite.

Zeolite A-4 is synthetic zeolite, having a chemical composition of Na₂O·Al₂O₃·2SiO₂ and having a mean pore size of 4 angstroms (Wako Analytical Circle No. 22, p. 14 (9. 2001)).

The proportion (by mol) of the mono-substituted form (Ar(1)) and the unsubstituted form (Ar(0)) in the compound after charging in the column was 0%, and the recovery efficiency of the di-substituted form was 96%.

### <Example A3>

This is the same as in Comparative Example 1, except that in the process of Comparative Example A1, Zeolite A-5 (Wako Pure Chemicals' product name, Zeolite, Synthetic, A-5, Beads, 2.36 to 4.75 mm, 30 g) was, after ground in a mortar to be a powder, used as the column material in place of silica gel/potassium carbonate. As a result of the treatment here, an oily compound (0.95 g, yield 95%) was obtained.

The obtained compound was analyzed through proton NMR, which was confirmed as the compound E2 and in which neither the compound S1 nor S2 was confirmed. After kept in contact with the compound E2 obtained in Synthesis Example 1, the zeolite changed from colorless to pale yellow. From this, it is known that the impurities were adsorbed by the zeolite. Also from the recovery rate, it is known that the impurities were adsorbed by the zeolite.

The proportion (by mol) of the mono-substituted form (Ar(1)) and the unsubstituted form (Ar(0)) in the compound after charging in the column was 0%, and the recovery efficiency of the di-substituted form was 95%.

### <Example A4>

This is the same as in Comparative Example A1, except that in the process of Comparative Example A1, Zeolite F-9 (Wako Pure Chemicals' product name, Zeolite, Synthetic, F-9, Powder, 30 g) was used as the column material in place of silica gel/potassium carbonate. As a result of the treatment here, an oily compound (0.93 g, yield 93%) was obtained.

The obtained compound was analyzed through proton NMR, which was confirmed as the compound E2 and in which neither the compound S1 nor S2 was confirmed. After kept in contact with the compound E2 obtained in Synthesis Example 1, the zeolite changed from colorless to pale yellow. From this, it is known that the impurities were adsorbed by the zeolite. Also from the recovery rate, it is known that the impurities were adsorbed by the zeolite.

Zeolite F-9 is synthetic zeolite, having a chemical composition of Na₂O·Al₂O₃·2.5SiO₂ and having a mean pore size of 9 angstroms (Wako Analytical Circle No. 22, p. 14 (9. 2001)).

The proportion (by mol) of the mono-substituted form (Ar(1)) and the unsubstituted form (Ar(0)) in the compound after charging in the column was 0%, and the recovery efficiency of the di-substituted form was 93%.

### <Example A5>

This is the same as in Comparative Example 1, except that in the process of Comparative Example A1, Zeolite HS-720 (Wako Pure Chemicals' product name, Zeolite, Synthetic, HS-720, Powder, potassium ferrierite, 30 g) was used as the column material in place of silica gel/potassium carbonate. As a result of the treatment here, an oily compound (0.95 g, yield 95%) was obtained.

The obtained compound was analyzed through proton NMR, which was confirmed as the compound E2 and in which neither the compound S1 nor S2 was confirmed. After kept in contact with the compound E2 obtained in Synthesis Example 1, the zeolite changed from colorless to pale yellow. From this, it is known that the impurities were adsorbed by the zeolite. Also from the recovery rate, it is known that the impurities were adsorbed by the zeolite.

Zeolite HS-720 is a cation type K of SiO₂/Al₂O₃ (mol/mol) = 17.7, having a surface area (BET, m²/g) of 170 and a mean particle size (µm) of from 20 to 30.

The proportion (by mol) of the mono-substituted form (Ar(1)) and the unsubstituted form (Ar(0)) in the compound after charging in the column was 0%, and the recovery efficiency of the di-substituted form was 95%.

### <Example A6>

This is the same as in Comparative Example 1, except that in the process of Comparative Example A1, Zeolite HS-320 (Wako Pure Chemicals' product name, Zeolite, Synthetic, HS-320, Powder, hydrogen Y, 30 g) was used as the column material in place of silica gel/potassium carbonate. As a result of the treatment here, an oily compound (0.96 g, yield 96%) was obtained.

The obtained compound was analyzed through proton NMR, which was confirmed as the compound E2 and in which neither the compound S1 nor S2 was confirmed. After kept in contact with the compound E2 obtained in Synthesis Example 1, the zeolite changed from colorless to pale yellow. From this, it is known that the impurities were adsorbed by the zeolite. Also from the recovery rate, it is known that the impurities were adsorbed by the zeolite.

Zeolite HS-320 is a cation type K of SiO₂/Al₂O₃ (mol/mol) = 5.5, having a surface area (BET, m²/g) of 550 and a mean particle size (µm) of from 6 to 10.

The proportion (by mol) of the mono-substituted form (Ar(1)) and the unsubstituted form (Ar(0)) in the compound after charging in the column was 0%, and the recovery efficiency of the di-substituted form was 96%.

### <Example A7>

This is the same as in Comparative Example 1, except that in the process of Comparative Example A1, Zeolite HS-341 (Wako Pure Chemicals' product name, Zeolite, Synthetic, HS-341, Powder, ammonium Y, 30 g) was used as the column material in place of silica gel/potassium carbonate. As a result of the treatment here, an oily compound (0.95 g, yield 95%) was obtained.

The obtained compound was analyzed through proton NMR, which was confirmed as the compound E2 and in which neither the compound S1 nor S2 was confirmed. After kept in contact with the compound E2 obtained in Synthesis Example 1, the zeolite changed from colorless to pale yellow. From this, it is known that the impurities were adsorbed by the zeolite. Also from the recovery rate, it is known that the impurities were adsorbed by the zeolite.

Zeolite HS-341 is a cation type NH₃ of SiO₂/Al₂O₃ (mol/mol) = 7, having a surface area (BET, m²/g) of 700 and a mean particle size (µm) of from 2 to 4.

The proportion (by mol) of the mono-substituted form (Ar(1)) and the unsubstituted form (Ar(0)) in the compound after charging in the column was 0%, and the recovery efficiency of the di-substituted form was 95%.

### <Example A8>

This is the same as in Comparative Example 1, except that in the process of Comparative Example A1, Zeolite HS-500 (Wako Pure Chemicals' product name, Zeolite, Synthetic, HS-500, Powder, potassium L, 30 g) was used as the column material in place of silica gel/potassium carbonate. As a result of the treatment here, an oily compound (0.94 g, yield 94%) was obtained.

The obtained compound was analyzed through proton NMR, which was confirmed as the compound E2 and in which neither the compound S1 nor S2 was confirmed. After kept in contact with the compound E2 obtained in Synthesis Example 1, the zeolite changed from colorless to pale yellow. From this, it is known that the impurities were adsorbed by the zeolite. Also from the recovery rate, it is known that the impurities were adsorbed by the zeolite.

Zeolite HS-500 is a cation type K of SiO₂/Al₂O₃ (mol/mol) = 6, having a surface area (BET, m₂/g) of 280 and a mean particle size (µm) of from 2 to 4.

The proportion (by mol) of the mono-substituted form (Ar(1)) and the unsubstituted form (Ar(0)) in the compound after charging in the column was 0%, and the recovery efficiency of the di-substituted form was 94%.

### <Example A9>

This is the same as in Comparative Example 1, except that in the process of Comparative Example A1, Zeolite HS-642 (Wako Pure Chemicals' product name, Zeolite, Synthetic, HS-642, Powder, sodium mordenite, 30 g) was used as the column material in place of silica gel/potassium carbonate. As a result of the treatment here, an oily compound (0.94 g, yield 94%) was obtained.

The obtained compound was analyzed through proton NMR, which was confirmed as the compound E2 and in which neither the compound S1 nor S2 was confirmed. After kept in contact with the compound E2 obtained in Synthesis Example 1, the zeolite changed from colorless to pale yellow. From this, it is known that the impurities were adsorbed by the zeolite. Also from the recovery rate, it is known that the impurities were adsorbed by the zeolite.

Zeolite HS-642 is a cation type of Na₈[Al₈Si₄₀O₉₆]·24H₂O.

The proportion (by mol) of the mono-substituted form (Ar(1)) and the unsubstituted form (Ar(0)) in the compound after charging in the column was 0%, and the recovery efficiency of the di-substituted form was 94%.

### <Example A10>

This is the same as in Comparative Example 1, except that in the process of Comparative Example A1, Zeolite HS-690 (Wako Pure Chemicals' product name, Zeolite, Synthetic, HS-690, Powder, hydrogen mordenite, 30 g) was used as the column material in place of silica gel/potassium carbonate. As a result of the treatment here, an oily compound (0.95 g, yield 95%) was obtained.

The obtained compound was analyzed through proton NMR, which was confirmed as the compound E2 and in which neither the compound S1 nor S2 was confirmed. After kept in contact with the compound E2 obtained in Synthesis Example 1, the zeolite changed from colorless to pale yellow. From this, it is known that the impurities were adsorbed by the zeolite. Also from the recovery rate, it is known that the impurities were adsorbed by the zeolite.

Zeolite HS-690 is a cation type H of SiO₂/Al₂O₃ (mol/mol) = 200, having a surface area (BET, m²/g) of 420 and a mean particle size (µm) of from 5 to 7.

The proportion (by mol) of the mono-substituted form (Ar(1)) and the unsubstituted form (Ar(0)) in the compound after charging in the column was 0%, and the recovery efficiency of the di-substituted form was 95%.

### <Example A11>

This is the same as in Example 1, except that in the process of Example A1, the compound E3 (0.5 g) obtained in Synthesis Example 2 was used in place of the compound E2 obtained in Synthesis Example 1. As a result of the treatment here, an oily compound (0.48 g, yield 96%) was obtained.

The obtained compound was analyzed through proton NMR, which was confirmed as the compound E3 and in which the presence of a destannylated compound was not confirmed. After kept in contact with the compound E3 obtained in Synthesis Example 2, the zeolite changed from colorless to pale yellow. From this, it is known that the impurities were adsorbed by the zeolite. Also from the recovery rate, it is known that the impurities were adsorbed by the zeolite.

The proportion (by mol) of the mono-substituted form (Ar(1)) and the unsubstituted form (Ar(0)) in the compound after charging in the column was 0%, and the recovery efficiency of the di-substituted form was 96%.

### <Example A12>

This is the same as in Example 1, except that in the process of Example A1, the compound E4 (0.5 g) obtained in Synthesis Example 3 was used in place of the compound E1 obtained in Synthesis Example 1. As a result of the treatment here, an oily compound (0.49 g, yield 98%) was obtained.

The obtained compound was analyzed through proton NMR, which was confirmed as the compound E4 and in which the presence of a destannylated compound was not confirmed. After kept in contact with the compound E4 obtained in Synthesis Example 3, the zeolite changed from colorless to pale yellow. From this, it is known that the impurities were adsorbed by the zeolite. Also from the recovery rate, it is known that the impurities were adsorbed by the zeolite.

The proportion (by mol) of the mono-substituted form (Ar(1)) and the unsubstituted form (Ar(0)) in the compound after charging in the column was 0%, and the recovery efficiency of the di-substituted form was 98%.

### <Example A13>

In the same manner as above except that the compound E5 (5.7 g) obtained in Synthesis Example 4 was used in place of the compound E2 obtained in Synthesis Example 1, an oily compound (5.6 g, yield 98%) was obtained.

The obtained compound was analyzed through proton NMR, which was confirmed as the compound E5 and in which the presence of a destannylated compound was not confirmed. After kept in contact with the compound E5 obtained in Synthesis Example 4, the zeolite changed from colorless to pale yellow. From this, it is known that the impurities were adsorbed by the zeolite. Also from the recovery rate, it is known that the impurities were adsorbed by the zeolite.

The proportion (by mol) of the mono-substituted form (Ar(1)) and the unsubstituted form (Ar(0)) in the compound after charging in the column was 0%, and the recovery efficiency of the di-substituted form was 98%.

### <Example A14>

In the same manner as above except that the compound E6 (3.1 g) obtained in Synthesis Example 5 was used in place of the compound E2 obtained in Synthesis Example 1, an oily compound (2.9 g, yield 94%) was obtained. The obtained compound was analyzed through proton NMR, which was confirmed as the compound E6 and in which the presence of a destannylated compound was not confirmed. After kept in contact with the compound E6 obtained in Synthesis Example 5, the zeolite changed from colorless to pale yellow. From this, it is known that the impurities were adsorbed by the zeolite. Also from the recovery rate, it is known that the impurities were adsorbed by the zeolite.

The proportion (by mol) of the mono-substituted form (Ar(1)) and the unsubstituted form (Ar(0)) in the compound after charging in the column was 0%, and the recovery efficiency of the di-substituted form was 94%.

### <Example A15>

In the same manner as above except that the compound E7 (6.0 g) obtained in Synthesis Example 6 was used in place of the compound E2 obtained in Synthesis Example 1, an oily compound (5.9 g, yield 98%) was obtained. The obtained compound was analyzed through proton NMR, which was confirmed as the compound E7 and in which the presence of a destannylated compound was not confirmed. After kept in contact with the compound E7 obtained in Synthesis Example 6, the zeolite changed from colorless to pale yellow. From this, it is known that the impurities were adsorbed by the zeolite. Also from the recovery rate, it is known that the impurities were adsorbed by the zeolite.

The proportion (by mol) of the mono-substituted form (Ar(1)) and the unsubstituted form (Ar(0)) in the compound after charging in the column was 0%, and the recovery efficiency of the di-substituted form was 98%.

### <Example A16>

In the same manner as above except that the compound E8 (3.2 g) obtained in Synthesis Example 7 was used in place of the compound E2 obtained in Synthesis Example 1, an oily compound (3.1 g, yield 97%) was obtained. The obtained compound was analyzed through proton NMR, which was confirmed as the compound E7 and in which the presence of a destannylated compound was not confirmed. After kept in contact with the compound E8 obtained in Synthesis Example 7, the zeolite changed from colorless to pale yellow. From this, it is known that the impurities were adsorbed by the zeolite. Also from the recovery rate, it is known that the impurities were adsorbed by the zeolite.

The proportion (by mol) of the mono-substituted form (Ar(1)) and the unsubstituted form (Ar(0)) in the compound after charging in the column was 0%, and the recovery efficiency of the di-substituted form was 97%.

### <Example A17>

In the same manner as above except that the compound E12 (3.5 g) obtained in Synthesis Example 8 was used in place of the compound E2 obtained in Synthesis Example 1, an oily compound (3.3 g, yield 94%) was obtained. The obtained compound was analyzed through proton NMR, which was confirmed as the compound E12 and in which the presence of a destannylated compound was not confirmed. After kept in contact with the compound E12 obtained in Synthesis Example 8, the zeolite changed from colorless to pale yellow. From this, it is known that the impurities were adsorbed by the zeolite. Also from the recovery rate, it is known that the impurities were adsorbed by the zeolite.

The proportion (by mol) of the mono-substituted form (Ar(1)) and the unsubstituted form (Ar(0)) in the compound after charging in the column was 0%, and the recovery efficiency of the di-substituted form was 94%.

### <Example A18>

In the same manner as above except that the compound E13 (2.7 g) obtained in Synthesis Example 9 was used in place of the compound E2 obtained in Synthesis Example 1, an oily compound (2.5 g, yield 93%) was obtained. The obtained compound was analyzed through proton NMR, which was confirmed as the compound E13 and in which the presence of a destannylated compound was not confirmed. After kept in contact with the compound E13 obtained in Synthesis Example 9, the zeolite changed from colorless to pale yellow. From this, it is known that the impurities were adsorbed by the zeolite. Also from the recovery rate, it is known that the impurities were adsorbed by the zeolite.

The proportion (by mol) of the mono-substituted form (Ar(1)) and the unsubstituted form (Ar(0)) in the compound after charging in the column was 0%, and the recovery efficiency of the di-substituted form was 93%.

### <Example A19>

In the same manner as above except that the compound E15 (3.0 g) obtained in Synthesis Example 10 was used in place of the compound E2 obtained in Synthesis Example 1, an oily compound (2.94 g, yield 98%) was obtained. The obtained compound was analyzed through proton NMR, which was confirmed as the compound E 15 and in which the presence of a destannylated compound was not confirmed.

The proportion (by mol) of the mono-substituted form (Ar(1)) and the unsubstituted form (Ar(0)) in the compound after charging in the column was 0%, and the recovery efficiency of the di-substituted form was 98%.

The above results are shown in Table 1 and Table 2.

**[Table 1]**

| | Monomer | Purification Step | | Impurities Removal | Process Efficiency | |
|---|---|---|---|---|---|---|
| | | Carrier | Method (developing solvent) | | Molar Ratio (%) of Ar(1) and Ar (0) in the compound after charging in column | Recovery Efficiency (%) of Di-substituted form |
| Comparative Example A1 | E2 | column (silica gel/ potassium carbonate) | passing fraction collected (hexane) | ○ | 100 | 0 |
| Comparative Example A2 | E2 | column (silica gel) | passing fraction collected (hexane + triethylamine (10 wt.%)) | ○ | 75 | 24 |
| Comparative Example A3 | E2 | amine silica gel | passing fraction collected (hexane) | ○ | 90 | 9 |
| Comparative Example A4 | E2 | neutral alumina | passing fraction collected (hexane) | ○ | 100 | 9 |
| Comparative Example A5 | E2 | basic alumina | passing fraction collected (hexane) | ○ | 100 | 9 |
| Comparative Example A6 | E2 | activated charcoal (acidic) | passing fraction collected (hexane) | ○ | 20 | 75 |
| Comparative Example A7 | E2 | activated charcoal (basic) | passing fraction collected (hexane) | ○ | 17 | 78 |
| Comparative Example A8 | E2 | celite | passing fraction collected (hexane) | × | 0 | 98 |
| Comparative Example A9 | E5 | column (silica gel/ potassium carbonate) | passing fraction collected (hexane) | ○ | 100 | 0 |
| Comparative Example A10 | E7 | column (silica gel/ potassium carbonate) | passing fraction collected (hexane) | ○ | 100 | 0 |
| Comparative Example A11 | E8 | column (silica gel/ potassium carbonate) | passing fraction collected (hexane) | ○ | 100 | 0 |
| Comparative Example A12 | E12 | column (silica gel/ potassium carbonate) | passing fraction collected (hexane) | ○ | 100 | 0 |
| Example A1 | E2 | synthetic zeolite (Zeolite A-3) | passing fraction collected (hexane) | ○ | 0 | 97 |
| Example A2 | E2 | synthetic zeolite (Zeolite A-4) | passing fraction collected (hexane) | ○ | 0 | 96 |
| Example A3 | E2 | synthetic zeolite (Zeolite A-5) | passing fraction collected (hexane) | ○ | 0 | 95 |

**[Table 2]**

| | Monomer | Purification Step | | Impurities Removal | Process Efficiency | |
|---|---|---|---|---|---|---|
| | | Carrier | Method (developing solvent) | | Molar Ratio (%) of Ar(1) and Ar(0) in the compound after charging in column | Recovery Efficiency (%) of Di-substituted form |
| Example A4 | E2 | synthetic zeolite (Zeolite F-9) | passing fraction collected (hexane) | ○ | 0 | 93 |
| Example A5 | E2 | cation-type zeolite (Zeolite HS-720) | passing fraction collected (hexane) | ○ | 0 | 95 |
| Example A6 | E2 | cation-type zeolite (Zeolite HS-320) | passing fraction collected (hexane) | ○ | 0 | 96 |
| Example A7 | E2 | cation-type zeolite (Zeolite HS-341) | passing fraction collected (hexane) | ○ | 0 | 95 |
| Example A8 | E2 | cation-type zeolite (Zeolite HS-500) | passing fraction collected (hexane) | ○ | 0 | 94 |
| Example A9 | E2 | cation-type zeolite (Zeolite HS-642) | passing fraction collected (hexane) | ○ | 0 | 94 |
| Example A10 | E2 | cation-type zeolite (Zeolite HS-690) | passing fraction collected (hexane) | ○ | 0 | 95 |
| Example A11 | E3 | synthetic zeolite (Zeolite A-3) | passing fraction collected (hexane) | ○ | 0 | 96 |
| Example A12 | E4 | synthetic zeolite (Zeolite A-3) | passing fraction collected (hexane) | ○ | 0 | 98 |
| Example A13 | E5 | synthetic zeolite (Zeolite A-3) | passing fraction collected (hexane) | ○ | 0 | 98 |
| Example A14 | E6 | synthetic zeolite (Zeolite A-3) | passing fraction collected (hexane) | ○ | 0 | 94 |
| Example A15 | E7 | synthetic zeolite (Zeolite A-3) | passing fraction collected (hexane) | ○ | 0 | 98 |
| Example A16 | E8 | synthetic zeolite (Zeolite A-3) | passing fraction collected (hexane) | ○ | 0 | 97 |
| Example A17 | E12 | synthetic zeolite (Zeolite A-3) | passing fraction collected (hexane) | ○ | 0 | 94 |
| Example A18 | E13 | synthetic zeolite (Zeolite A-3) | passing fraction collected (hexane) | ○ | 0 | 93 |
| Example A19 | E15 | synthetic zeolite as(Zeolite A-3) | passing fraction collected (hexane) | ○ | 0 | 98 |

### <Example B1>

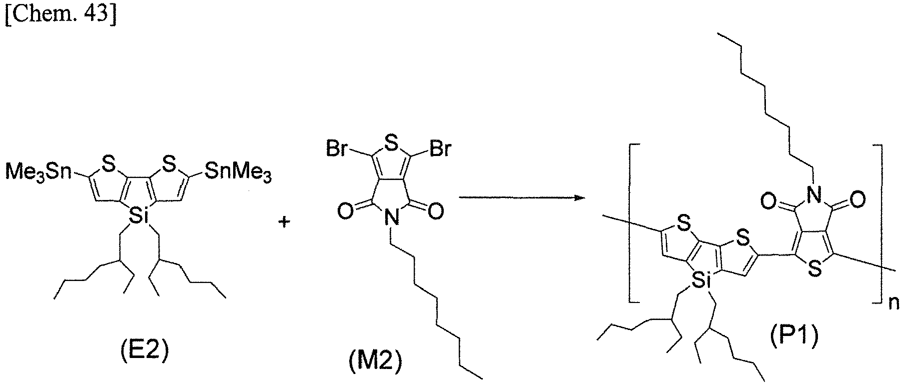

In a 50-mL eggplant flask in nitrogen, the compound E2 (138 mg) obtained in Example A1, the compound M2 (1,3-dibromo-5-octyl-4H-thieno[3,4-c]pyrrole-4,6-(5H)-dione, 255 mg) obtained with reference to a publication (Organic Letters, Vol. 6, pp. 3381-3384, 2004), tetrakis(triphenylphosphine)palladium(0) (12 mg, 3 mol% relative to the compound E2), a heterogeneous complex catalyst Pd-EnCat® TPP30 (by Aldrich, 25 mg, 3 mol% relative to the compound E2), toluene (5.3 mL) and N,N-dimethylformamide (1.3 mL) were put, and stirred at 90°C for 1 hour and then at 100°C for 10 hours therein. The reaction liquid was diluted 4-fold with toluene, then stirred under heat for 0.5 hours, and thereafter for terminal treatment, trimethyl(phenyl)tin (0.043 mL) was added thereto and stirred under heat for 6 hours, and further, bromobenzene (2 mL) was added and stirred under heat for 11 hours, and the reaction solution was poured into methanol, and the deposited precipitate was taken out through filtration.

The obtained solid was dissolved in chloroform, then diamine silica gel (by Fuji Silicia Chemical) was added thereto and stirred at room temperature for 1 hour, and led to pass through a short column filled with an acidic silica gel. The solution was concentrated and reprecipitated using a solvent of chloroform/ethyl acetate, and the deposited precipitate was taken out through filtration to give a conjugated polymer P1. Of the obtained conjugated polymer P1, the weight-average molecular weight Mw was 1.5 × 10⁵, and PDI was 3.2. The yield of the conjugated polymer P1 was 78%.

### <Example B2>

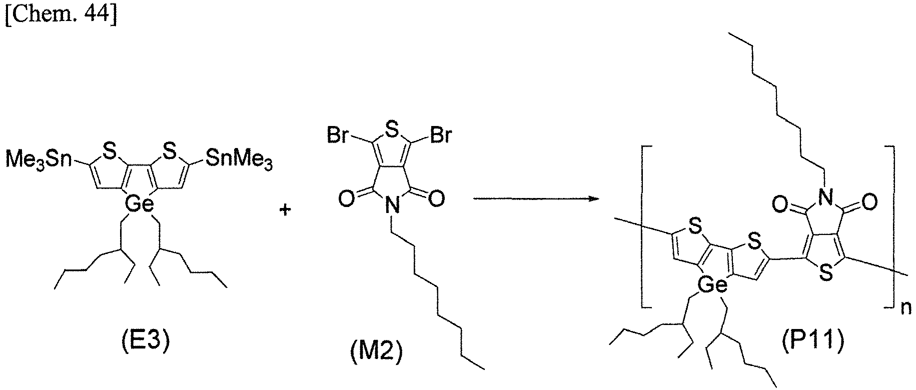

A conjugated polymer P11 was obtained in the same manner as in Example B1 except that, in Example B1, the compound E3 (300 mg) obtained in Example A11 was used in place of the compound E2 obtained in Example A1. Of the obtained conjugated polymer P11, the weight-average molecular weight Mw was 1.9 × 10⁵, and PDI was 5.7. The yield of the conjugated polymer P11 was 82%.

### <Example B3>

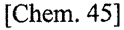

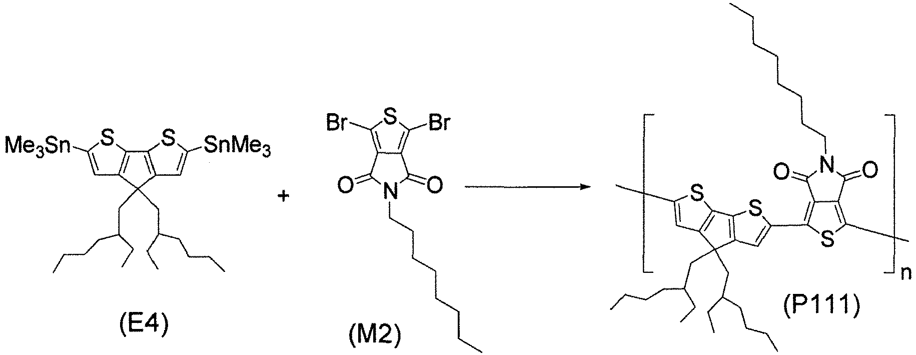

A conjugated polymer P111 was obtained in the same manner as in Example B1 except that, in Example B1, the compound E4 (250 mg) obtained in Example A12 was used in place of the compound E2 obtained in Example A1. Of the obtained conjugated polymer P111, the weight-average molecular weight Mw was 1.3 × 10⁵, and PDI was 3.4. The yield of the conjugated polymer P111 was 73%.

### <Comparative Example B1>

A conjugated polymer P1 was obtained in the same manner as in Example B1 except that, in Example B1, the compound E2 obtained in Synthesis Example 1 was used in place of the compound E2 obtained in Example A1, and that as the catalyst, tetrakis(triphenylphosphine)palladium(0) alone was used in an amount of 3 mol% relative to the compound E2, in place of using tetrakis(triphenylphosphine)palladium(0) in an amount of 3 mol% relative to the compound E2 and the heterogeneous complex catalyst Pd-EnCat® TPP30 in an amount of 3 mol% relative to the compound E2. Of the obtained conjugated polymer P1, the weight-average molecular weight Mw was 2.1 × 10⁴, and PDI was 3.1. The yield of the conjugated polymer P1 was 51%.

### <Comparative Example B2>

A conjugated polymer P1 was obtained in the same manner as in Comparative Example B1 except that, in Comparative Example B1, the compound E2 obtained in Comparative Example A8 was used in place of the compound E2 obtained in Synthesis Example A1. Of the obtained conjugated polymer P1, the weight-average molecular weight Mw was 3.2 × 10⁴, and PDI was 2.8. The yield of the conjugated polymer P1 was 41%.

### <Example B4>

A conjugated polymer P1 was obtained in the same manner as in Example B1 except that, in Example B1 as the catalyst, tetrakis(triphenylphosphine)palladium(0) alone was used in an amount of 3 mol% relative to the compound E2, in place of using tetrakis(triphenylphosphine)palladium(0) in an amount of 3 mol% relative to the compound E2 and the heterogeneous complex catalyst Pd-EnCat® TPP30 in an amount of 3 mol% relative to the compound E2. Of the obtained conjugated polymer P1, the weight-average molecular weight Mw was 4.3 × 10⁴, and PDI was 2.4. The yield of the conjugated polymer P1 was 38%.

### <Example B5>

### [Conjugated Polymer D, Pd(PPh₃)₄ 3 mol% + Pd-EnCat® TPP30 3 mol%]

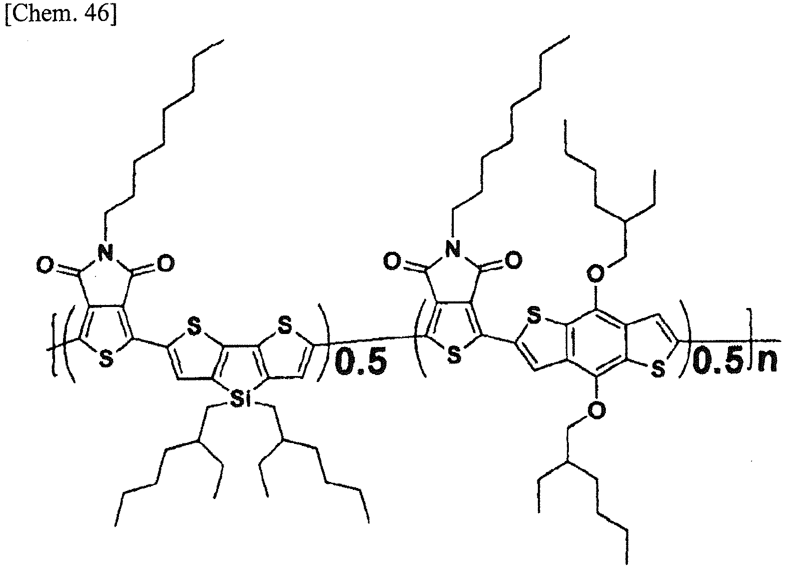

A conjugated polymer D was obtained in the same manner as in Example B1 except that, in Example B1, the compound M2 (0.861 mol), the compound E2 (0.453 mol) and the compound E5 (0.453 mol) obtained in Synthesis Example 4 were used in place of the compound E2 obtained in Example A1, and that as the catalyst, Pd(PPh₃)₄ and Pd-EnCat® TPP30 were used each in an amount of 3 mol% relative to the compound M2, in place of using them each in an amount of 3 mol% relative to the compound E2. Of the obtained conjugated polymer D, the weight-average molecular weight Mw was 1.6 × 10⁵, and PDI was 4.1. The yield of the conjugated polymer D was 71%.

### <Example B6>

### [Conjugated Polymer E, Pd(PPh₃)₄ 3 mol% + Pd-EnCat® TPP30 3 mol%]

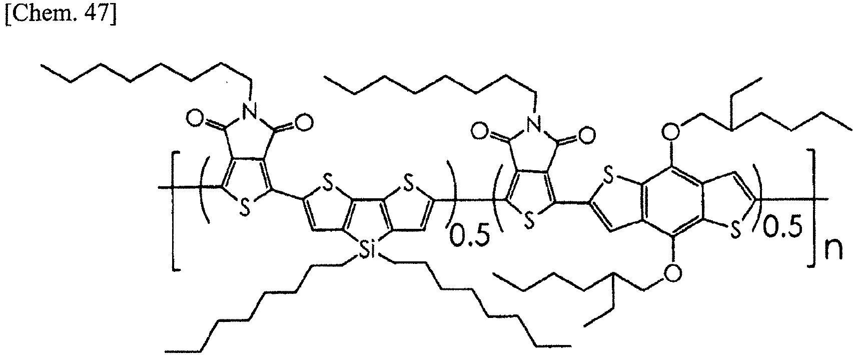

A conjugated polymer E was obtained in the same manner as in Example B1 except that, in Example B1, the compound M2 (0.861 mol), the compound E5 (0.298 mol) and the compound E6 (0.298 mol) obtained in Synthesis Example 5 were used as the monomers in place of the compound M2 and the compound E2, and that as the catalyst, Pd(PPh₃)₄ and Pd-EnCat® TPP30 were used each in an amount of 3 mol% relative to the compound E1, in place of using them each in an amount of 3 mol% relative to the compound E2. Of the obtained conjugated polymer E, the weight-average molecular weight Mw was 1.0 × 10⁵, and PDI was 2.7. The yield of the conjugated polymer E was 69%.

### <Example B7>

### [Conjugated Polymer F, Pd(PPh₃)₄ 3 mol% + Pd-EnCat® TPP30 3 mol%]

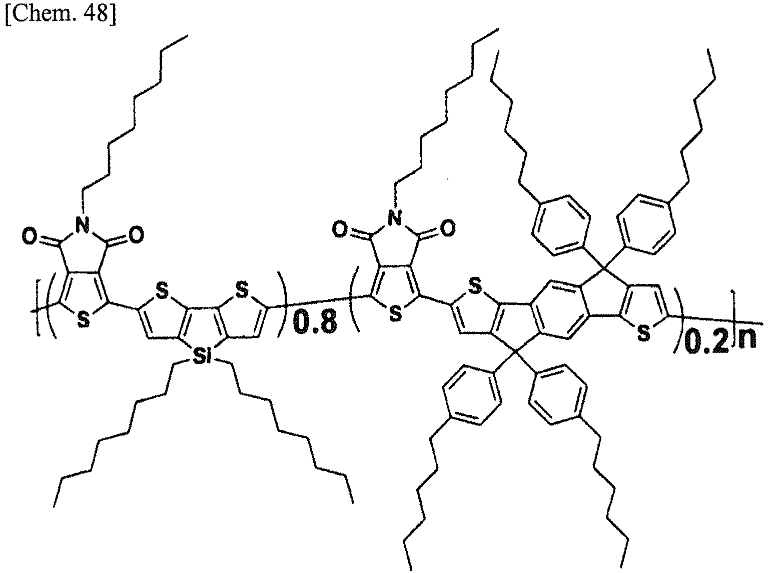

A conjugated polymer F was obtained in the same manner as in Example B1 except that, in Example B1, the compound M2 (0.810 mol), the compound E6 (0.682 mol) obtained in Synthesis Example 5 and the compound E7 (0.171 mol) obtained in Synthesis Example 6 were used as the monomers in place of the compound M2 and the compound E2, and that as the catalyst, Pd(PPh₃)₄ and Pd-EnCat® TPP30 were used each in an amount of 3 mol% relative to the compound M2, in place of using them each in an amount of 3 mol% relative to the compound E2. Of the obtained conjugated polymer F, the weight-average molecular weight Mw was 4.4 × 10⁵, and PDI was 5.6. The yield of the conjugated polymer F was 79%.

### <Example B8>

### [Conjugated Polymer G, Pd(PPh₃)₄ 3 mol% + Pd-EnCat® TPP30 3 mol%]

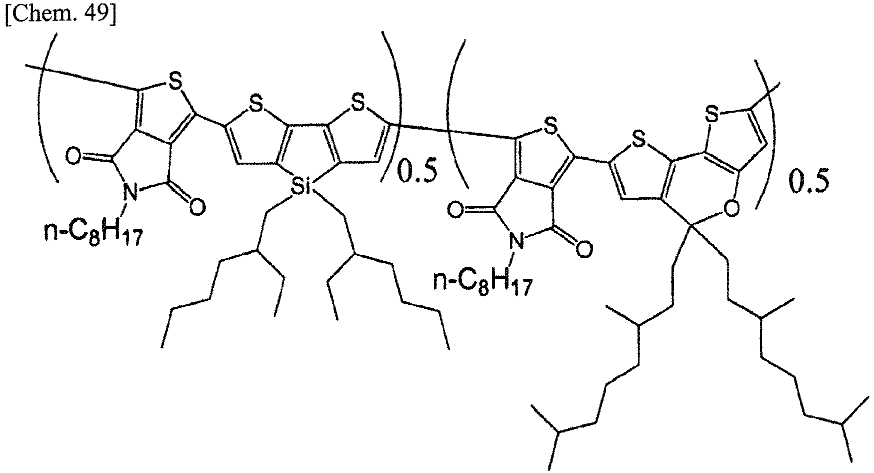

A conjugated polymer G was obtained in the same manner as in Example B1 except that, in Example B1, the compound M2 (0.851 mol), the compound E2 (0.448 mol) and the compound E8 (0.448 mol) obtained in Synthesis Example 7 were used as the monomers in place of the compound M2 and the compound E2, and that as the catalyst, Pd(PPh₃)₄ and Pd-EnCat® TPP30 were used each in an amount of 3 mol% relative to the compound M2, in place of using them each in an amount of 3 mol% relative to the compound E2. Of the obtained conjugated polymer G, the weight-average molecular weight Mw was 5.1 × 10⁴, and PDI was 2.1. The yield of the conjugated polymer G was 68%.

### <Example B9>

### [Conjugated Polymer H, Pd(PPh₃)₄ 3 mol% + Pd-EnCat® TPP30 3 mol%]

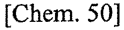

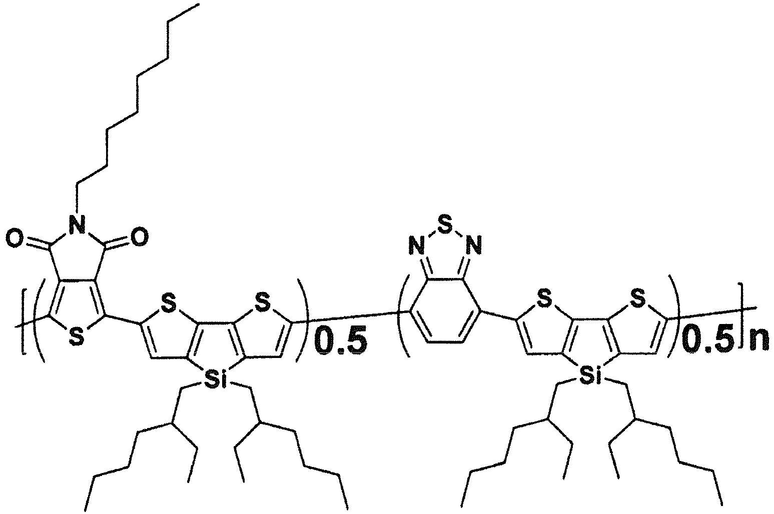

A conjugated polymer H was obtained in the same manner as in Example B1 except that, in Example B1, the compound M2 (0.396 mol), the compound E2 (0.834 mol) and 4,7-dibromobenzo[c][1,2,5]thiadiazole (compound E9(0.396 mol, by Tokyo Chemical)) were used as the monomers in place of the compound M2 and the compound E2. Of the obtained conjugated polymer H, the weight-average molecular weight Mw was 1.0 × 10⁵, and PDI was 3.6. The yield of the conjugated polymer H was 73%.

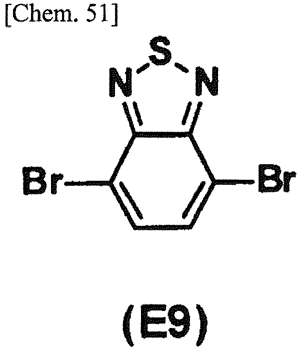

### <Example B10>

### [Conjugated Polymer I, Pd(PPh₃)₄ 3 mol% + Pd-EnCat® TPP30 3 mol%]

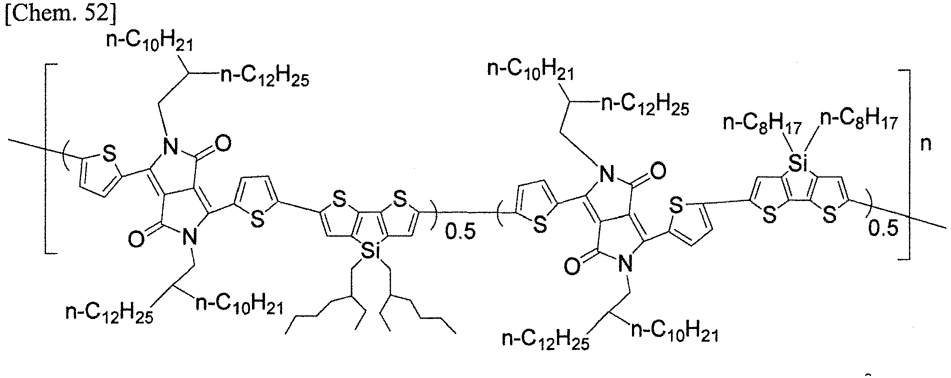

A conjugated polymer I was obtained in the same manner as in Example B1 except that, in Example B1, the compound E2 (0.341 mol), the compound E6 (0.341 mol) obtained in Synthesis Example 5 and 3,6-bis(5-bromo-2-thienyl)-2,5-bis(2-decyltetradecyl)-2,5-dihydro-pyrrolo[3,4-c]pyrrole -1,4-dione (compound E10 (0.648 mmol), by Lumtec) were used as the monomers in place of the compound M2 and the compound E2, and that as the catalyst, Pd(PPh₃)₄ and Pd-EnCat® TPP30 were used each in an amount of 3 mol% relative to the compound E10, in place of using them each in an amount of 3 mol% relative to the compound E2. Of the obtained conjugated polymer I, the weight-average molecular weight Mw was 2.6 × 10⁵, and PDI was 3.9. The yield of the conjugated polymer I was 71%.

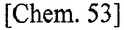

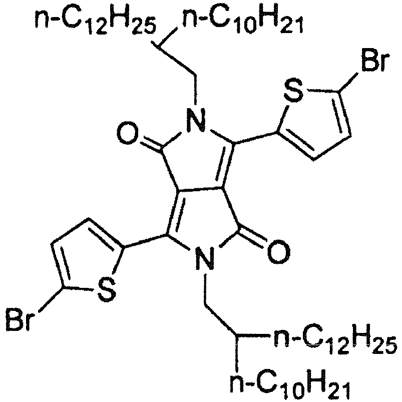

### <Example B11>

### [Conjugated Polymer J, Pd(PPh₃)₄ 3 mol% + Pd-EnCat® TPP30 3 mol%]

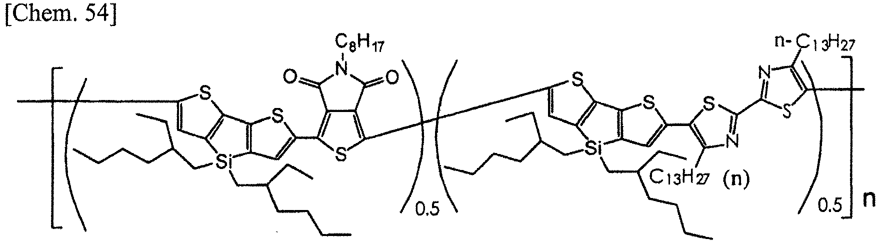

A conjugated polymer J was obtained in the same manner as in Example B1 except that, in Example B1, the compound M2 (0.338 mol), the compound E2 (0.712 mol) and 3,6-bis(5-bromo-2-thienyl)-2,5-bis(2-decyltetradecyl)-2,5-dihydro-pyrrolo[3,4-c]pyrrole -1,4-dione (compound E11 (0.338 mmol, by Lumtec)) were used as the monomers in place of the compound M2 and the compound E2. Of the obtained conjugated polymer J, the weight-average molecular weight Mw was 1.0 × 10⁵, and PDI was 2.8. The yield of the conjugated polymer J was 79%.

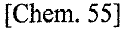

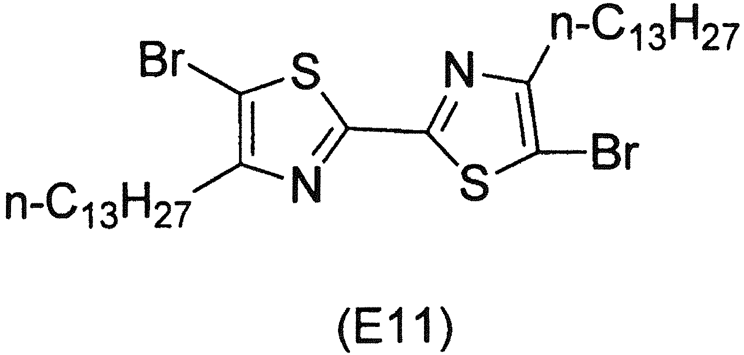

### <Example B12>

### [Conjugated Polymer K, Pd(PPh₃)₄ 3 mol% + Pd-EnCat® TPP30 3 mol%]

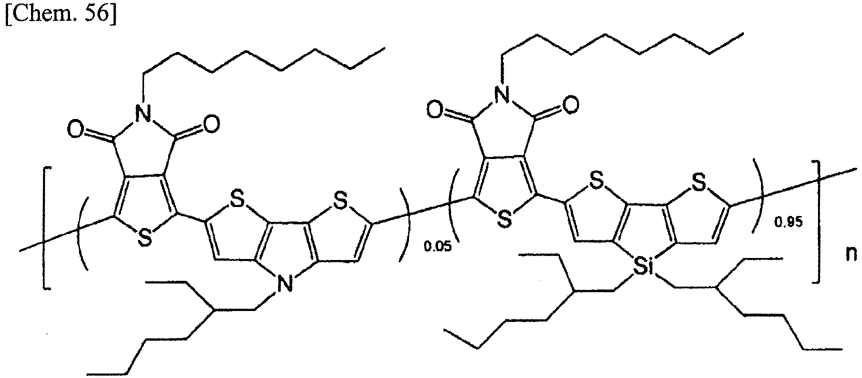

A conjugated polymer K was obtained in the same manner as in Example 1 except that, in Example B1, the compound M2 (0.801 mol), the compound E2 (0.801 mol) and the compound E12 (0.0422 mol) obtained in Synthesis Example 8 were used as the monomers in place of the compound M2 and the compound E2, and that as the catalyst, Pd(PPh₃)₄ and Pd-EnCat® TPP30 were used each in an amount of 3 mol% relative to the compound M2, in place of using them each in an amount of 3 mol% relative to the compound E2. Of the obtained conjugated polymer K, the weight-average molecular weight Mw was 1.8 × 10⁵, and PDI was 3.6. The yield of the conjugated polymer K was 77%.

### <Example B13>

### [Conjugated Polymer L, Pd(PPh₃)₄ 3 mol% + Pd-EnCat® TPP30 3 mol%]

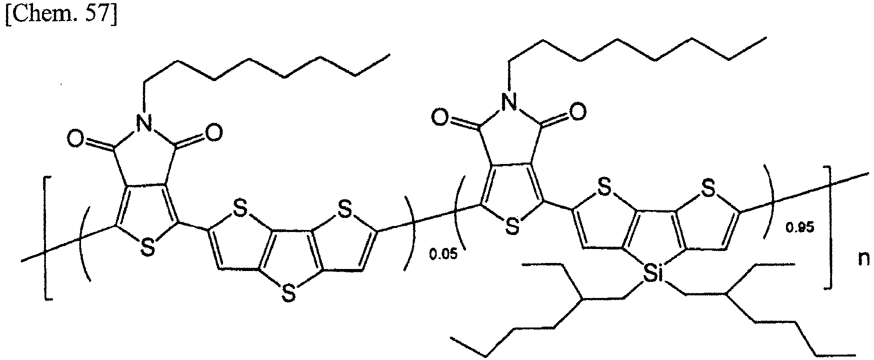

A conjugated polymer L was obtained in the same manner as in Example B1 except that, in Example B1, the compound M2 (0.794 mol), the compound E2 (0.794 mol) and the compound E13 (0.042 mol) obtained in Synthesis Example 9 were used as the monomers in place of the compound M2 and the compound E2, and that as the catalyst, Pd(PPh₃)₄ and Pd-EnCat® TPP30 were used each in an amount of 3 mol% relative to the compound M2, in place of using them each in an amount of 3 mol% relative to the compound E2. Of the obtained conjugated polymer L, the weight-average molecular weight Mw was 2.6 × 10⁵, and PDI was 5.2. The yield of the conjugated polymer L was 75%.

### <Example B14>

### [Conjugated Polymer M, Pd(PPh₃)₄ 3 mol% + Pd-EnCat® TPP30 3 mol%]

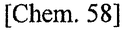

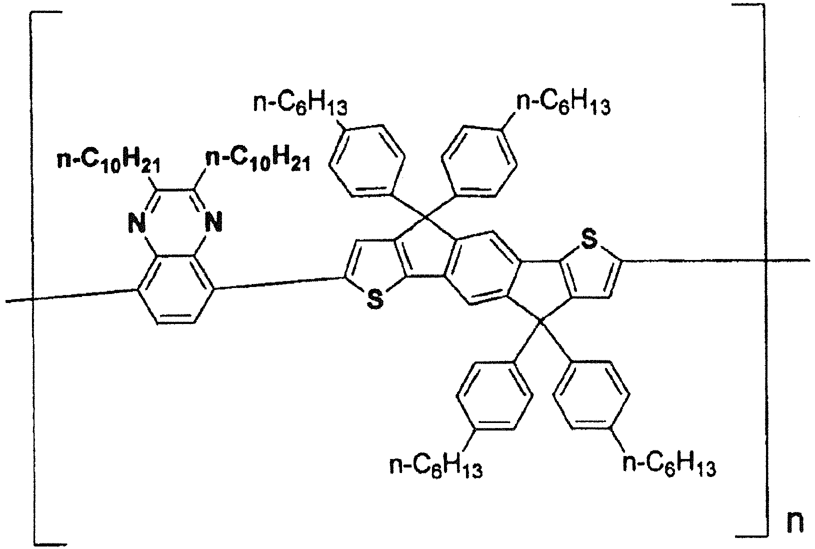

A conjugated polymer M was obtained in the same manner as in Example B1 except that, in Example B1, the compound E7 (0.642 mol) obtained in Synthesis Example 6 and 5,8-dibromo-2,3-didecyl-quinoxaline (compound E14 (0.616 mol, by Lumtec)) were used as the monomers in place of the compound M2 and the compound E2, and that as the catalyst, Pd(PPh₃)₄ and Pd-EnCat® TPP30 were used each in an amount of 3 mol% relative to the compound E7, in place of using them each in an amount of 3 mol% relative to the compound E2.

Of the obtained conjugated polymer M, the weight-average molecular weight Mw was 1.5 × 10⁵, and PDI was 1.9. The yield of the conjugated polymer M was 70%.

### <Example B15>

### [Conjugated Polymer N, Pd(PPh₃)₄ 3 mol% + Pd-EnCat® TPP30 3 mol%]

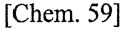

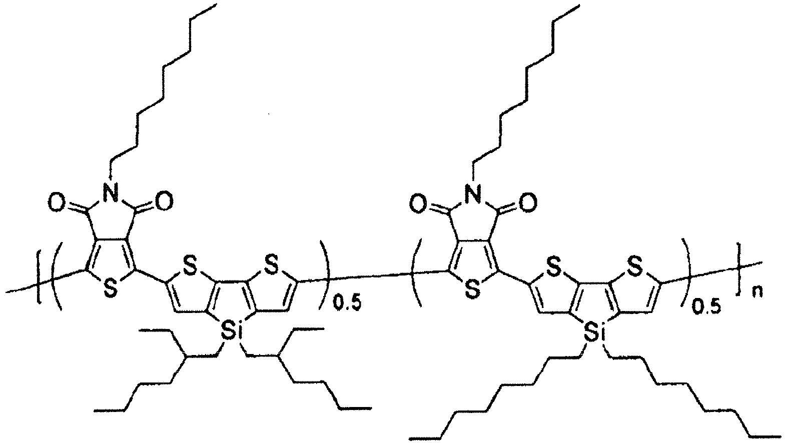

A conjugated polymer N was obtained in the same manner as in Example B1 except that, in Example B1, the compound M2 (98.9 mol), the compound E2 (47.0 mol) and the compound E6 (47.0 mol) obtained in Synthesis Example 5 were used as the monomers in place of the compound M2 and the compound E2, that as the catalyst, Pd(PPh₃)₄ and Pd-EnCat® TPP30 were used each in an amount of 3 mol% relative to the compound M2, in place of using them each in an amount of 3 mol% relative to the compound E2, and that the reaction time was 1 hour at 90°C plus 2 hours at 100°C in place of 1 hour at 90°C plus 10 hours at 100°C. Of the obtained conjugated polymer N, the weight-average molecular weight Mw was 3.2 × 10⁵, and PDI was 5.2. The yield of the conjugated polymer N was 83%.

### <Example B16>

### [Conjugated Polymer O, Pd(PPh₃)₄ 3 mol% + Pd-EnCat® PP30 3 mol%]

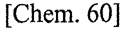

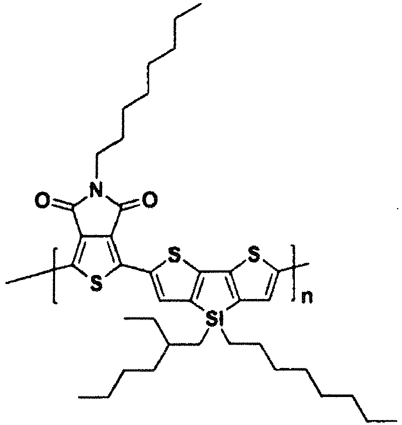

A conjugated polymer O was obtained in the same manner as in Example 1 except that, in Example B1, the compound E15 (0.986 mol) obtained in Synthesis Example 10 was used as the monomer in place of the compound E2, and that as the catalyst, Pd(PPh₃)₄ and Pd-EnCat® TPP30 were used each in an amount of 3 mol% relative to the compound E15, in place of using them each in an amount of 3 mol% relative to the compound E2. Of the obtained conjugated polymer O, the weight-average molecular weight Mw was 2.1 × 10⁵, and PDI was 4.6. The yield of the conjugated polymer O was 81%.

### <Example B17>

### [Conjugated Polymer P, Pd(PPh₃)₄ 3 mol% + Pd-EnCat® TPP30 3 mol%]

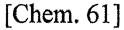

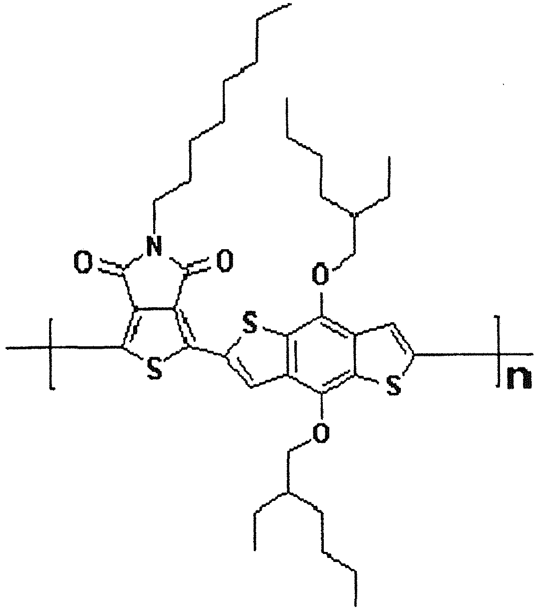

A conjugated polymer P was obtained in the same manner as in Example B1 except that, in Example B1, the compound E5 (0.612 mol) obtained in Synthesis Example 4 was used as the monomer in place of the compound E2, and that as the catalyst, Pd(PPh₃)₄ and Pd-EnCat® TPP30 were used each in an amount of 3 mol% relative to the compound E5, in place of using them each in an amount of 3 mol% relative to the compound E2. Of the obtained conjugated polymer P, the weight-average molecular weight Mw was 3.6 × 10⁵, and PDI was 5.7. The yield of the conjugated polymer P was 80%.

### <Example B18>

### [Conjugated Polymer Q, Pd(PPh₃)₄ 3 mol% + Pd-EnCat® TPP30 3 mol%]

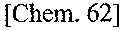

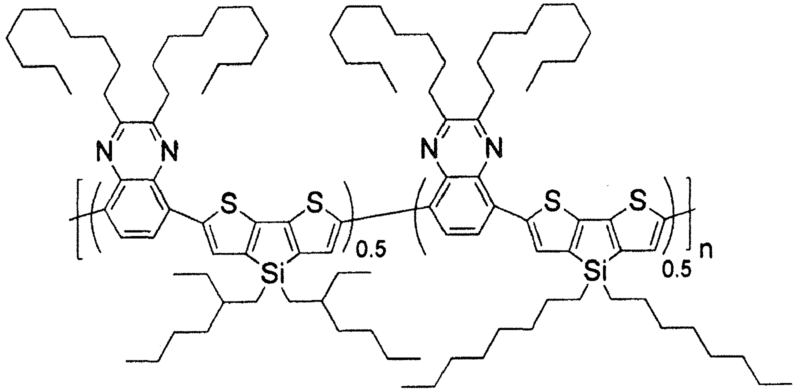

A conjugated polymer Q was obtained in the same manner as in Example B1 except that, in Example B1, the compound E2 (0.312 mol), the compound E6 (0.312 mol) obtained in Synthesis Example 5 and 5,8-dibromo-2,3-didecyl-quinoxaline (compound E14 (0.657 mol, by Lumtec)) were used as the monomers in place of the compound M2 and the compound E2, and that as the catalyst, Pd(PPh₃)₄ and Pd-EnCat® TPP30 were used each in an amount of 3 mol% relative to the compound E14, in place of using them each in an amount of 3 mol% relative to the compound E2. Of the obtained conjugated polymer Q, the weight-average molecular weight Mw was 3.2 × 10⁵, and PDI was 5.2. The yield of the conjugated polymer Q was 67%.

### <Example B19>

### [Conjugated Polymer R, Pd(PPh₃)₄ 3 mol% + Pd-EnCat® TPP30 3 mol%]

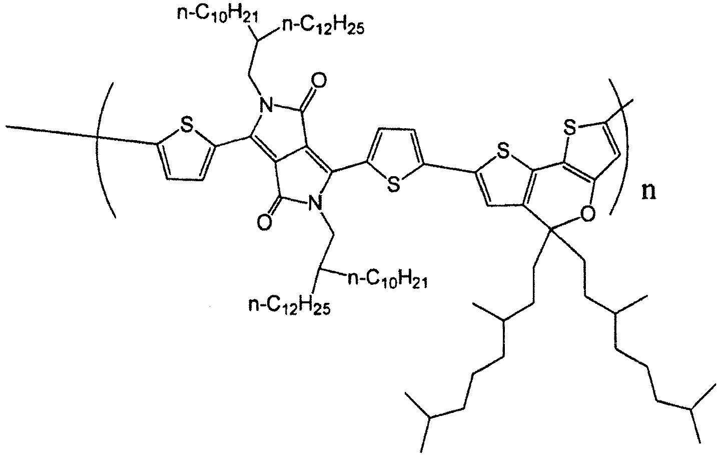

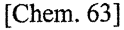

A conjugated polymer R was obtained in the same manner as in Example B1 except that, in Example B1, the compound E8 (0.835 mol) obtained in Synthesis Example 7 and 3,6-bis(5-bromo-2-thienyl)-2,5-bis(2-decyltetradecyl)-2,5-dihydro-pyrrolo[3,4-c]pyrrole -1,4-dione (compound E10 (0.810 mol, by Lumtec)) were used as the monomers in place of the compound M2 and the compound E2, and that as the catalyst, Pd(PPh₃)₄ and Pd-EnCat® TPP30 were used each in an amount of 3 mol% relative to the compound E8, in place of using them each in an amount of 3 mol% relative to the compound E2. Of the obtained conjugated polymer R, the weight-average molecular weight Mw was 4.1 × 10⁵, and PDI was 1.9. The yield of the conjugated polymer R was 74%.

**[Table 3]**

| | Monomer 1 (Production Method of Invention) | Monomer 2 | Mw | Yield (%) | PDI | Name of Polymer |
|---|---|---|---|---|---|---|
| Example B1 | (E2) Example A1 | M2 | 1.5 × 10⁵ | 77 | 3.2 | P1 |
| Example B2 | (E3) Example A11 | M2 | 1.9 × 10⁵ | 82 | 5.7 | P11 |
| Example B3 | (42) Example A12 | M2 | 1.3 × 10⁵ | 73 | 3.4 | P111 |
| Comparative Example B1 | (E2) Synthesis Example 1 | M2 | 2.1 × 10⁴ | 51 | 3.1 | P1 |
| Comparative Example B2 | (E2) Comparative Example E8 | M2 | 3.2 × 10⁴ | 41 | 2.8 | P1 |
| Example B4 | (E2) Example A1 | M2 | 4.3 × 10⁴ | 38 | 2.4 | P1 |
| Example B5 | (E5) Example A13, (E2) Example A1 | M2 | 1.6 × 10⁵ | 71 | 4.1 | D |
| Example B6 | (E6) Example A14, (E5) Example A1 | M2 | 1.0 × 10⁵ | 69 | 2.7 | E |
| Example B7 | (E6) Example A14, (E7) Example A15 | M2 | 4.4 × 10⁵ | 79 | 5.6 | F |
| Example B8 | (E8) Example A16, (E2) Example A1 | M2 | 5.1 × 10⁵ | 68 | 2.1 | G |
| Example B9 | (E2) Example A1 | M2, E9 | 1.0 × 10⁵ | 73 | 3.6 | H |
| Example B10 | (E6) Example A14 | M2, E10 | 2.6 × 10⁵ | 71 | 3.9 | I |
| Example B11 | (E2) Example A1 | M2, E11 | 1.0 × 10⁵ | 79 | 2.8 | J |
| Example B12 | (E12) Example A14, (E2) Example A1 | M2 | 1.8 × 10⁵ | 77 | 3.6 | K |
| Example B13 | (E13) Example A18, (E2) Example A1 | M2 | 2.6 × 10⁵ | 75 | 5.2 | L |
| Example B14 | (E7) Example A15 | E14 | 1.5 × 10⁵ | 70 | 1.9 | M |
| Example B15 | (E6) Example A14, (E2) Example A1 | M2 | 3.2 × 10⁵ | 83 | 5.2 | N |
| Example B16 | (E15) Example A19 | M2 | 2.1 × 10⁵ | 81 | 4.6 | O |
| Example B17 | (E5) Example A13 | M2 | 3.6 × 10⁵ | 80 | 5.7 | P |
| Example B18 | (E6) Example A14, (E2) Example A1 | E14 | 3.2 × 10⁵ | 67 | 5.2 | Q |
| Example B19 | (E8) Example A16 | E10 | 4.1 × 10⁵ | 74 | 1.9 | R |

From the above results, Comparative Examples A1 to A9 are compared with Examples A1 to A10 in point of the compound E2, and it is known that, when zeolite is brought into contact with the compound E2, then the impurities that interfere with polymerization could be removed not removing the active group, trimethylstannyl group. It is also known that the compounds E3 to E8, E12, E13 and E15 enjoy the same result.

On the other hand, it is known that, in the case where silica gel or alumina is used as the column material (Comparative Examples A1 to A5), the mono-substituted form or the unsubstituted form is formed by removing at least one active group from the di-substituted form. It is also known that even when the column material is basic, any remarkable improvement could not be attained. It is known that the compound obtained in Comparative Examples A1 to A5, which contains the compound (unsubstituted form) that does not contribute toward production of a conjugated polymer in a ratio of from 75% to 100% or the compound (mono-substituted form) that interferes with the reaction is unsuitable as the monomer for conjugated polymers. It is known that the tendency applies also to the other compounds (compounds E3 to E8, E12, E13)

It is known that, in the case of using activated charcoal as the column material (Comparative Examples A6 and A7), the di-substituted form can be recovered in a ratio of 75% or so, but the mono-substituted form or the unsubstituted form is formed by removing at least one active group. It is known that the compounds obtained in Comparative Examples A6 and A7, containing the compound (unsubstituted form) that does not contribute toward production of a conjugated polymer in a ratio of 20% or more or the compound (mono-substituted form) that interferes with the reaction, are also unsuitable as the monomer for conjugated polymers.

In the case where celite is used as the column material (Comparative Example A8), neither the compound (unsubstituted form) not contributing toward the reaction to give a conjugated polymer nor the compound (mono-substituted form) that interferes with the reaction is not formed, and the di-substituted form can be recovered at high efficiency (99% or so); however, in the case, when the obtained compound is stored at -20°C for 4 days, a visible precipitate forms. On the other hand, even when the compound obtained in Example A1 is stored at -20°C for 4 days, no visible precipitate forms. From this, it is known that the storage stability at -20°C of the compound obtained in Comparative Example A8 is inferior to that of the compound obtained in Example A1, and that the impurities in the composition in the invention could not have been removed from the compound obtained in Comparative Examples A8.

Regarding the coupling reaction to give a conjugated polymer, when Example B1 is compared with Comparative Example B1 and Comparative Example B2, the monomer used has a significant influence on the value of the weight-average molecular weight of the formed conjugated polymer, and consequently, it is known that the compound obtained in Comparative Example A8 is unsuitable to the monomer for conjugated polymers.

Comparative Example B1 is compared with Example B1. The conjugated polymer P1 obtained through Stille reaction using the compound E2 before contact treatment with zeolite has a relatively small weight-average molecular weight (Mw) of 2.1 × 10⁴. The polymerization (Comparative Example B2) through Stille reaction using the compound E2 that had been brought into contact with celite also has a relatively small weight-average molecular weight (Mw) of 3.2 × 10⁴. On the other hand, the conjugated polymer P1 that had been obtained through Stille reaction using the compound E2 that had been subjected to contact treatment with zeolite was a high-molecular polymer having a large weight-average molecular weight (Mw) of 1.5 × 10⁵.

From the above, it is known that the contact treatment with zeolite removes the impurities that act as a catalyst poison, such as inorganic salts, organic substances and others, from the compound E2 obtained in Synthesis Example 1, suitably controls the equivalent ratio of the monomers (E2 and M2) in Stille reaction, and removes the inhibitory substances such as the compound S1 and the compound S2 that are formed through removal of the active group, thereby giving a conjugated polymer having a high molecular weight. It is also known that the compounds E3 to E8, E12, E13 and E15 enjoy the same effect.

While the present invention has been described in detail and with reference to specific embodiments thereof, it will be apparent to one skilled in the art that various changes and modifications can be made therein without departing from the spirit and scope thereof. The present application is based on a Japanese patent application filed on November 2, 2011 (Patent Application 2011-241498) and a Japanese patent application filed on November 29, 2011 (Patent Application 2011-260973), the entire contents of which are herein incorporated by reference.

### Industrial Applicability

By employing a step of bringing a composition that contains a condensed polycyclic aromatic compound and a solvent, into contact with zeolite, the impurities can be removed and a pure, difunctional condensed polycyclic aromatic compound can be obtained, and consequently, through coupling reaction of the monomer, a conjugated polymer having a higher molecular weight can be obtained.

As a result, it is possible to obtain a photoelectric conversion element excellent in photoelectric conversion efficiency by the use of the compound, and therefore the invention is favorable for solar cells and modules thereof, and can be utilized for energy sources having a low environment load.

## Claims

1. A method for producing a condensed polycyclic aromatic compound having n active groups (wherein n is an integer of 1 or more and 4 or less), which comprises bringing a composition containing the condensed polycyclic aromatic compound and a solvent into contact with zeolite.

2. The method for producing a condensed polycyclic aromatic compound according to claim 1, wherein the condensed polycyclic aromatic compound satisfies the following requirement:
Requirement: When 5 ml of a hexane solution containing 1.0 g of the condensed polycyclic aromatic compound (Ar(n)) having n active groups is charged in a column (having an inner diameter 15 mm, and charged with 50 mL of a hexane solution containing 20 g of silica gel (spherical, neutral (pH 7.0 ± 0.5), and having a particle size of from 63 to 210 µm) and 2 g of anhydrous potassium carbonate) and developed with a developing solvent of hexane (at a flow rate of 50 ml/min), the total proportion of the condensed polycyclic aromatic compound in which the number of the active groups is smaller than n in the solution having passed through the column in 3 minutes at room temperature is 5 mol% or more relative to the aromatic compound (Ar(n)) before charged in the column.

3. The method for producing a condensed polycyclic aromatic compound according to claim 1 or 2, wherein the condensed polycyclic aromatic compound is a condensed polycyclic aromatic compound represented by the following formula (I): 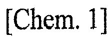 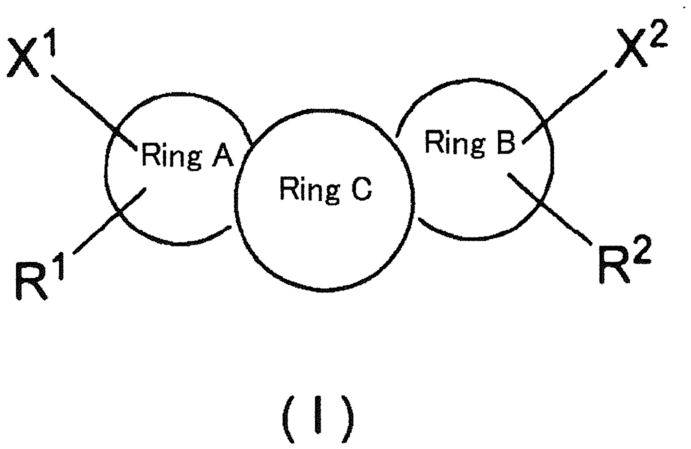 (In the formula (I), the Ring A and the Ring B each independently represent a 5-membered aromatic hetero ring, and the Ring C represents a ring optionally having a substituent, X¹ and X² each independently represent an active group, R¹ and R² each independently represent a hydrogen atom, a halogen atom, or a hydrocarbon group optionally having a hetero atom.)

4. The method for producing a condensed polycyclic aromatic compound according to claim 3, wherein the compound represented by the formula (I) is a condensed polycyclic aromatic compound represented by the following formula (II) or formula (III): 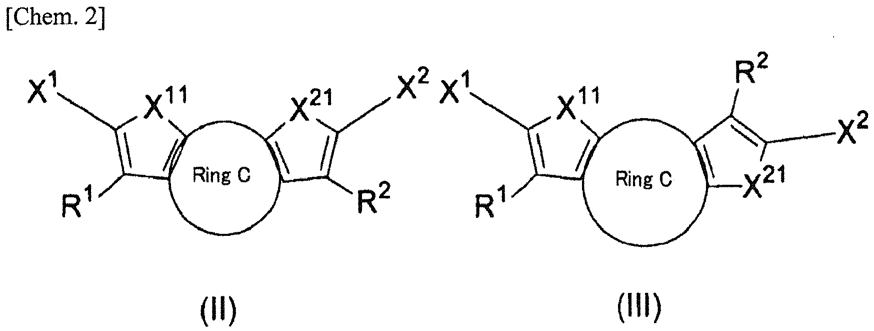 (In the formula (II) and the formula (III), X¹, X², R¹, R² and the Ring C have the same meanings as in the formula (I), and X¹¹ and X²¹ each independently represent an atom selected from Group 16 elements of the Periodic Table.)

5. The method for producing a condensed polycyclic aromatic compound according to claim 4, wherein the compound represented by the formula (II) or the formula (III) is a condensed polycyclic aromatic compound represented by the following formula (IV), formula (V), formula (VI) or formula (VII): 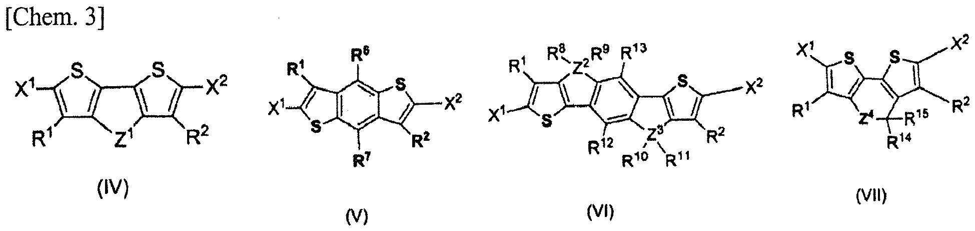 in the formula (IV), formula (V), formula (VI) or formula (VI), X¹, X², R¹ and R² have the same meanings as in the formula (I),
in the formula (IV), Z¹ represents Z¹¹(R³)(R⁴), Z¹²(R⁵), or Z¹³, Z¹¹ represents an atom selected from Group 14 elements of the Periodic Table, R³ and R⁴ are the same as the above-mentioned R¹ and R², Z¹² represents an atom selected from Group 15 elements of the Periodic Table, R⁵ has the same meaning as R³ and R⁴. Z¹³ represents an atom selected from Group 16 elements of the Periodic Table,
in the formula (V), R⁶ and R⁷ each represent a hydrogen atom, a halogen atom, an alkyl group optionally having a substituent, an alkenyl group optionally having a substituent, an alkynyl group optionally having a substituent, an aromatic group optionally having a substituent, an alkoxy group optionally having a substituent, or an aryloxy group optionally having a substituent,
in the formula (VI), R⁸ to R¹¹ have the same meanings as R³ and R⁴; and R¹² and R¹³ have the same meanings as R¹ and R². Z² and Z³ each independently represent an atom selected from Group 14 elements of the Periodic Table,
in the formula (VII), R¹⁴ and R¹⁵ have the same meanings as R³ and R⁴. Z⁴ represents an atom selected from Group 16 elements of the Periodic Table.

6. The method for producing a condensed polycyclic aromatic compound according to any one of claims 3 to 5, wherein at least one of X¹ and X² is a tin-containing group.

7. The method for producing a condensed polycyclic aromatic compound according to any one of claims 3 to 6, which, in the condensed compound represented by the formula (II), comprises producing the condensed polycyclic aromatic compound represented by the formula (I) through reaction of a condensed polycyclic aromatic compound represented by the following formula (VIII) with a non-nucleophilic base followed by reaction thereof with an electrophilic reagent: 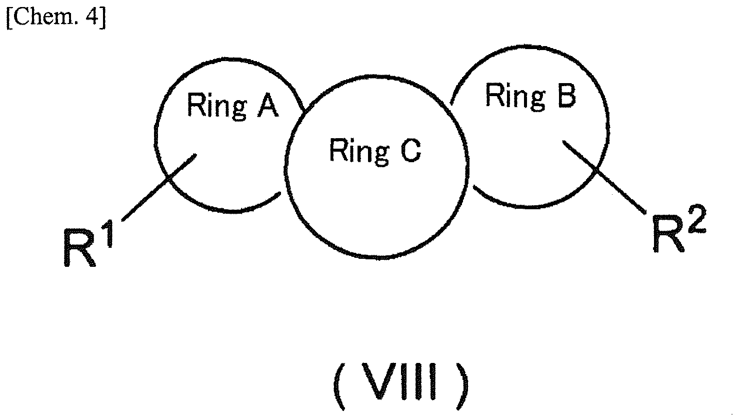 (In the formula (VIII), the Ring A, the Ring B, the Ring C, R¹ and R² have the same meanings as in the formula (I).)

8. The method for producing a condensed polycyclic aromatic compound according to claim 7, wherein pKa in tetrahydrofuran (THF) of the conjugated acid of the non-nucleophilic base is 20 or more and 40 or less.

9. The method for producing a condensed polycyclic aromatic compound according to claim 7 or 8, wherein the non-nucleophilic base is a metal amide.

10. The method for producing a condensed polycyclic aromatic compound according to any one of claims 7 to 9, wherein the operation of reacting with the non-nucleophilic base followed by reacting with the electrophilic reagent is repeated multiple times.

11. The method for producing a condensed polycyclic aromatic compound according to any one of claims 1 to 10, wherein the contact is performed by passing the composition through the zeolite-containing layer at a temperature not higher than the boiling point of the solvent.

12. The method for producing a condensed polycyclic aromatic compound according to any one of claims 1 to 11, wherein the zeolite is zeolite with 8-membered, 10-membered or 12-membered rings.

13. A conjugated polymer where the condensed polycyclic aromatic compound produced according to the method as described in any one of claims 1 to 12 is used as the starting material.

14. A photoelectric conversion element that comprises the conjugated polymer produced according to the production method of claim 12.

15. A solar cell that contains the photoelectric conversion element produced according to the method of claim 13.

16. A solar cell module that contains the solar cell produced according to claim 14.
